# EUROPEAN PATENT APPLICATION

(11) **EP 4 804 759 A1**
(43) Date of publication of application: **09.09.2026**
(21) Application number: 25224939.6
(22) Date of filing: 18.12.2025
(51) Int. Cl.: H10D 64/01, H10D 30/00, H10D 30/01, H10D 84/83, H10D 30/69, H10D 64/23, H10D 62/822, B82Y 10/00

(54) **INTEGRATED CIRCUIT DEVICE**

(30) Priority: 07.03.2025 KR 20250029948
(71) Applicant: Samsung Electronics Co., Ltd., Suwon-si, Gyeonggi-do 16677 (KR)
(72) Inventor: PARK, Wooseok, 16677 Suwon-si (KR); KANG, Myungil, 16677 Suwon-si (KR); KIM, Youngjun, 16677 Suwon-si (KR); PARK, Kyunam, 16677 Suwon-si (KR); LEE, Yonghui, 16677 Suwon-si (KR); CHOI, Doyoung, 16677 Suwon-si (KR)
(74) Representative: Marks & Clerk LLP

(57) **Abstract**

An integrated circuit device includes at least one nanosheet, a pair of source/drain regions contacting the at least one nanosheet, a gate line between the pair of source/drain regions in a first horizontal direction and surrounding the at least one nanosheet, an insulating wall structure having a first sidewall contacting the pair of source/drain regions and facing the gate line, a gate dielectric film surrounding the gate line, and a pair of blocking insulating spacers arranged, in a plan view, in a gap area between the first sidewall and the gate line, in a second horizontal direction, and respectively contacting the pair of source/drain regions, wherein the pair of blocking insulating spacers are spaced apart from one another in the first horizontal direction in the gap area and each include a portion contacting the gate dielectric film and a portion contacting the first sidewall of the insulating wall structure.

## Description

### BACKGROUND

Due to the advancement of electronics technology, integrated circuit devices have been rapidly down-scaled. Because highly down-scaled integrated circuit devices require high operation speeds and accuracy in operations as well, there is a need to provide integrated circuit devices having stable and optimized structures in relatively small areas.

### SUMMARY

The disclosed concepts provide an integrated circuit device having a structure, which may prevent unintended short-circuits between conductive regions constituting transistors of the integrated circuit device and may improve the electrical performance and reliability of the transistors, when the transistors of the integrated circuit device are arranged in a reduced area due to down-scaling.

According to aspects of the disclosed concepts, there is provided an integrated circuit device including a nanosheet stack including at least one nanosheet, a pair of source/drain regions spaced apart from one another in a first horizontal direction with the nanosheet stack therebetween, each of the pair of source/drain regions being in contact with the at least one nanosheet, a gate line arranged between the pair of source/drain regions in the first horizontal direction and surrounding the at least one nanosheet, an insulating wall structure arranged adjacent to the nanosheet stack, the gate line, and the pair of source/drain regions in a second horizontal direction intersecting the first horizontal direction, the insulating wall structure having a first sidewall that includes portions contacting the pair of source/drain regions and a portion facing the gate line, a gate dielectric film surrounding the gate line, and a pair of blocking insulating spacers each arranged, in a plan view, in a gap area between the first sidewall of the insulating wall structure and the gate line in the second horizontal direction and contacting the pair of source/drain regions, wherein the pair of blocking insulating spacers are spaced apart from one another in the first horizontal direction in the gap area and each include a portion contacting the gate dielectric film and a portion contacting the first sidewall of the insulating wall structure.

According to aspects of the disclosed concepts, there is provided an integrated circuit device including first and second semiconductor regions, which extend in a first horizontal direction and are adjacent to one another in a second horizontal direction orthogonal to the first horizontal direction, an insulating wall structure extending in the first horizontal direction between the first and second semiconductor regions, first and second nanosheet stacks positioned to respectively overlap the first and second semiconductor regions in a vertical direction and spaced apart from one another in the second horizontal direction with the insulating wall structure therebetween, each of the first and second nanosheet stacks including at least one nanosheet, a first gate line arranged over the first semiconductor region to surround the at least one nanosheet of the first nanosheet stack, a first gate dielectric film surrounding the first gate line and including a first end portion that is adjacent to a first sidewall of the insulating wall structure in the second horizontal direction, a first source/drain region positioned adjacent to the first gate line and contacting the at least one nanosheet of the first nanosheet stack, the first source/drain region being in contact with the first sidewall of the insulating wall structure, and a first blocking insulating spacer, in a plan view, arranged in a first gap area between the insulating wall structure and the first gate line in the second horizontal direction and contacting the first source/drain region, wherein the first blocking insulating spacer includes, in the first gap area, a portion contacting the first end portion of the first gate dielectric film and a portion contacting the first sidewall of the insulating wall structure.

According to aspects of the disclosed concepts, there is provided an integrated circuit device including a fin-type active region extending in a first horizontal direction, a device isolation film covering both sidewalls of the fin-type active region in a second horizontal direction intersecting the first horizontal direction, a nanosheet stack including a plurality of nanosheets arranged over the fin-type active region, a gate line arranged over the fin-type active region to surround the plurality of nanosheets and overlapping a portion of the device isolation film in a vertical direction, a source/drain region arranged on the fin-type active region and contacting the plurality of nanosheets, an insulating wall structure having a first sidewall that, in the second horizontal direction, faces each of the source/drain region, the gate line, and the plurality of nanosheets, a gate dielectric film surrounding the gate line, and a blocking insulating spacer, in a plan view, arranged in a gap area between the first sidewall of the insulating wall structure and the gate line in the second horizontal direction and contacting the source/drain region, wherein the blocking insulating spacer includes, in the gap area, a portion contacting the gate dielectric film and a portion contacting the first sidewall of the insulating wall structure, a minimum separation width in the second horizontal direction between the plurality of nanosheets and the first sidewall of the insulating wall structure is a first width, and a minimum separation width between the first sidewall of the insulating wall structure and the gate line that is between each of the plurality of nanosheets is less than the first width.

According to aspects of the disclosed concepts, there is provided a method of fabricating an integrated circuit device, the method including forming a first structure that includes a pair of fin-type active regions extending in a first horizontal direction and a pair of stack structures respectively arranged on the pair of fin-type active regions, each of the pair of stack structures including therein a plurality of sacrificial semiconductor layers and a plurality of nanosheet semiconductor layers alternately stacked one-by-one, forming a device isolation film to cover both sidewalls of each of the pair of fin-type active regions in a second horizontal direction intersecting with the first horizontal direction, forming a second structure on the device isolation film between the pair of fin-type active regions and between the pair of stack structures, the second structure including a main insulating layer and a cladding layer covering both sidewalls of the main insulating layer in the second horizontal direction, forming a plurality of dummy gate layers on the first structure and the second structure, the plurality of dummy gate layers extending in the second horizontal direction and being spaced apart from one another in the first horizontal direction, forming a cladding spacer layer from the cladding layer between each of the plurality of dummy gate layers to cover both sidewalls of the main insulating layer and forming a main insulating wall from the main insulating layer, forming a recess in each of the pair of fin-type active regions by partially removing each of the pair of stack structures from the first structure between each of the plurality of dummy gate layers, and forming a plurality of nanosheets from the plurality of nanosheet semiconductor layers in the first structure, forming a second cladding portion, which is between the plurality of stack structures and the main insulating wall, from the cladding spacer layer and forming a pair of undercut spaces, which are on both sides of the second cladding portion in the first horizontal direction and connected to the recess, by partially removing the cladding spacer layer through the recess, forming a pair of blocking insulating spacers respectively in the pair of undercut spaces to contact the second cladding portion, forming a source/drain region in a space defined by the recess and the pair of blocking insulating spacers, forming a gate space to expose the second cladding portion by removing the plurality of dummy gate layers and portions of the plurality of sacrificial semiconductor layers, the portions being respectively covered by the plurality of dummy gate layers, forming a gate dielectric film in the gate space, and forming a gate line in the gate space to cover the gate dielectric film.

In some embodiments, while the second cladding portion is being formed, a first cladding portion may be formed to contact a lower surface of the main insulating wall.

In some embodiments, in the forming of the gate dielectric film, the gate dielectric film may be formed to contact the pair of blocking insulating spacers.

In some embodiments, in the forming of the second structure, the cladding layer may include a first insulating material, and the main insulating layer may include a second insulating material that is different from the first insulating material.

In some embodiments, in the forming of the second structure, the cladding layer may include a first insulating material, and in the forming of the pair of blocking insulating spacers, each of the pair of blocking insulating spacers may include a third insulating material that is different from the first insulating material.

In some embodiments, in the forming of the second cladding portion, the second cladding portion may be formed to have a surface contacting the plurality of nanosheets and a surface contacting the main insulating wall.

In some embodiments, in a plan view, each of the pair of blocking insulating spacers may be formed to have a concave surface toward the recess.

In some embodiments, after the forming of the second structure, before the forming of the plurality of dummy gate layers, the method may further include forming an isolation insulating film pattern to cover local upper surfaces of the device isolation film. The isolation insulating film pattern may be formed to face the second structure in the second horizontal direction with one selected from the pair of fin-type active regions therebetween.

In some embodiments, in the forming of the gate line, in the second horizontal direction, a minimum separation width between the plurality of nanosheets and the main insulating wall may be a first width, and a minimum separation width between the gate line and the main insulating wall may be less than the first width.

In some embodiments, after the forming of the gate space to expose the second cladding portion, before the forming of the gate dielectric film in the gate space, the method may further include at least partially removing a portion of the second cladding portion, the portion being between the plurality of nanosheets and the main insulating wall.

According to aspects of the disclosed concepts, there is provided a method of manufacturing an integrated circuit device including: providing a nanosheet stack including at least one nanosheet, providing a pair of source/drain regions spaced apart from one another in a first horizontal direction with the nanosheet stack therebetween, each of the pair of source/drain regions being in contact with the at least one nanosheet, providing a gate line arranged between the pair of source/drain regions in the first horizontal direction and surrounding the at least one nanosheet, providing an insulating wall structure arranged adjacent to the nanosheet stack, the gate line, and the pair of source/drain regions in a second horizontal direction intersecting the first horizontal direction, the insulating wall structure having a first sidewall that includes portions contacting the pair of source/drain regions and a portion facing the gate line, providing a gate dielectric film surrounding the gate line, and providing a pair of blocking insulating spacers each arranged, in a plan view, in a gap area between the first sidewall of the insulating wall structure and the gate line in the second horizontal direction and contacting the pair of source/drain regions, wherein the pair of blocking insulating spacers are spaced apart from one another in the first horizontal direction in the gap area and each include a portion contacting the gate dielectric film and a portion contacting the first sidewall of the insulating wall structure.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1 is a planar layout diagram illustrating an integrated circuit device according to some embodiments;
FIG. 2A is a cross-sectional view of the integrated circuit device of FIG. 1, taken along a line X1-X1' of FIG. 1;
FIG. 2B is a cross-sectional view of the integrated circuit device of FIG. 1, taken along a line Y1-Y1' of FIG. 1;
FIG. 2C is a cross-sectional view of the integrated circuit device of FIG. 1, taken along a line Y2-Y2' of FIG. 1;
FIG. 2D is an enlarged plan view of some components at a first vertical level in a region EX1 of FIG. 1;
FIG. 2E is an enlarged cross-sectional view of a region EX2 of FIG. 2C;
FIG. 3 is a cross-sectional view illustrating an integrated circuit device according to some embodiments;
FIGS. 4A, 4B, 4C, 4D, 4E, and 4F are plan views respectively illustrating integrated circuit devices according to some embodiments;
FIGS. 5A, 5B, 5C, 5D, and 5E are cross-sectional views respectively illustrating integrated circuit devices according to some embodiments;
FIGS. 6 and 7 are cross-sectional views respectively illustrating integrated circuit devices according to some embodiments;
FIG. 8A is a layout diagram illustrating an integrated circuit device according to some embodiments;
FIG. 8B is a cross-sectional view of the integrated circuit device of FIG. 8A, taken along a line Y1-Y1' of FIG. 8A;
FIG. 8C is a cross-sectional view of the integrated circuit device of FIG. 8A, taken along a line Y2-Y2' of FIG. 8A;
FIGS. 9A and 9B are cross-sectional views illustrating an integrated circuit device according to some embodiments;

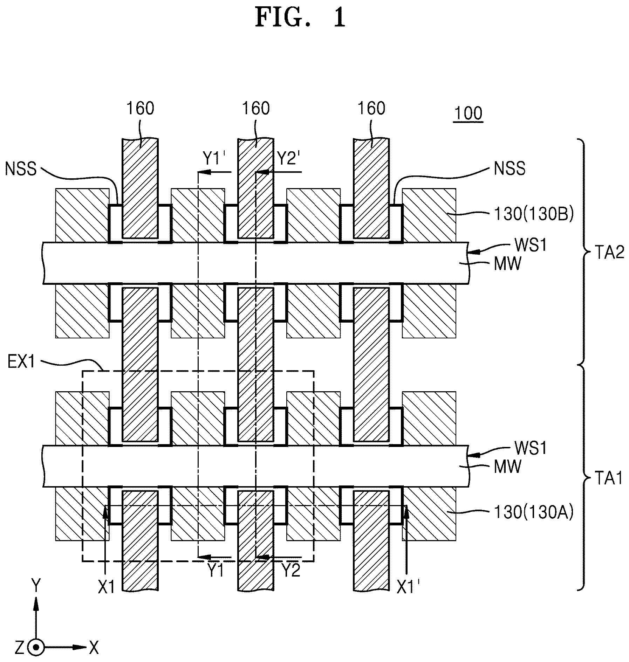

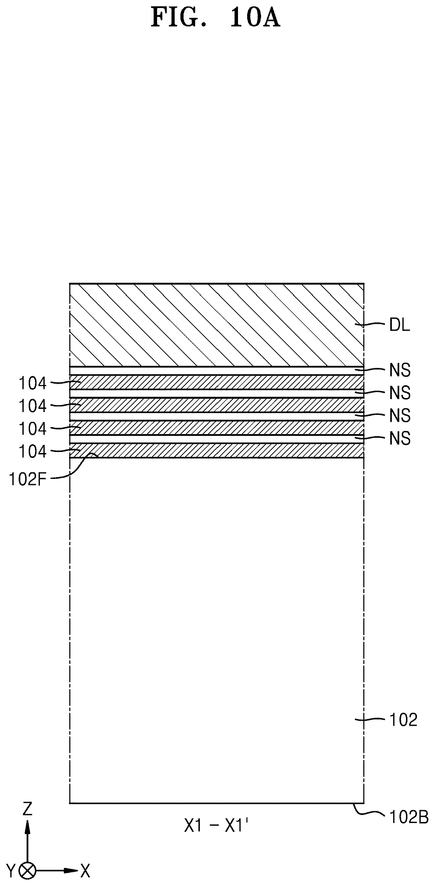

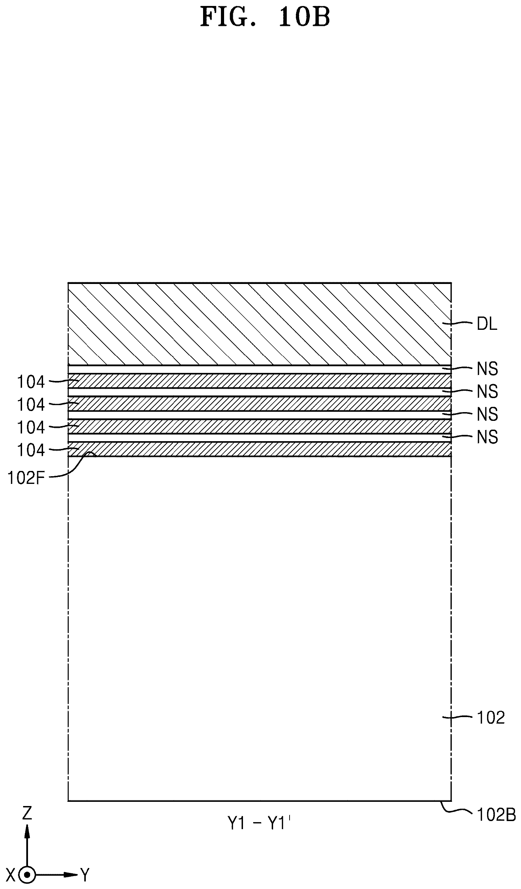

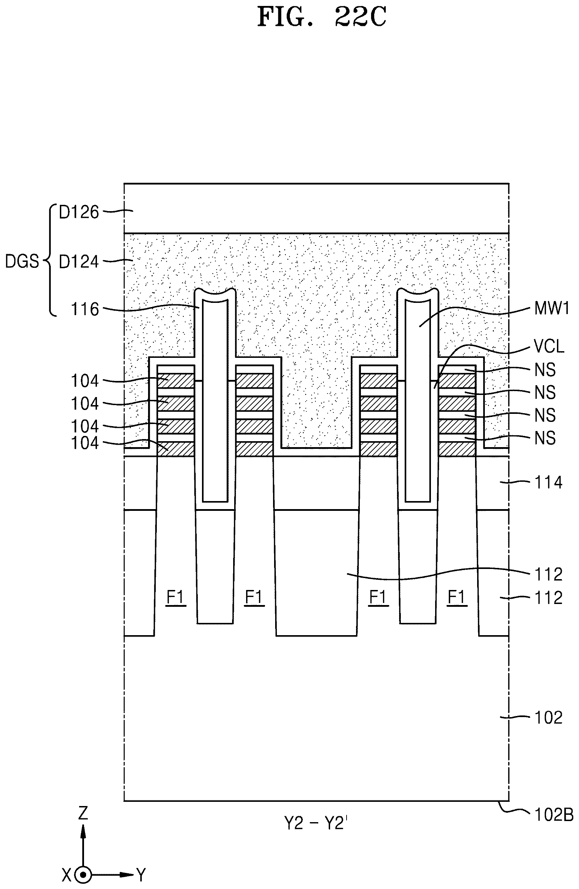

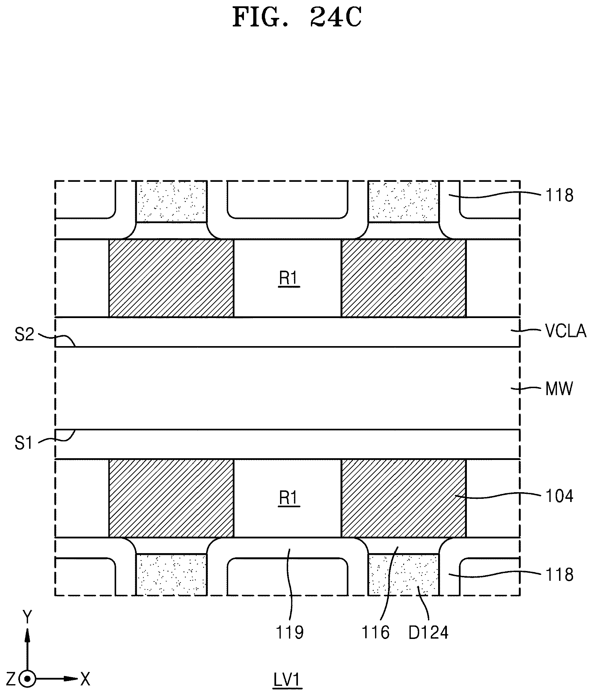

FIGS. 10A to 32B are cross-sectional views respectively illustrating a sequence of processes of a method of fabricating an integrated circuit device, according to some embodiments, and in particular, FIGS. 10A, 11A, 22A, 23A, 24A, 28A, 30A, 31A, and 32A are cross-sectional views respectively illustrating cross-sectional structures of a region corresponding to the cross-section taken along the line X1-X1' of FIG. 1, according to a sequence of processes, FIGS. 10B, 11B, 12, 13, 14, 15, 16, 17, 18, 19, 20, 21, 22B, 23B, 24B, 25A, 26A, 27A, 28B, 29, and 30B are cross-sectional views respectively illustrating cross-sectional structures of a region corresponding to the cross-section taken along the line Y1-Y1' of FIG. 1, according to a sequence of processes, FIGS. 22C, 30C, 31B, and 32B are cross-sectional views respectively illustrating cross-sectional structures of a region corresponding to the cross-section taken along the line Y2-Y2' of FIG. 1, according to a sequence of processes, and FIGS. 24C, 25B, 26B, 27B, and 28C are plan views of some components in a region corresponding to the region EX1 of FIG. 1, according to a sequence of processes; and

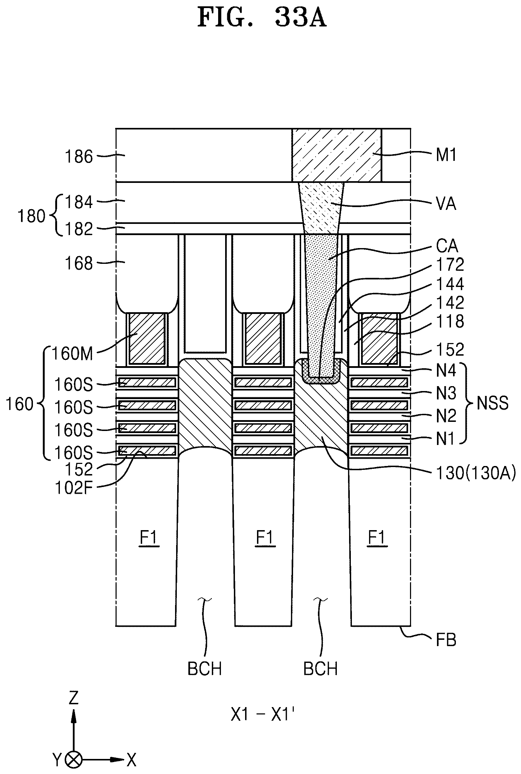

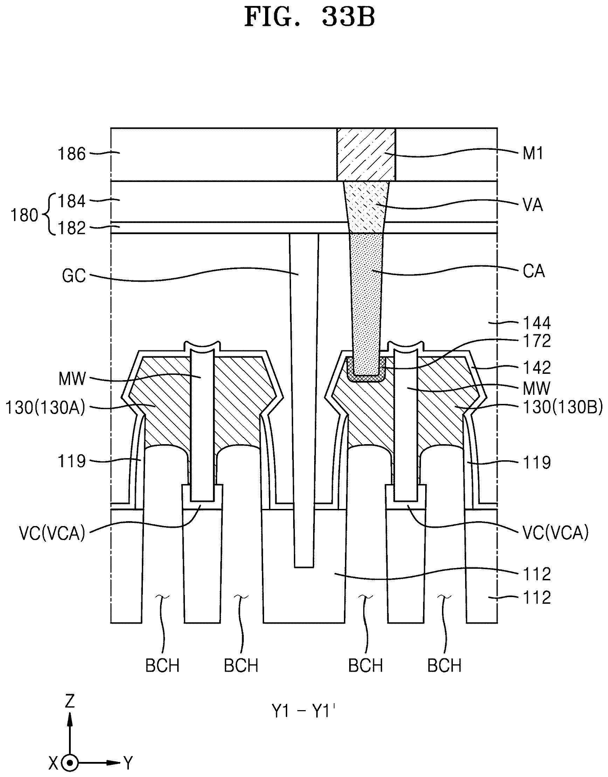

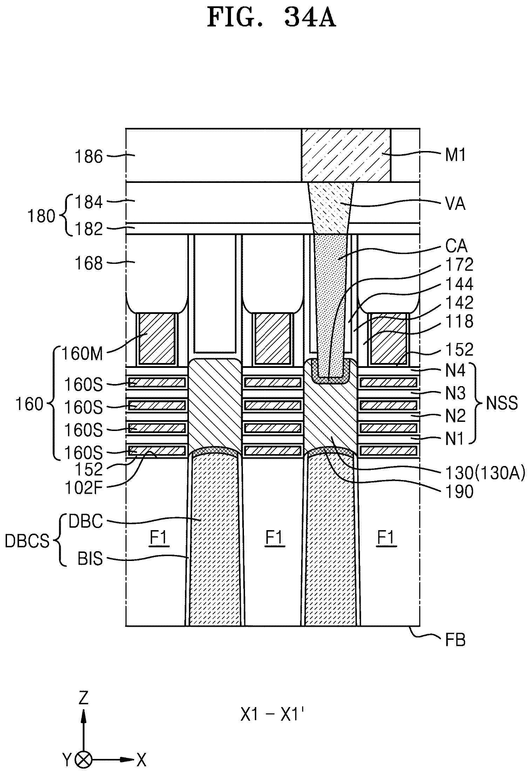

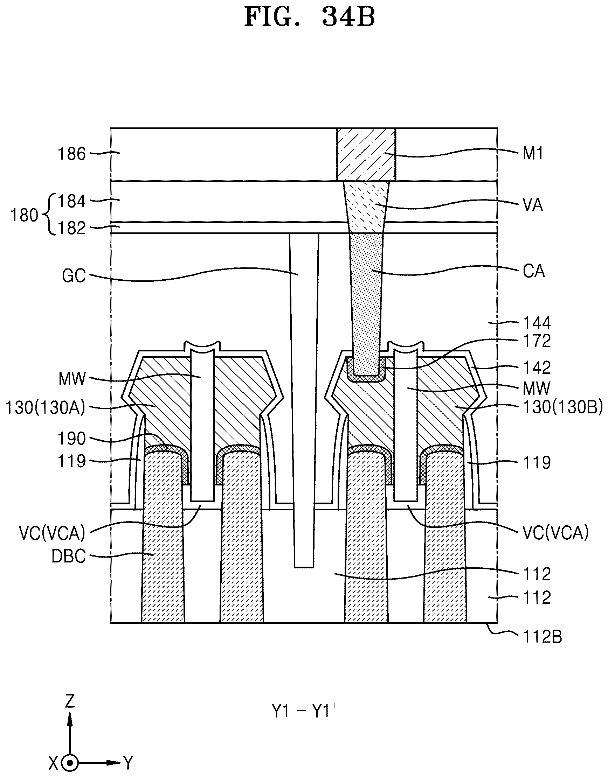

FIGS. 33A to 34B are diagrams respectively illustrating a sequence of processes of a method of fabricating an integrated circuit device, according to some embodiments, and in particular, FIGS. 33A and 34A are cross-sectional views respectively illustrating cross-sectional structures of a region corresponding to the cross-section taken along the line X1-X1' of FIG. 1, according to a sequence of processes, and FIGS. 33B and 34B are cross-sectional views respectively illustrating cross-sectional structures of a region corresponding to the cross-section taken along the line Y1-Y1' of FIG. 1, according to a sequence of processes.

### DETAILED DESCRIPTION

Hereinafter, embodiments of the disclosed concepts will be described in detail with reference to the accompanying drawings. Like components are denoted by like reference numerals throughout the specification, and repeated descriptions thereof are omitted.

The disclosed concepts relate to an integrated circuit device, and more particularly, to an integrated circuit device including a field-effect transistor.

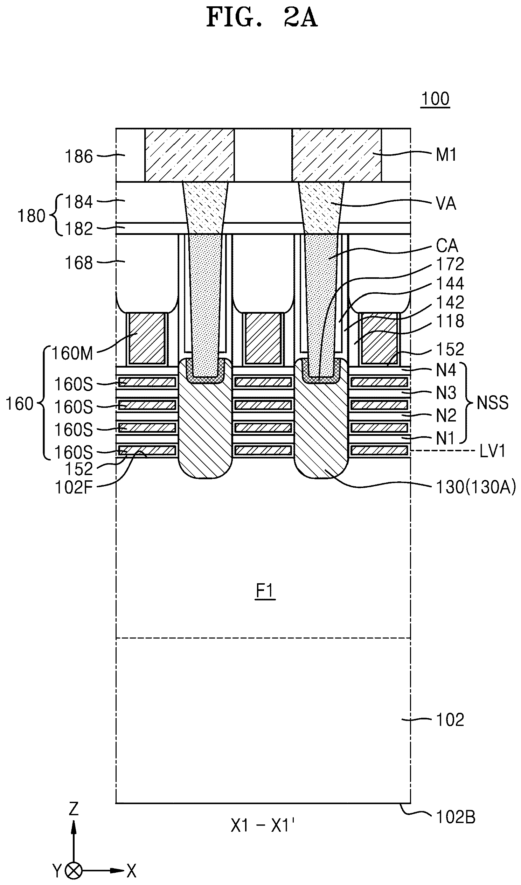

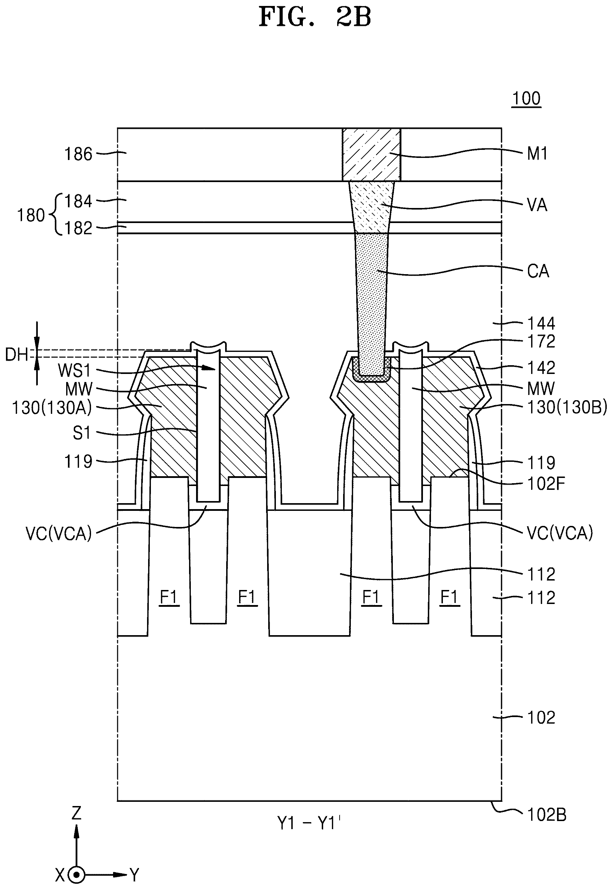

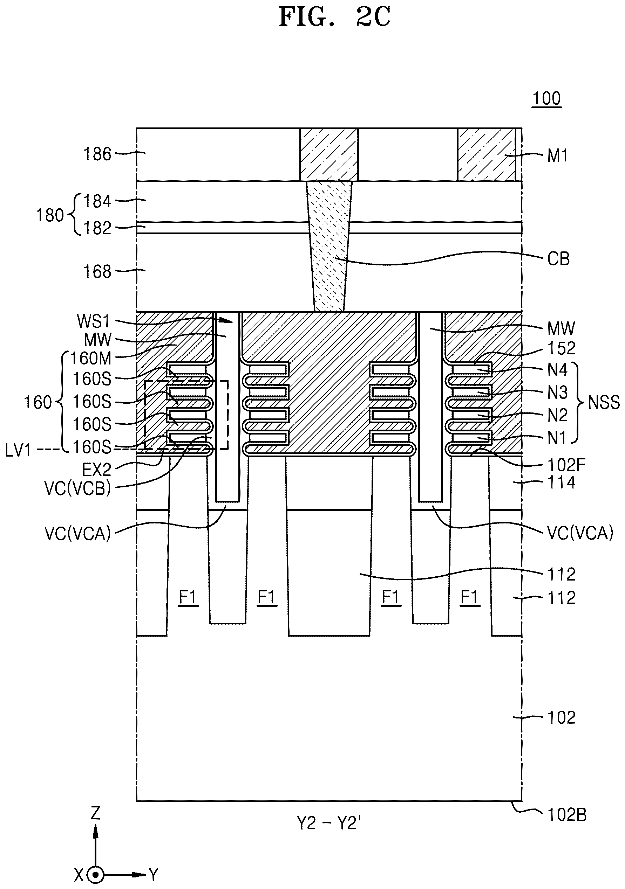

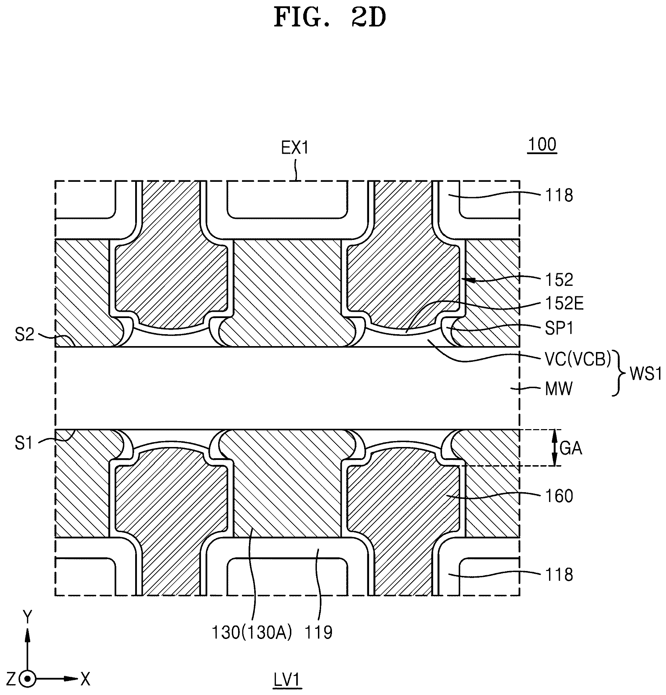

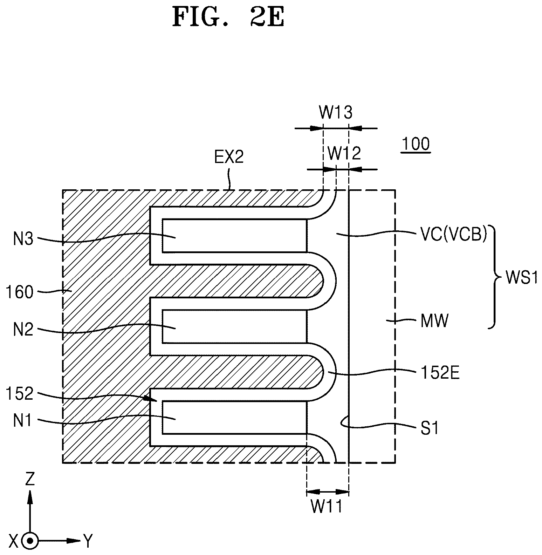

FIG. 1 is a planar layout diagram illustrating an integrated circuit device 100 according to embodiments. FIG. 2A is a cross-sectional view of the integrated circuit device 100, taken along a line X1-X1' of FIG. 1. FIG. 2B is a cross-sectional view of the integrated circuit device 100, taken along a line Y1-Y1' of FIG. 1. FIG. 2C is a cross-sectional view of the integrated circuit device 100, taken along a line Y2-Y2' of FIG. 1. FIG. 2D is an enlarged plan view of some components at a first vertical level LV1 of FIGS. 2A and 2C in a region EX1 of FIG. 1. FIG. 2E is an enlarged cross-sectional view of a region EX2 of FIG. 2C. The integrated circuit device 100 including a field-effect transistor, which has a gate-all-around (GAA) structure including a nanowire or nanosheet-shaped active region and a gate surrounding the active region, is described with reference to FIGS. 1 and 2A to 2E.

Referring to FIGS. 1 and 2A to 2E, the integrated circuit device 100 may include a substrate 102, which includes a first device area TA1 and a second device area TA2, and a plurality of fin-type active regions F1 protruding in a vertical direction (a Z direction) from the substrate 102 in the first device area TA1 and the second device area TA2. The plurality of fin-type active regions F1 may be spaced apart from one another and may be arranged in a line in a first horizontal direction (an X direction) and a second horizontal direction (a Y direction), which intersect with one another. In some embodiments, the first horizontal direction (an X direction) and the second horizontal direction (a Y direction) may be orthogonal to one another.

The substrate 102 and the plurality of fin-type active regions F1 may each include a semiconductor, such as Si or Ge, or a compound semiconductor, such as SiGe, SiC, GaAs, InAs, InGaAs, or InP. As used herein, each of the terms "SiGe", "SiC", "GaAs", "InAs", "InGaAs", and "InP" refers to a material including elements contained in each term and is not a chemical formula representing a stoichiometric relationship. The substrate 102 may include a conductive region, for example, an impurity-doped well or an impurity-doped structure. Herein, a fin-type active region F1 may be referred to as a semiconductor region.

As shown in FIGS. 2A to 2C, each of the plurality of fin-type active regions F1 may have a frontside surface 102F that is opposite to a backside surface 102B of the substrate 102. The frontside surface 102F of each of the plurality of fin-type active regions F1 is a surface facing in a forward direction of the vertical direction (the Z direction), and the backside surface 102B of the substrate 102 is a surface facing in a reverse direction of the vertical direction (the Z direction). Each of the plurality of fin-type active regions F1 may include silicon (Si).

A plurality of nanosheet stacks NSS may be arranged over the plurality of fin-type active regions F1. Each of the plurality of nanosheet stacks NSS may face the fin-type active region F1 in the vertical direction (the Z direction) at a position overlapping the fin-type active region F1 in the vertical direction (the Z direction) and may include at least one nanosheet. As used herein, the term "nanosheet" refers to a conductive structure having a cross-section that is substantially perpendicular to a current-flowing direction. The nanosheet may also be understood as including a nanowire.

Although the present example illustrates a configuration in which each of the plurality of nanosheet stacks NSS includes first to fourth nanosheets N1, N2, N3, and N4, the number of nanosheets in each of the plurality of nanosheet stacks NSS may be variously changed. For example, each of the plurality of nanosheet stacks NSS may include at least one nanosheet or at least two nanosheets, and the number of nanosheets constituting a nanosheet stack NSS is not particularly limited. Each of the first to fourth nanosheets N1, N2, N3, and N4 may have a channel region. In some embodiments, each of the first to fourth nanosheets N1, N2, N3, and N4 of the nanosheet stack NSS may include a Si layer, a SiGe layer, or a combination thereof.

In some embodiments, each of the first to fourth nanosheets N1, N2, N3, and N4 may have a thickness selected from a range of about 4 nm to about 6 nm in the vertical direction (the Z direction). In some embodiments, the first to fourth nanosheets N1, N2, N3, and N4 may have a substantially equal thickness. The first to fourth nanosheets N1, N2, N3, and N4 may include the same material.

The integrated circuit device 100 may include a plurality of source/drain regions 130. The plurality of source/drain regions 130 may each be arranged one-by-one adjacent to each of the plurality of nanosheet stacks NSS on either side, in the first horizontal direction (the X direction), of each of the plurality of nanosheet stacks NSS. In one example, the integrated circuit device 100 may include a pair of source/drain regions 130.

Each of the plurality of source/drain regions 130 may be arranged one-by-one between a pair of nanosheet stacks NSS adjacent to one another in the first horizontal direction (the X direction) from among the plurality of nanosheet stacks NSS and may be in contact with each of the first to fourth nanosheets N1, N2, N3, and N4 of the nanosheet stack NSS adjacent to each source/drain region 130.

A plurality of gate lines 160 may be located apart from one another in the first horizontal direction (the X direction) over the fin-type active region F1 and may extend lengthwise in the second horizontal direction (the Y direction). Each of the plurality of gate lines 160 may cover at least one nanosheet stack NSS and may surround the first to fourth nanosheets N1, N2, N3, and N4 of the at least one nanosheet stack NSS.

Each of the plurality of source/drain regions 130 may be arranged adjacent to at least one gate line 160 selected from the plurality of gate lines 160. A plurality of source/drain regions 130 aligned in a line in the first horizontal direction (the X direction) may each be arranged one-by-one between each of the plurality of gate lines 160. Each of the plurality of source/drain regions 130 may have surfaces contacting the first to fourth nanosheets N1, N2, N3, and N4 that are included in the nanosheet stack NSS adjacent thereto.

The integrated circuit device 100 may include a plurality of insulating wall structures WS1, which are located adjacent to the plurality of fin-type active regions F1, the plurality of nanosheet stacks NSS, and the plurality of source/drain regions 130 and extend lengthwise in the first horizontal direction (the X direction). The plurality of insulating wall structures WS1 may be spaced apart from one another in the second horizontal direction (the Y direction) and may extend in the first horizontal direction (the X direction) so as to be parallel to one another.

Each of the plurality of insulating wall structures WS1 may pass in the vertical direction (the Z direction) between a pair of fin-type active regions F1 adjacent to one another in the second horizontal direction (the Y direction) from among the plurality of fin-type active regions F1, between a pair of nanosheet stacks NSS adjacent to one another in the second horizontal direction (the Y direction) from among the plurality of nanosheet stacks NSS, between a pair of source/drain regions 130 adjacent to one another in the second horizontal direction (the Y direction) from among the plurality of source/drain regions 130, and between a pair of gate lines 160 adjacent to one another in the second horizontal direction (the Y direction) from among the plurality of gate lines 160.

An upper sidewall of each of a pair of fin-type active regions F1, which are adjacent to one another in the second horizontal direction (the Y direction) with one insulating wall structure WS1 therebetween, may be in contact with the one insulating wall structure WS1. The first nanosheet N1, the second nanosheet N2, the third nanosheet N3, and the fourth nanosheet N4 of each of a pair of nanosheet stacks NSS, which are adjacent to one another in the second horizontal direction (the Y direction) with one insulating wall structure WS1 therebetween, may be in contact with the one insulating wall structure WS1. One end, in the second horizontal direction (the Y direction), of each of the first nanosheet N1, the second nanosheet N2, the third nanosheet N3, and the fourth nanosheet N4 may be in contact with the one insulating wall structure WS1. A pair of source/drain regions 130, which are adjacent to one another in the second horizontal direction (the Y direction) with one insulating wall structure WS1 therebetween, may each be in contact with the one insulating wall structure WS1. For example, as shown in FIG. 2D, one source/drain region 130 out of the pair of source/drain regions 130, which are adjacent to one another in the second horizontal direction (the Y direction) with one insulating wall structure WS1 therebetween, may be in contact with a first sidewall S1 of the one insulating wall structure WS1, and the other source/drain region 130 may be in contact with a second sidewall S2 of the one insulating wall structure WS1, the second sidewall S2 being opposite to the first sidewall S1.

A lower sidewall of each of the plurality of fin-type active regions F1 may be covered by a device isolation film 112. The lower sidewall of each of the plurality of fin-type active regions F1 may be in contact with the device isolation film 112. The device isolation film 112 may be arranged at a vertical level that is lower than the vertical level of each of the insulating wall structure WS1, the plurality of source/drain regions 130, and the plurality of gate lines 160. As used herein, the term "vertical level" refers to the distance in the vertical direction (the Z direction) from the backside surface 102B of the substrate 102. The device isolation film 112 may include, but is not limited to, a silicon oxide film, a silicon nitride film, or a combination thereof.

Each of the plurality of source/drain regions 130 may include an epitaxially grown semiconductor layer. In some embodiments, each of the plurality of source/drain regions 130 may include an epitaxially grown Si layer, an epitaxially grown SiC layer, or a plurality of epitaxially grown SiGe layers.

As shown in FIG. 1, the integrated circuit device 100 may include the first device area TA1 and the second device area TA2. The first device area TA1 and the second device area TA2 are areas in which different types of transistors are formed, respectively. For example, the first device area TA1 may correspond to a PMOS transistor area, and the second device area TA2 may correspond to an NMOS transistor area. In this case, a plurality of first source/drain regions 130A in the first device area TA1 from among the plurality of source/drain regions 130 may each include a SiGe layer doped with a p-type dopant, and a plurality of second source/drain regions 130B in the second device area TA2 from among the plurality of source/drain regions 130 may each include a Si layer doped with an n-type dopant, or a SiC layer doped with an n-type dopant. The p-type dopant may be selected from boron (B) and gallium (Ga). The n-type dopant may be selected from phosphorus (P), arsenic (As), and antimony (Sb). The plurality of first source/drain regions 130A in the first device area TA1 and the plurality of second source/drain regions 130B in the second device area TA2 may have different shapes and sizes from one another.

As shown in FIGS. 2A and 2C, each of the plurality of gate lines 160 may include a main gate portion 160M, which extends lengthwise in the second horizontal direction (the Y direction) to cover the upper surface of the nanosheet stack NSS, and a plurality of sub-gate portions 160S, which are integrally connected to the main gate portion 160M and are respectively arranged separation spaces between the fin-type active region F1 and the first nanosheet N1 and between each of the first to fourth nanosheets N1, N2, N3, and N4. In the vertical direction (the Z direction), the thickness of each of the plurality of sub-gate portions 160S may be less than the thickness of the main gate portion 160M.

A gate dielectric film 152 may be arranged between the nanosheet stack NSS and the gate line 160. The gate dielectric film 152 may include a stack structure of an interface dielectric film and a high-k dielectric film. The interface dielectric film may include a low-k material film having a dielectric constant of about 9 or less, for example, a silicon oxide film, a silicon oxynitride film, or a combination thereof. In some embodiments, the interface dielectric film may be omitted. The high-k dielectric film may include a material having a dielectric constant that is greater than that of a silicon oxide film. For example, the high-k dielectric film may have a dielectric constant of about 10 to about 25. The high-k dielectric film may include, but is not limited to, hafnium oxide.

Each of the plurality of gate lines 160 may include a metal, a metal nitride, a metal carbide, or a combination thereof. The metal may be selected from Ti, W, Ru, Nb, Mo, Hf, Ni, Co, Pt, Yb, Tb, Dy, Er, and Pd. The metal nitride may be selected from TiN and TaN. The metal carbide may include TiAlC. However, a material constituting the plurality of gate lines 160 is not limited to the examples set forth above.

In the first device area TA1 and the second device area TA2, a plurality of nanosheet transistors may be respectively arranged in intersection areas between the plurality of fin-type active regions F1 and the plurality of gate lines 160. In the first device area TA1 and the second device area TA2, the plurality of gate lines 160, the plurality of nanosheet stacks NSS, and the plurality of source/drain regions 130 may constitute the plurality of nanosheet transistors. The plurality of nanosheet transistors may include a PMOS transistor and an NMOS transistor.

In some embodiments, a transistor arranged in the first device area TA1 may include a PMOS transistor, and a transistor arranged in the second device area TA2 may include an NMOS transistor. When the first device area TA1 is a PMOS transistor area, the gate line 160 arranged in the first device area TA1, among the plurality of gate lines 160, may include a first work function metal-containing film, a second work function metal-containing film, and a gap-fill metal film, which are sequentially stacked in the stated order on the gate dielectric film 152 surrounding the first to fourth nanosheets N1, N2, N3, and N4. When the second device area TA2 is an NMOS transistor area, the gate line 160 arranged in the second device area TA2, among the plurality of gate lines 160, may include the second work function metal-containing film and the gap-fill metal film, which are sequentially stacked in the stated order on the gate dielectric film 152 surrounding the first to fourth nanosheets N1, N2, N3, and N4. In some embodiments, the first work function metal-containing film may include a TiN film, the second work function metal-containing film may include a combination of a first TiN film, a TiAlC film, and a second TiN film, and the gap-fill metal film may include W, Al, or a combination thereof, but the inventive concept is not limited thereto.

As shown in FIG. 2A, both sidewalls of each of the plurality of sub-gate portions 160S of the plurality of gate lines 160 may each be spaced apart from the source/drain region 130 with the gate dielectric film 152 therebetween. The gate dielectric film 152 may be arranged between a sub-gate portion 160S of the gate line 160 and each of the first to fourth nanosheets N1, N2, N3, and N4 and between a lowermost sub-gate portion 160S of the gate line 160 and the fin-type active region F1.

As shown in FIG. 2A, both sidewalls of the gate line 160 may be respectively covered by a plurality of main insulating spacers 118. Each of the plurality of main insulating spacers 118 may be arranged on the upper surface of the nanosheet stack NSS to cover the sidewall of the main gate portion 160M. Each of the plurality of main insulating spacers 118 may be spaced apart from the gate line 160 with the gate dielectric film 152 therebetween. As shown in FIG. 2B, a plurality of side insulating spacers 119 may be arranged on the device isolation film 112. Each of the plurality of side insulating spacers 119 may cover the upper sidewall of the fin-type active region F1 adjacent thereto and the sidewall of the source/drain region 130 adjacent thereto. As shown in FIG. 2D, each of the plurality of side insulating spacers 119 may be integrally connected to a main insulating spacer 118 adjacent thereto.

The plurality of main insulating spacers 118 and the plurality of side insulating spacers 119 may each include silicon nitride, silicon oxide, SiOC, SiOCN, SiCN, SiBN, SiON, SiBCN, SiOF, SiOCH, or a combination thereof. The plurality of main insulating spacers 118 and the plurality of side insulating spacers 119 may each include a single film including one material film selected from the materials listed above or a multi-film including a plurality of material films selected from the materials listed above.

Each of the plurality of insulating wall structures WS1 may be arranged adjacent to, in the second horizontal direction (the Y direction), the plurality of gate lines 160, the plurality of source/drain regions 130, and the plurality of nanosheet stacks NSS, which are arranged on or over one fin-type active region F1. Each of the plurality of insulating wall structures WS1 may be arranged between a pair of fin-type active regions F1 adjacent to one another, between a pair of source/drain regions 130 adjacent to one another, and between a pair of gate lines 160 adjacent to one another.

As shown in FIGS. 2B, 2C, and 2D, each of the plurality of insulating wall structures WS1 may include a main insulating wall MW, which has a first sidewall S1 and a second sidewall S2 opposite to one another, and a plurality of cladding portions VC respectively covering portions of the main insulating wall MW. Each of the plurality of cladding portions VC may include a first cladding portion VCA covering the lower surface, which faces the device isolation film 112, of the main insulating wall MW, and a second cladding portion VCB covering the first sidewall S1 and the second sidewall S2 of the main insulating wall MW. In each of the plurality of insulating wall structures WS1, the main insulating wall MW and each of the plurality of cladding portions VC may include different materials. In some embodiments, the main insulating wall MW may include a nitrogen-containing insulating material, for example, silicon nitride (SiN), SiCN, SiBN, SiON, SiOCN, SiBCN, or a combination thereof. As used herein, each of the terms "SiN", "SiCN", "SiBN", "SiON", "SiOCN", and "SiBCN" refers to a material including elements contained in each term and is not a chemical formula representing a stoichiometric relationship. In some embodiments, each of the plurality of cladding portions VC may include silicon oxide.

FIG. 2B illustrates an example in which an upper portion of the main insulating wall MW protrudes upwards up to a vertical level that is higher than the vertical level of uppermost surfaces of a pair of source/drain regions 130 adjacent to the main insulating wall MW, but the inventive concept is not limited thereto. In some embodiments, a height DH of the upper portion of the main insulating wall MW, which protrudes above the uppermost surfaces of the pair of source/drain regions 130 adjacent to the main insulating wall MW, may be selected from a range of about 0 nm to about 30 nm.

As shown in FIG. 2D, each of the plurality of gate dielectric films 152 may include an end portion 152E that is adjacent to, in the second horizontal direction (the Y direction), the first sidewall S1 or the second sidewall S2 of the main insulating wall MW of the insulating wall structure WS1. In a plan view, a plurality of blocking insulating spacers SP1 may be respectively arranged in regions that are adjacent to, in the second horizontal direction (the Y direction), the first sidewall S1 and the second sidewall S2 of the main insulating wall MW. Herein, a plan view refers to a viewpoint viewed from the X-Y plane in the accompanying drawings.

In a plan view, a pair of blocking insulating spacers SP1 may be arranged in a gap area GA between the first sidewall S1 or the second sidewall S2 of the main insulating wall MW and one gate line 160 in the second horizontal direction (the Y direction). In a plan view, each of the plurality of blocking insulating spacers SP1 may fill a corner area defined in the gap area GA by the gate dielectric film 152 and the source/drain region 130.

The pair of blocking insulating spacers SP1 may be respectively in contact with a pair of source/drain regions 130 spaced apart from one another with one gate line 160 adjacent to the pair of blocking insulating spacers SP1 therebetween. In a plan view, each of the pair of blocking insulating spacers SP1 arranged in the gap area GA may be in contact with a source/drain region 130 adjacent thereto and may have a concave surface toward the adjacent source/drain region 130. Each of the pair of blocking insulating spacers SP1 arranged in the gap area GA may prevent a short-circuit between the gate line 160 and the source/drain region 130 and/or a short-circuit between a pair of source/drain regions 130 adjacent to one another, in the gap area GA between the first sidewall S1 or the second sidewall S2 of the main insulating wall MW and one gate line 160 adjacent to the pair of blocking insulating spacers SP1, or in the vicinity of the gap area GA.

The pair of blocking insulating spacers SP1 in the gap area GA and adjacent to one gate line 160 may be spaced apart from one another in the first horizontal direction (the X direction) with a portion of the second cladding portion VCB of the insulating wall structure WS1 in the gap area GA therebetween. Each of the pair of blocking insulating spacers SP1 may include a portion contacting the gate dielectric film 152 in the gap area GA and a portion contacting the first sidewall S1 or the second sidewall S2 of the insulating wall structure WS1.

The pair of blocking insulating spacers SP1 in the gap area GA and adjacent to one gate line 160 may be in contact with the surface of the second cladding portion VCB of the insulating wall structure WS1. In a plan view, a separation distance in the first horizontal direction (the X direction) between the pair of blocking insulating spacers SP1 may gradually increase toward the first sidewall S1 or the second sidewall S2 of the main insulating wall MW in the second horizontal direction (the Y direction). The width of each of the pair of blocking insulating spacers SP1 in the first horizontal direction (the X direction) may vary. Each of the pair of blocking insulating spacers SP1 may have, but is not limited to, a width of about 0.5 nm to about 4 nm in the first horizontal direction (the X direction).

A constituent material of the blocking insulating spacer SP1 may be different from a constituent material of the cladding portion VC. In some embodiments, the blocking insulating spacer SP1 may include a nitrogen-containing insulating material, for example, silicon nitride (SiN), SiCN, SiBN, SiON, SiOCN, SiBCN, or a combination thereof, and the first cladding portion VCA and the second cladding portion VCB, which constitute the cladding portion VC, may include silicon oxide.

As shown in FIG. 2D, the planar shape of a pair of blocking insulating spacers SP1 in the gap area GA between one of a pair of gate lines 160 spaced apart from one another in the second horizontal direction (the Y direction) with one insulating wall structure WS1 therebetween and the first sidewall S1 of the main insulating wall MW of the one insulating wall structure WS1 may be axially symmetric to the planar shape of a pair of blocking insulating spacers SP1 in the gap area GA between the other one of the pair of gate lines 160 and the second sidewall S2 of the main insulating wall MW about the center line of the main insulating wall MW of the one insulating wall structure WS1, the center line following the first horizontal direction (the X direction).

As shown in FIGS. 2B and 2C, the first cladding portion VCA of the insulating wall structure WS1 may be in contact with the lower surface and lower sidewalls of one main insulating wall MW that passes between a pair of source/drain regions 130 adjacent to one another in the second horizontal direction (the Y direction) and between a pair of gate lines 160 adjacent to one another in the second horizontal direction (the Y direction). A vertical level of the uppermost surface of the first cladding portion VCA between the pair of source/drain regions 130 adjacent to one another in the second horizontal direction (the Y direction) may be equal to or lower than a vertical level of the frontside surface 102F of the fin-type active region F1 adjacent to the first cladding portion VCA. At a vertical level that is higher than the upper surface of a local region (which may be referred to as a first local region, herein) of the device isolation film 112, which overlaps the insulating wall structure WS1 in the vertical direction (the Z direction), the first cladding portion VCA may be in contact with the lower surface of the main insulating wall MW.

As shown in FIG. 2D, in a plan view, the second cladding portion VCB of the insulating wall structure WS1 may include, in the first horizontal direction (the X direction), a portion between a pair of blocking insulating spacers SP1 and may include, in the second horizontal direction (the Y direction), a portion between the first sidewall S1 of the main insulating wall MW and the end portion 152E of the gate dielectric film 152 adjacent to the first sidewall S1 and a portion between the second sidewall S2 of the main insulating wall MW and the end portion 152E of the gate dielectric film 152 adjacent to the second sidewall S2.

As shown in FIGS. 2C and 2E, the second cladding portion VCB of the insulating wall structure WS1 may be arranged between the first sidewall S1 of the main insulating wall MW and the first to fourth nanosheets N1, N2, N3, and N4 of the nanosheet stack NSS. The second cladding portion VCB may have a flat surface contacting the first sidewall S1 of the main insulating wall MW in the second horizontal direction (the Y direction) and an uneven surface facing the first to fourth nanosheets N1, N2, N3, and N4 and the gate line 160 in the second horizontal direction (the Y direction). The uneven surface of the second cladding portion VCB may include a surface contacting each of the first to fourth nanosheets N1, N2, N3, and N4 and a surface contacting the gate dielectric film 152. The uneven surface of the second cladding portion VCB may be spaced apart from the gate line 160 with the gate dielectric film 152 therebetween.

As shown in FIG. 2E, in the second horizontal direction (the Y direction), a first minimum separation width W11 between the first to fourth nanosheets N1, N2, N3, and N4 and the first sidewall S1 or the second sidewall S2 of the main insulating wall MW may be greater than a second minimum separation width W12 between the gate dielectric film 152 and the first sidewall S1 or the second sidewall S2 of the main insulating wall MW. A third minimum separation width W13 between the gate line 160 and the first sidewall S1 or the second sidewall S2 of the main insulating wall MW may be less than the first minimum separation width W11 and may be greater than the second minimum separation width W12. In some embodiments, the first minimum separation width W11 may be about 5 nm to about 10 nm and the second minimum separation width W12 may be about 3 nm to about 8 nm, but the inventive concept is not limited thereto. In some embodiments, the third minimum separation width W13 may have a value that is less than the first minimum separation width W11 and less than the length, in the second horizontal direction (the Y direction), of the blocking insulating spacer SP1 (see FIG. 2D) within a range of about 3 nm to about 8 nm, but the inventive concept is not limited thereto.

As shown in FIG. 2E, the integrated circuit device 100 may have a structure in which the third minimum separation width W13 between the gate line 160 and the first sidewall S1 or the second sidewall S2 of the main insulating wall MW is less than the first minimum separation width W11 between the first to fourth nanosheets N1, N2, N3, and N4 and the first sidewall S1 of the main insulating wall MW. Therefore, a structure, in which the gate line 160 surrounds the first to fourth nanosheets N1, N2, N3, and N4 throughout the total length of the first to fourth nanosheets N1, N2, N3, and N4 in the second horizontal direction (the Y direction), may be implemented. Therefore, it may be prevented that an effective work function is unintentionally reduced in a transistor in the integrated circuit device 100, and the performance of the transistor may be maximized.

As shown in FIG. 2C, local upper surfaces, not overlapping the insulating wall structure WS1 in the vertical direction (the Z direction), out of the upper surface of the device isolation film 112 may be respectively covered by a plurality of isolation insulating patterns 114. The respective lower surfaces of the plurality of isolation insulating patterns 114 may be in contact with the local upper surfaces of the device isolation film 112. The plurality of isolation insulating patterns 114 may include an isolation insulating pattern 114 (which may be referred to as a first isolation insulating pattern) between the device isolation film 112 and the gate line 160. The isolation insulating pattern 114 between the device isolation film 112 and the gate line 160 may be in contact with the upper sidewall of the fin-type active region F1 adjacent to the isolation insulating pattern 114. The fin-type active region F1 adjacent to the isolation insulating pattern 114 may be one selected from a pair of fin-type active regions F1, which are spaced apart from one another with one insulating wall structure WS1 therebetween and contact the one insulating wall structure WS1. The isolation insulating pattern 114 between the device isolation film 112 and the gate line 160 may face the first cladding portion VCA of the insulating wall structure WS1 in the second horizontal direction (the Y direction) with one fin-type active region F1 therebetween. The device isolation film 112 may be spaced apart from the gate line 160 and the gate dielectric film 152 in the vertical direction (the Z direction) with the isolation insulating pattern 114 therebetween.

As shown in FIGS. 2A and 2C, the upper surface of each of the insulating wall structure WS1, the gate line 160, the gate dielectric film 152, and the main insulating spacer 118 may be covered by a capping insulating pattern 168. Each capping insulating pattern 168 may include a silicon nitride film. The upper surface of the insulating wall structure WS1 may be in contact with the lower surface of the capping insulating pattern 168.

As shown in FIG. 2B, the insulating wall structure WS1, the plurality of source/drain regions 130, the device isolation film 112, the plurality of main insulating spacers 118, and the plurality of side insulating spacers 119 may be covered by an insulating liner 142. An inter-gate dielectric 144 may be arranged on the insulating liner 142. The inter-gate dielectric 144 may be arranged between a pair of gate lines 160, which are adjacent to one another in the first horizontal direction (the X direction), and between a pair of source/drain regions 130, which are adjacent to one another in the second horizontal direction (the Y direction). In some embodiments, the insulating liner 142 may include, but is not limited to, silicon nitride, SiCN, SiBN, SiON, SiOCN, SiBCN, or a combination thereof. The inter-gate dielectric 144 may include, but is not limited to, a silicon oxide film.

As shown in FIGS. 2A and 2B, a plurality of source/drain contacts CA may be respectively arranged on the plurality of source/drain regions 130. Each of the plurality of source/drain contacts CA may be configured to be electrically connected to at least one source/drain region 130 selected from the plurality of source/drain regions 130. For example, one source/drain contact CA may be connected to one source/drain region 130 or to a plurality of source/drain regions 130 adjacent to one another.

A metal silicide film 172 may be arranged between the source/drain region 130 and the source/drain contact CA. The metal silicide film 172 may be in contact with the source/drain region 130. The source/drain contact CA may pass through the inter-gate dielectric 144 and the insulating liner 142 in the vertical direction (the Z direction) to contact the metal silicide film 172. The source/drain contact CA may be configured to be connected to the source/drain region 130 via the metal silicide film 172. The insulating liner 142 and the inter-gate dielectric 144 may surround the sidewall of the source/drain contact CA.

In some embodiments, the metal silicide film 172 may include Ti, W, Ru, Nb, Mo, Hf, Ni, Co, Pt, Yb, Tb, Dy, Er, or Pd. For example, the metal silicide film 172 may include titanium silicide. In some embodiments, the source/drain contact CA may include only a metal plug including a single metal. In some embodiments, the source/drain contact CA may include a metal plug and a conductive barrier film surrounding the metal plug. The metal plug may include, but is not limited to, Mo, W, Co, Ru, Mn, Ti, Ta, Al, Cu, a combination thereof, or an alloy thereof. The conductive barrier film may include a metal or a conductive metal nitride. For example, the conductive barrier film may include, but is not limited to, Ti, Ta, W, TiN, TaN, WN, WCN, TiSiN, TaSiN, WSiN, or a combination thereof.

As shown in FIGS. 2A, 2B, and 2C, the upper surface of each of the source/drain contact CA, a plurality of capping insulating patterns 168, and the inter-gate dielectric 144 may be covered by an upper insulating structure 180. The upper insulating structure 180 may include an etch stop film 182 and an upper insulating film 184, which are sequentially stacked in the stated order on each of the inter-gate dielectric 144, the plurality of capping insulating patterns 168, and the plurality of source/drain contacts CA. The etch stop film 182 may include silicon carbide (SiC), SiN, SiCN, SiOC, AlN, AlON, AlO, AlOC, or a combination thereof. The upper insulating film 184 may include an oxide film, a nitride film, an ultralow-k film having an ultralow dielectric constant of about 2.2 to about 2.4, or a combination thereof. For example, the upper insulating film 184 may include, but is not limited to, a tetraethylorthosilicate (TEOS) film, a high-density plasma (HDP) oxide film, a boro-phospho-silicate glass (BPSG) film, a flowable chemical vapor deposition (FCVD) oxide film, a SiON film, a SiN film, a SiOC film, a SiCOH film, or a combination thereof.

A source/drain via contact VA may be arranged on the source/drain contact CA. A plurality of source/drain via contacts VA may each pass through the upper insulating structure 180 to contact the source/drain contact CA. The source/drain region 130 connected to the source/drain contact CA from among the plurality of source/drain regions 130 may be configured to be electrically connected to the source/drain via contact VA via the metal silicide film 172 and the source/drain contact CA. Each of the plurality of source/drain via contacts VA may include, but is not limited to, Mo or W.

A gate contact CB may be arranged on the gate line 160. The gate contact CB may be configured to pass through the upper insulating structure 180 and the capping insulating pattern 168 in the vertical direction (the Z direction) and be connected to the gate line 160. The lower surface of the gate contact CB may be in contact with the upper surface of the gate line 160. The gate contact CB may include a contact plug including Mo, Cu, W, Co, Ru, Mn, Ti, Ta, Al, a combination thereof, or an alloy thereof, but a constituent material of the contact plug is not limited to the examples set forth above. In some embodiments, the gate contact CB may further include a conductive barrier pattern surrounding a portion of the contact plug. The conductive barrier pattern of the gate contact CB may include a metal or a metal nitride. For example, the conductive barrier pattern may include, but is not limited to, Ti, Ta, W, TiN, TaN, WN, WCN, TiSiN, TaSiN, WSiN, or a combination thereof.

The upper surface of the upper insulating structure 180 may be covered by an interlayer dielectric 186. A constituent material of the interlayer dielectric 186 is substantially the same as the constituent material of the upper insulating film 184 described above. A plurality of upper wiring layers M1 may be arranged to pass through the interlayer dielectric 186. The plurality of upper wiring layers M1 may include an upper wiring layer M1 connected to the source/drain via contact VA and an upper wiring layer M1 connected to the gate contact CB. Each of the plurality of upper wiring layers M1 may include, but is not limited to, Mo, Cu, W, Co, Ru, Mn, Ti, Ta, Al, a combination thereof, or an alloy thereof. A frontside wiring structure may be further arranged on the interlayer dielectric 186 and the upper wiring layer M1, as needed.

The integrated circuit device 100 described with reference to FIGS. 1 and 2A to 2E includes a pair of blocking insulating spacers SP1 arranged in the gap area GA between the first sidewall S1 or the second sidewall S2 of the main insulating wall MW of the insulating wall structure WS1 and one gate line 160. The pair of blocking insulating spacers SP1 may prevent, in the gap area GA or the vicinity thereof, a short-circuit between the gate line 160 and the source/drain region 130 and/or a short-circuit between a pair of source/drain regions 130 adjacent to one another.

In addition, as shown in FIG. 2E, the integrated circuit device 100 may have a structure in which the third minimum separation width W13 between the gate line 160 and the first sidewall S1 or the second sidewall S2 of the main insulating wall MW is less than the first minimum separation width W11 between the first to fourth nanosheets N1, N2, N3, and N4 and the first sidewall S1 of the main insulating wall MW. Therefore, a structure, in which the gate line 160 surrounds the first to fourth nanosheets N1, N2, N3, and N4 throughout the total length of the first to fourth nanosheets N1, N2, N3, and N4 in the second horizontal direction (the Y direction), may be implemented. Therefore, it may be prevented that an effective work function is unintentionally reduced in a transistor in the integrated circuit device 100, and the performance of the transistor may be maximized.

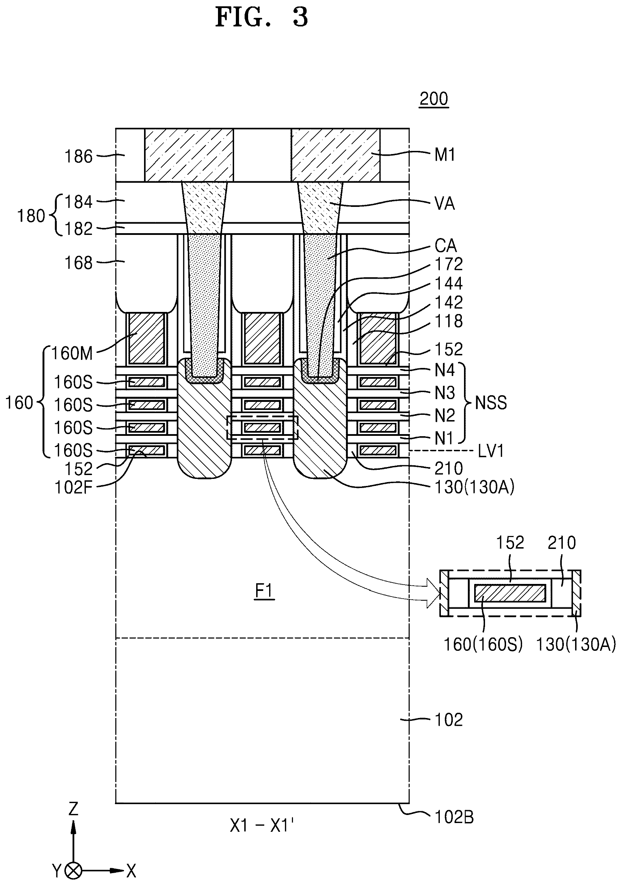

FIG. 3 is a cross-sectional view illustrating an integrated circuit device 200 according to some embodiments. FIG. 3 illustrates a cross-sectional configuration of a portion of the integrated circuit device 200, the portion corresponding to the cross-section taken along the line X1-X1' of FIG. 1. In FIG. 3, the same reference numerals as in FIGS. 1 and 2A to 2E respectively denote the same members, and here, repeated descriptions thereof are omitted.

Referring to FIG. 3, the integrated circuit device 200 has substantially the same configuration as the integrated circuit device 100 described with reference to FIGS. 1 and 2A to 2E. However, the integrated circuit device 200 further includes a plurality of first inner spacers 210. The plurality of first inner spacers 210 are arranged one-by-one between each of the plurality of sub-gate portions 160S of the gate line 160 and each of a pair of source/drain regions 130 arranged on both sides, in the first horizontal direction (the X direction), of the gate line 160.

Each of the plurality of sub-gate portions 160S may be spaced apart from the source/drain region 130 in the first horizontal direction (the X direction) with the gate dielectric film 152 and a first inner spacer 210 therebetween. Each of the plurality of first inner spacers 210 may be in contact with the source/drain region 130 adjacent thereto. At least a portion of each of the plurality of first inner spacers 210 may overlap the main insulating spacer 118 in the vertical direction (the Z direction). The first inner spacer 210 may include silicon nitride, silicon oxide, SiCN, SiBN, SiON, SiOCN, SiBCN, SiOC, or a combination thereof. In some embodiments, the first inner spacer 210 may include the same material as the main insulating spacer 118. In some embodiments, the main insulating spacer 118 and the first inner spacer 210 may respectively include different materials. Each of the plurality of source/drain regions 130 may face the sub-gate portion 160S of the gate line 160 in the first horizontal direction (the X direction) with the first inner spacer 210 therebetween.

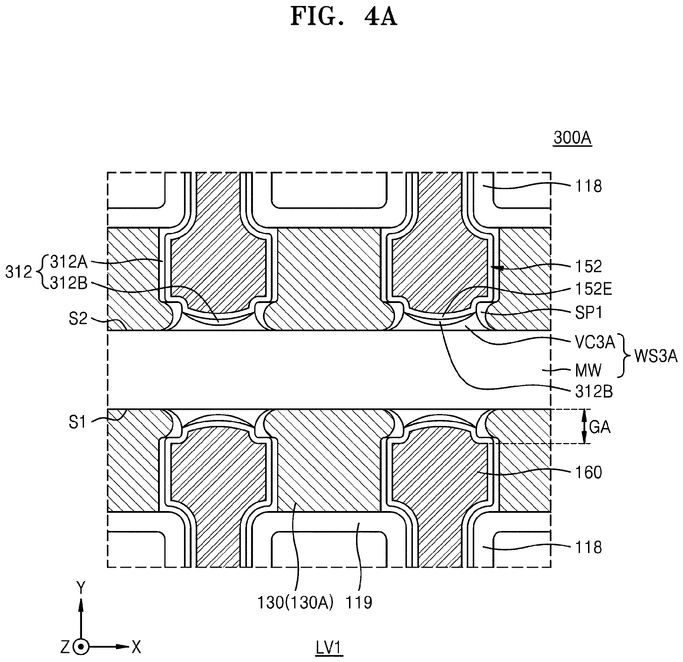

FIGS. 4A to 4F are plan views respectively illustrating integrated circuit devices 300A, 300B, 300C, 300D, 300E, and 300F according to some embodiments. FIGS. 4A to 4F respectively illustrate enlarged planar configurations of some components in regions of the integrated circuit devices 300A, 300B, 300C, 300D, 300E, and 300F, the regions corresponding to the region EX1 of FIG. 1. In some embodiments, each of the configurations shown in FIGS. 4A to 4F may constitute a portion of the integrated circuit device 100 described with reference to FIGS. 1 and 2A to 2E or a portion of the integrated circuit device 200 described with reference to FIG. 3. In FIGS. 4A to 4F, the same reference numerals as in FIGS. 1 and 2A to 2E respectively denote the same members, and here, repeated descriptions thereof are omitted.

Referring to FIG. 4A, the integrated circuit device 300A has substantially the same configuration as the integrated circuit device 200 described with reference to FIG. 3. However, the integrated circuit device 300A includes an insulating wall structure WS3A and a plurality of inner spacers 312.

In the integrated circuit device 300A, the insulating wall structure WS3A may include the main insulating wall MW having a first sidewall S1 and a second sidewall S2, which are opposite to one another, and a plurality of second cladding portions VC3A respectively covering portions of the main insulating wall MW. The insulating wall structure WS3A may further include the first cladding portion VCA described with reference to FIGS. 2B and 2C. A more detailed configuration of the insulating wall structure WS3A is substantially the same as that of the insulating wall structure WS1 described with reference to FIGS. 1 and 2A to 2E.

In the integrated circuit device 300A, each of the plurality of inner spacers 312 includes a first inner spacer 312A and a second inner spacer 312B. In a plan view, the first inner spacer 312A may be arranged between the source/drain region 130 and the gate dielectric film 152 and between the main insulating spacer 118 and the gate dielectric film 152. In some embodiments, a portion of the first inner spacer 312A may be omitted, the portion being between the main insulating spacer 118 and the gate dielectric film 152. In a plan view, the second inner spacer 312B may be arranged between, in the first horizontal direction (the X direction), a pair of blocking insulating spacer SP1 in the gap area GA between the first sidewall S1 or the second sidewall S2 of the main insulating wall MW of the insulating wall structure WS3A and one gate line 160 and may be arranged between, in the second horizontal direction (the Y direction), the end portion 152E of the gate dielectric film 152 and the first sidewall S1 or the second sidewall S2 of the main insulating wall MW of the insulating wall structure WS3A in the gap area GA.

In the second horizontal direction (the Y direction), a second cladding portion VC3A of the insulating wall structure WS3A may be arranged between the second inner spacer 312B and the first sidewall S1 or the second sidewall S2 of the main insulating wall MW. A more detailed configuration of the second cladding portion VC3A of the insulating wall structure WS3A is substantially the same as that of the second cladding portion VCB of the insulating wall structure WS1 described with reference to FIGS. 2C, 2D, and 2E. However, in a plan view, the width, in the second horizontal direction (the Y direction), of the second cladding portion VC3A between the first sidewall S1 or the second sidewall S2 of the main insulating wall MW and the gate line 160 may be less than the width in the second horizontal direction (the Y direction) between the first sidewall S1 or the second sidewall S2 of the main insulating wall MW and the end portion 152E of the gate dielectric film 152.

The plurality of first inner spacers 312A and a plurality of second inner spacers 312B may each include silicon nitride, silicon oxide, SiCN, SiBN, SiON, SiOCN, SiBCN, SiOC, or a combination thereof. The plurality of first inner spacers 312A and the plurality of second inner spacers 312B may include the same material. When the planar structure shown in FIG. 4A constitutes a portion of the integrated circuit device 200 described with reference to FIG. 3, the first inner spacer 312A may correspond to the first inner spacer 210 shown in FIG. 3, and the plurality of first inner spacers 312A and the plurality of second inner spacers 312B, which are shown in FIG. 4A, may include the same material as the plurality of first inner spacers 210 shown in FIG. 3.

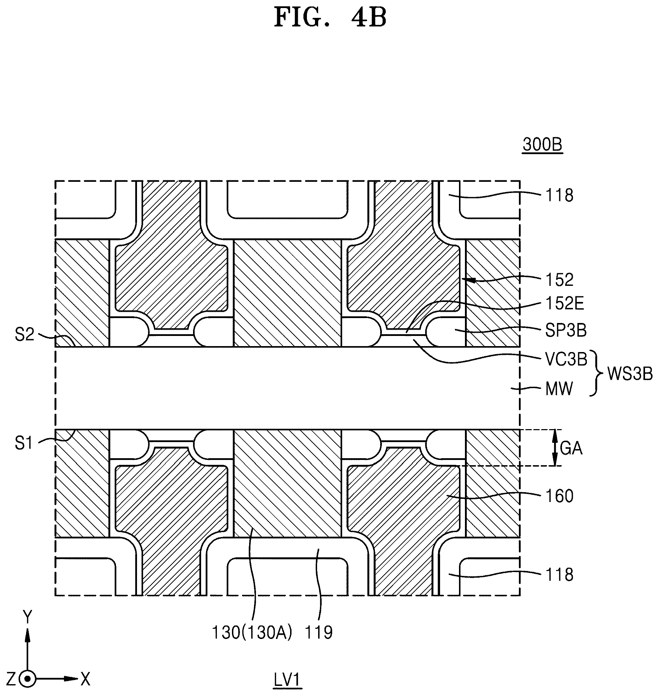

Referring to FIG. 4B, the integrated circuit device 300B has substantially the same configuration as the integrated circuit device 100 described with reference to FIGS. 1 and 2A to 2E. However, the integrated circuit device 300B includes a plurality of blocking insulating spacers SP3B and an insulating wall structure WS3B.

In a plan view, each of the plurality of blocking insulating spacers SP3B may be arranged in an area that is adjacent to the first sidewall S1 or the second sidewall S2 of the main insulating wall MW in the second horizontal direction (the Y direction). A pair of blocking insulating spacers SP3B may be arranged in the gap area GA between the first sidewall S1 or the second sidewall S2 of the main insulating wall MW and one gate line 160 in the second horizontal direction (the Y direction). Each of the plurality of blocking insulating spacers SP3B may include a flat surface contacting the source/drain region 130 adjacent thereto and a curved surface that is convex toward the inside of the gap area GA in the first horizontal direction (the X direction). In a plan view, each of the plurality of blocking insulating spacers SP3B may fill the corner area defined in the gap area GA by the gate dielectric film 152 and the source/drain region 130. Each of the plurality of blocking insulating spacers SP3B may include a nitrogen-containing insulating material, for example, silicon nitride (SiN), SiCN, SiBN, SiON, SiOCN, SiBCN, or a combination thereof. A more detailed configuration of the blocking insulating spacer SP3B is substantially the same as that of the blocking insulating spacer SP1 described with reference to FIG. 2D.

In the integrated circuit device 300B, the insulating wall structure WS3B may include the main insulating wall MW and a plurality of second cladding portions VC3B respectively covering portions of the main insulating wall MW. Each of the plurality of second cladding portions VC3B may be arranged between a pair of blocking insulating spacers SP3B in the gap area GA. In the gap area GA, the second cladding portion VC3B may be in contact with the convex curved surface of each of the pair of blocking insulating spacers SP3B adjacent thereto. The insulating wall structure WS3B may further include the first cladding portion VCA described with reference to FIGS. 2B and 2C. A more detailed configuration of the second cladding portion VC3B of the insulating wall structure WS3B is substantially the same as that of the second cladding portion VCB of the insulating wall structure WS1 described with reference to FIGS. 2C, 2D, and 2E.

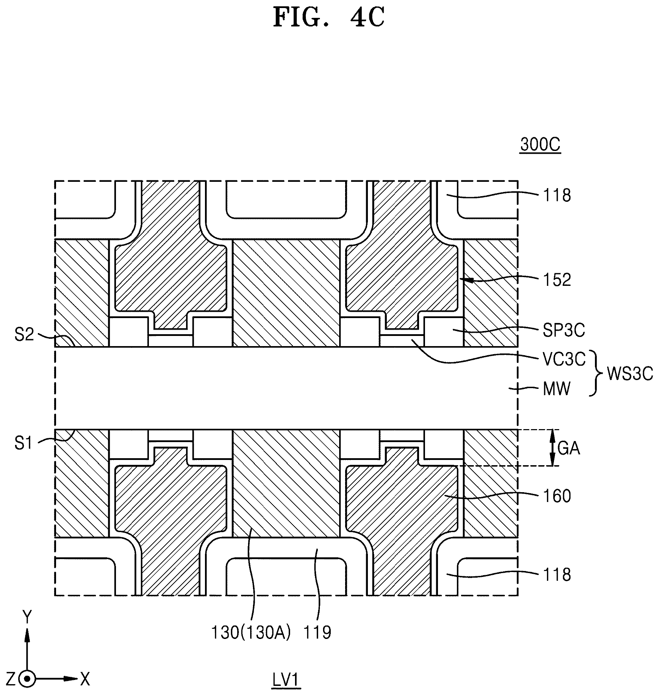

Referring to FIG. 4C, the integrated circuit device 300C has substantially the same configuration as the integrated circuit device 100 described with reference to FIGS. 1 and 2A to 2E. However, the integrated circuit device 300C includes a plurality of blocking insulating spacers SP3C and an insulating wall structure WS3C.

In a plan view, each of the plurality of blocking insulating spacers SP3C may be arranged in an area that is adjacent to the first sidewall S1 or the second sidewall S2 of the main insulating wall MW in the second horizontal direction (the Y direction). A pair of blocking insulating spacers SP3C may be arranged in the gap area GA between the first sidewall S1 or the second sidewall S2 of the main insulating wall MW and one gate line 160 in the second horizontal direction (the Y direction). Each of the plurality of blocking insulating spacers SP3C may have a flat outer surface contacting the source/drain region 130 adjacent thereto. In a plan view, each of the plurality of blocking insulating spacers SP3C may fill the corner area defined in the gap area GA by the gate dielectric film 152 and the source/drain region 130. Each of the plurality of blocking insulating spacers SP3C may include a nitrogen-containing insulating material, for example, silicon nitride (SiN), SiCN, SiBN, SiON, SiOCN, SiBCN, or a combination thereof. A more detailed configuration of the blocking insulating spacer SP3C is substantially the same as that of the blocking insulating spacer SP1 described with reference to FIG. 2D.

In the integrated circuit device 300C, the insulating wall structure WS3C may include the main insulating wall MW and a plurality of second cladding portions VC3C respectively covering portions of the main insulating wall MW. Each of the plurality of second cladding portions VC3C may be arranged between a pair of blocking insulating spacers SP3C in the gap area GA. In the gap area GA, the second cladding portion VC3C may be in contact with each of the pair of blocking insulating spacers SP3C adjacent thereto. Each of the plurality of blocking insulating spacers SP3C may have a flat inner surface contacting each of the gate dielectric film 152 and the second cladding portion VC3C in the gap area GA. The insulating wall structure WS3C may further include the first cladding portion VCA described with reference to FIGS. 2B and 2C. A more detailed configuration of the second cladding portion VC3C of the insulating wall structure WS3C is substantially the same as that of the second cladding portion VCB of the insulating wall structure WS1 described with reference to FIGS. 2C, 2D, and 2E.

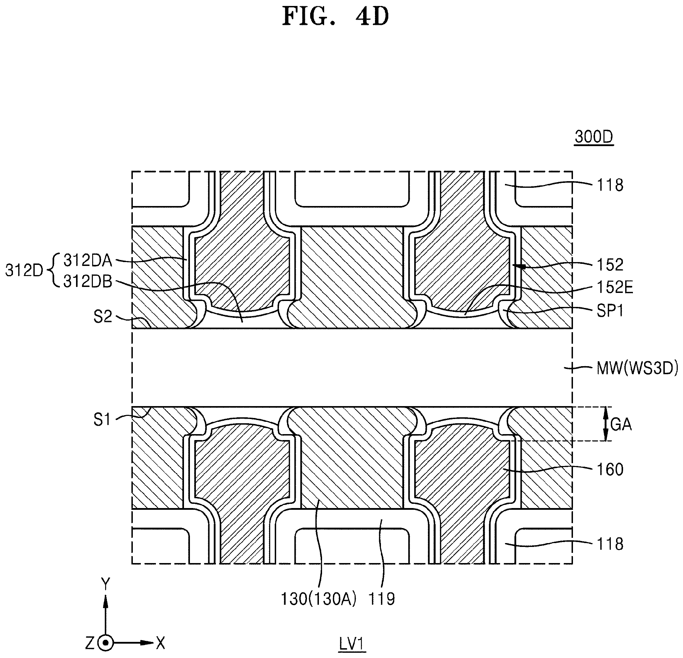

Referring to FIG. 4D, the integrated circuit device 300D has substantially the same configuration as the integrated circuit device 200 described with reference to FIG. 3. However, the integrated circuit device 300D includes an insulating wall structure WS3D and a plurality of inner spacers 312D.

The insulating wall structure WS3D may include the main insulating wall MW. The insulating wall structure WS3D may further include the first cladding portion VCA described with reference to FIGS. 2B and 2C. The insulating wall structure WS3D may not include a component corresponding to the second cladding portion VCB (see FIGS. 2C, 2D, and 2E) that is in contact with the first sidewall S1 and the second sidewall S2 of the main insulating wall MW.

In the integrated circuit device 300D, each of the plurality of inner spacers 312D includes a first inner spacer 312DA and a second inner spacer 312DB. In a plan view, the first inner spacer 312DA may be arranged between the source/drain region 130 and the gate dielectric film 152 and between the main insulating spacer 118 and the gate dielectric film 152. In some embodiments, a portion of the first inner spacer 312DA may be omitted, the portion being between the main insulating spacer 118 and the gate dielectric film 152. In a plan view, the second inner spacer 312DB may be arranged between, in the first horizontal direction (the X direction), a pair of blocking insulating spacers SP1 in the gap area GA between the first sidewall S1 or the second sidewall S2 of the main insulating wall MW of the insulating wall structure WS3D and one gate line 160 and may be arranged between, in the second horizontal direction (the Y direction), the end portion 152E of the gate dielectric film 152 and the first sidewall S1 or the second sidewall S2 of the main insulating wall MW of the insulating wall structure WS3D in the gap area GA.

Each of a plurality of second inner spacers 312DB may include a portion contacting the first sidewall S1 or the second sidewall S2 of the main insulating wall MW and portions respectively contacting the pair of blocking insulating spacer SP1 in the gap area GA and adjacent to each second inner spacer 312DB. Each of a plurality of first inner spacers 312DA may be in contact with the source/drain region 130, the gate dielectric film 152, and the main insulating spacer 118, which are adjacent thereto.

The plurality of first inner spacers 312DA and the plurality of second inner spacers 312DB may each include silicon nitride, silicon oxide, SiCN, SiBN, SiON, SiOCN, SiBCN, SiOC, or a combination thereof. The plurality of first inner spacers 312DA and the plurality of second inner spacers 312DB may include the same material. When the planar structure shown in FIG. 4D constitutes a portion of the integrated circuit device 200 described with reference to FIG. 3, the first inner spacer 312DA may correspond to the first inner spacer 210 shown in FIG. 3, and the plurality of first inner spacers 312DA and the plurality of second inner spacers 312DB, which are shown in FIG. 4D, may include the same material as the plurality of first inner spacers 210 shown in FIG. 3.

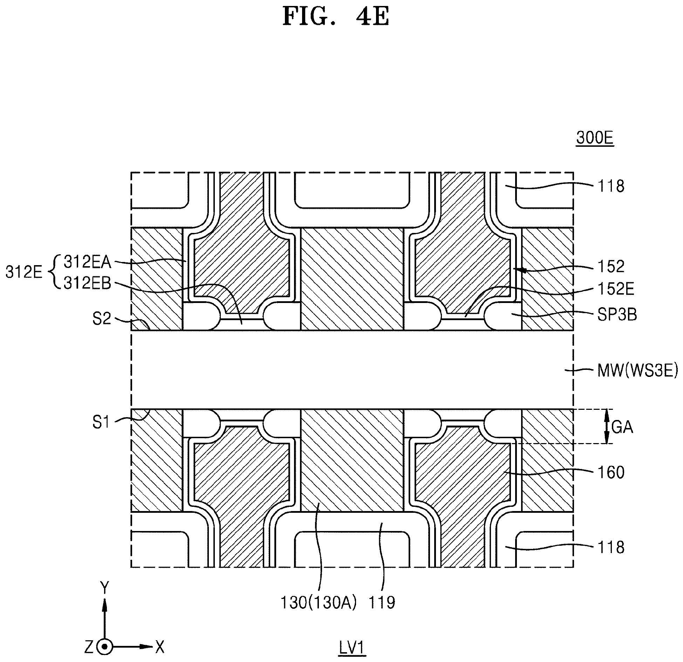

Referring to FIG. 4E, the integrated circuit device 300E has substantially the same configuration as the integrated circuit device 200 described with reference to FIG. 3. However, the integrated circuit device 300E includes an insulating wall structure WS3E and an inner spacer 312E.

The insulating wall structure WS3E may include the main insulating wall MW. The insulating wall structure WS3E may further include the first cladding portion VCA described with reference to FIGS. 2B and 2C. The insulating wall structure WS3E may not include a component corresponding to the second cladding portion VCB (see FIGS. 2C, 2D, and 2E) that is in contact with the first sidewall S1 and the second sidewall S2 of the main insulating wall MW.

In the integrated circuit device 300E, a plurality of inner spacers 312E each include a first inner spacer 312EA and a second inner spacer 312EB. In a plan view, the first inner spacer 312EA may be arranged between the source/drain region 130 and the gate dielectric film 152 and between the main insulating spacer 118 and the gate dielectric film 152. In some embodiments, a portion of the first inner spacer 312EA may be omitted, the portion being between the main insulating spacer 118 and the gate dielectric film 152. In a plan view, the second inner spacer 312EB may be arranged between, in the first horizontal direction (the X direction), a pair of blocking insulating spacer SP3B in the gap area GA between the first sidewall S1 or the second sidewall S2 of the main insulating wall MW of the insulating wall structure WS3E and one gate line 160 and may be arranged between, in the second horizontal direction (the Y direction), the end portion 152E of the gate dielectric film 152 and the first sidewall S1 or the second sidewall S2 of the main insulating wall MW of the insulating wall structure WS3E in the gap area GA.

Each of a plurality of second inner spacers 312EB may include a portion contacting the first sidewall S1 or the second sidewall S2 of the main insulating wall MW and portions respectively contacting the pair of blocking insulating spacer SP3B in the gap area GA and adjacent to each second inner spacer 312EB. Each of a plurality of first inner spacers 312EA may be in contact with the source/drain region 130, the gate dielectric film 152, and the main insulating spacer 118, which are adjacent thereto.

The plurality of first inner spacers 312EA and the plurality of second inner spacers 312EB may each include silicon nitride, silicon oxide, SiCN, SiBN, SiON, SiOCN, SiBCN, SiOC, or a combination thereof. The plurality of first inner spacers 312EA and the plurality of second inner spacers 312EB may include the same material. When the planar structure shown in FIG. 4E constitutes a portion of the integrated circuit device 200 described with reference to FIG. 3, the first inner spacer 312EA may correspond to the first inner spacer 210 shown in FIG. 3, and the plurality of first inner spacers 312EA and the plurality of second inner spacers 312EB, which are shown in FIG. 4E, may include the same material as the plurality of first inner spacers 210 shown in FIG. 3.

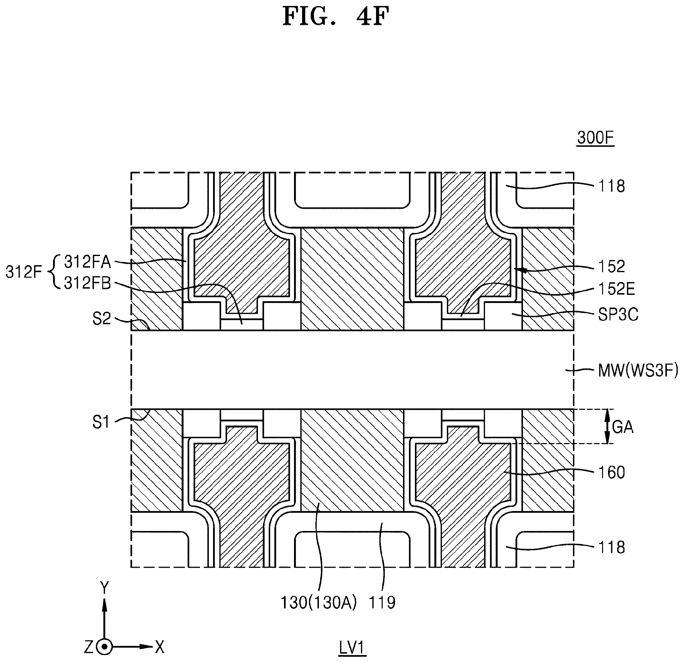

Referring to FIG. 4F, the integrated circuit device 300F has substantially the same configuration as the integrated circuit device 200 described with reference to FIG. 3. However, the integrated circuit device 300F includes an insulating wall structure WS3F and an inner spacer 312F.

The insulating wall structure WS3F may include the main insulating wall MW. The insulating wall structure WS3F may further include the first cladding portion VCA described with reference to FIGS. 2B and 2C. The insulating wall structure WS3F may not include a component corresponding to the second cladding portion VCB (see FIGS. 2C, 2D, and 2E) that is in contact with the first sidewall S1 and the second sidewall S2 of the main insulating wall MW.

In the integrated circuit device 300F, a plurality of inner spacers 312F each include a first inner spacer 312FA and a second inner spacer 312FB. In a plan view, the first inner spacer 312FA may be arranged between the source/drain region 130 and the gate dielectric film 152 and between the main insulating spacer 118 and the gate dielectric film 152. In some embodiments, a portion of the first inner spacer 312FA may be omitted, the portion being between the main insulating spacer 118 and the gate dielectric film 152. In a plan view, the second inner spacer 312FB may be arranged between, in the first horizontal direction (the X direction), a pair of blocking insulating spacer SP3C in the gap area GA between the first sidewall S1 or the second sidewall S2 of the main insulating wall MW of the insulating wall structure WS3F and one gate line 160 and may be arranged between, in the second horizontal direction (the Y direction), between the end portion 152E of the gate dielectric film 152 and the first sidewall S1 or the second sidewall S2 of the main insulating wall MW of the insulating wall structure WS3F in the gap area GA.

Each of a plurality of second inner spacers 312FB may include a portion contacting the first sidewall S1 or the second sidewall S2 of the main insulating wall MW and portions respectively contacting the pair of blocking insulating spacer SP3C in the gap area GA and adjacent to each second inner spacer 312FB. Each of a plurality of first inner spacers 312FA may be in contact with the source/drain region 130, the gate dielectric film 152, and the main insulating spacer 118, which are adjacent thereto.

The plurality of first inner spacers 312FA and the plurality of second inner spacers 312FB may each include silicon nitride, silicon oxide, SiCN, SiBN, SiON, SiOCN, SiBCN, SiOC, or a combination thereof. The plurality of first inner spacers 312FA and the plurality of second inner spacers 312FB may include the same material. When the planar structure shown in FIG. 4F constitutes a portion of the integrated circuit device 200 described with reference to FIG. 3, the first inner spacer 312FA may correspond to the first inner spacer 210 shown in FIG. 3, and the plurality of first inner spacers 312FA and the plurality of second inner spacers 312FB, which are shown in FIG. 4F, may include the same material as the plurality of first inner spacers 210 shown in FIG. 3.

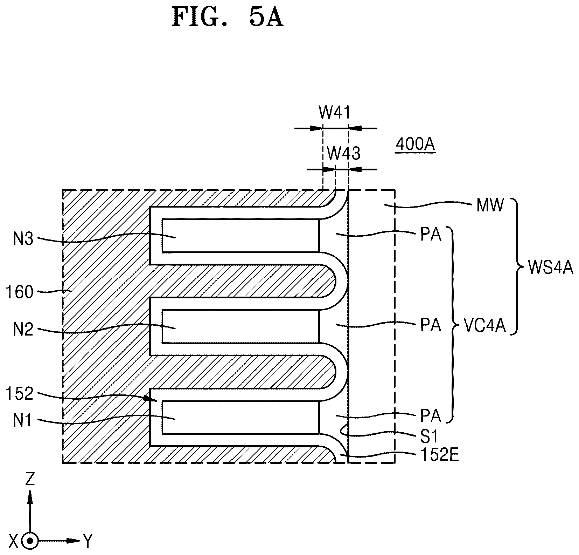

FIGS. 5A to 5E are cross-sectional views respectively illustrating integrated circuit devices 400A, 400B, 400C, 400D, and 400E according to some embodiments. FIGS. 5A to 5E respectively illustrate enlarged cross-sectional configurations of some components in regions of the integrated circuit devices 400A, 400B, 400C, 400D, and 400E, the regions corresponding to the region EX2 of FIG. 2C. In some embodiments, each of the configurations shown in FIGS. 5A to 5E may constitute a portion of the integrated circuit device 100 described with reference to FIGS. 1 and 2A to 2E or a portion of the integrated circuit device 200 described with reference to FIG. 3. In FIGS. 5A to 5E, the same reference numerals as in FIGS. 1, 2A to 2E, and 3 respectively denote the same members, and here, repeated descriptions thereof are omitted.

Referring to FIG. 5A, the integrated circuit device 400A has substantially the same configuration as the integrated circuit device 100 described with reference to FIGS. 1 and 2A to 2Eor the integrated circuit device 200 described with reference to FIG. 3. However, the integrated circuit device 400A includes an insulating wall structure WS4A.

The insulating wall structure WS4A may include the main insulating wall MW and a second cladding portion VC4A covering a portion of the main insulating wall MW. The insulating wall structure WS4A may further include the first cladding portion VCA described with reference to FIGS. 2B and 2C. The second cladding portion VC4A of the insulating wall structure WS4A may intermittently extend along the sidewall of the main insulating wall MW, for example, the first sidewall S1 of the main insulating wall MW. The second cladding portion VC4A may include a plurality of second cladding patterns PA, which are arranged in a line along the sidewall of the main insulating wall MW, for example, the first sidewall S1 of the main insulating wall MW, and spaced apart from one another in the vertical direction (the Z direction) with a local region of the gate line 160 therebetween.

Each of the plurality of second cladding patterns PA may have a surface contacting one of the first to fourth nanosheets N1, N2, N3, and N4 and a surface contacting the main insulating wall MW. The plurality of second cladding patterns PA may respectively have gradually increasing thicknesses in the vertical direction (the Z direction) toward the main insulating wall MW in the second horizontal direction (the Y direction) away from the first to fourth nanosheets N1, N2, N3, and N4. A constituent material of each of the plurality of second cladding patterns PA may be different from the constituent material of the main insulating wall MW. In some embodiments, each of the plurality of second cladding patterns PA may include silicon oxide.

In the integrated circuit device 400A, the end portion 152E of the gate dielectric film 152 may be in contact with the main insulating wall MW. A minimum separation width W43 between the gate line 160 and the first sidewall S1 of the main insulating wall MW may be less than a minimum separation width W41 between the first to fourth nanosheets N1, N2, N3, and N4 and the first sidewall S1 of the main insulating wall MW. Therefore, a structure, in which the gate line 160 surrounds the first to fourth nanosheets N1, N2, N3, and N4 throughout the total length of the first to fourth nanosheets N1, N2, N3, and N4 in the second horizontal direction (the Y direction), may be implemented. Therefore, it may be prevented that an effective work function is unintentionally reduced in a transistor in the integrated circuit device 400A, and the performance of the transistor may be maximized.

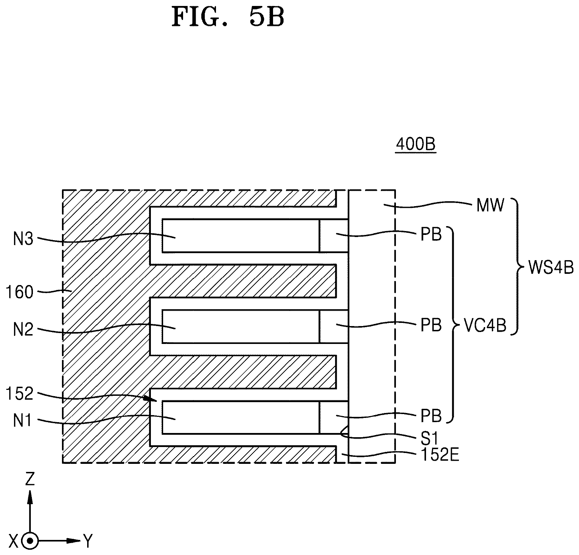

Referring to FIG. 5B, the integrated circuit device 400B has substantially the same configuration as the integrated circuit device 400A described with reference to FIG. 5A. However, the integrated circuit device 400B includes an insulating wall structure WS4B.

The insulating wall structure WS4B may include the main insulating wall MW and a second cladding portion VC4B covering a portion of the main insulating wall MW. The second cladding portion VC4B may intermittently extend along the sidewall of the main insulating wall MW, for example, the first sidewall S1 of the main insulating wall MW. The second cladding portion VC4B may include a plurality of second cladding patterns PB, which are arranged in a line along the sidewall of the main insulating wall MW, for example, the first sidewall S1 of the main insulating wall MW, and spaced apart from one another in the vertical direction (the Z direction) with a local region of the gate line 160 therebetween. The end portion 152E of the gate dielectric film 152 between each of the plurality of second cladding patterns PB may be in contact with the main insulating wall MW.

Each of the plurality of second cladding patterns PB may have a surface contacting one of the first to fourth nanosheets N1, N2, N3, and N4 and a surface contacting the main insulating wall MW. The plurality of second cladding patterns PB may respectively have approximately constant thicknesses in the vertical direction (the Z direction) toward the main insulating wall MW in the second horizontal direction (the Y direction) away from the first to fourth nanosheets N1, N2, N3, and N4. A constituent material of each of the plurality of second cladding patterns PB may be different from the constituent material of the main insulating wall MW. In some embodiments, each of the plurality of second cladding patterns PB may include silicon oxide.

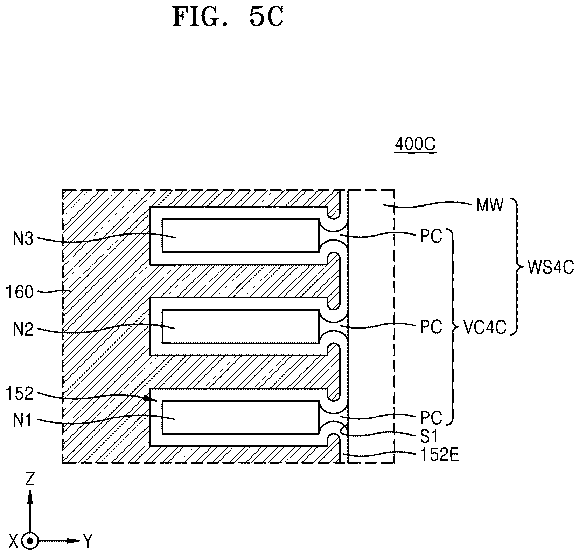

Referring to FIG. 5C, the integrated circuit device 400C has substantially the same configuration as the integrated circuit device 400A described with reference to FIG. 5A. However, the integrated circuit device 400C includes an insulating wall structure WS4C.

The insulating wall structure WS4C may include the main insulating wall MW and a second cladding portion VC4C covering a portion of the main insulating wall MW. The second cladding portion VC4C may intermittently extend along the sidewall of the main insulating wall MW, for example, the first sidewall S1 of the main insulating wall MW. The second cladding portion VC4C may include a plurality of second cladding patterns PC, which are arranged in a line along the sidewall of the main insulating wall MW, for example, the first sidewall S1 of the main insulating wall MW, and spaced apart from one another in the vertical direction (the Z direction) with a local region of the gate line 160 therebetween. The end portion 152E of the gate dielectric film 152 between each of the plurality of second cladding patterns PC may be in contact with the main insulating wall MW.

Each of the plurality of second cladding patterns PC may have a surface contacting one of the first to fourth nanosheets N1, N2, N3, and N4 and a surface contacting the main insulating wall MW. The plurality of second cladding patterns PC may respectively have variable thicknesses in the vertical direction (the Z direction) toward the main insulating wall MW in the second horizontal direction (the Y direction) away from the first to fourth nanosheets N1, N2, N3, and N4. Each of the plurality of second cladding patterns PC may have a gradually increasing thickness in the vertical direction (the Z direction) toward the main insulating wall MW or one of the first to fourth nanosheets N1, N2, N3, and N4 in the second horizontal direction (the Y direction) away from the center position, based on the second horizontal direction (the Y direction), of each second cladding pattern PC. A constituent material of each of the plurality of second cladding patterns PC may be different from the constituent material of the main insulating wall MW. In some embodiments, each of the plurality of second cladding patterns PC may include silicon oxide.

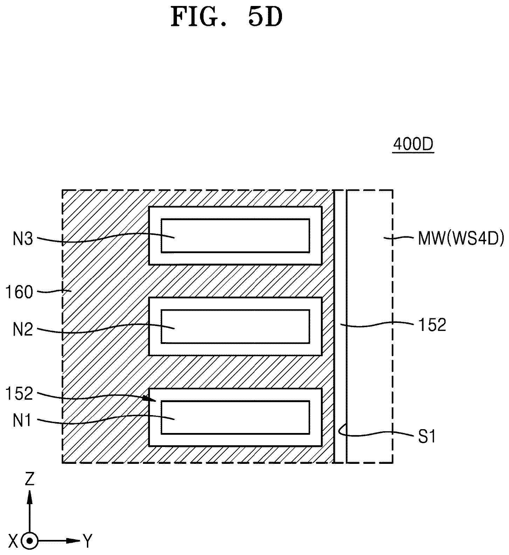

Referring to FIG. 5D, the integrated circuit device 400D has substantially the same configuration as the integrated circuit device 100 described with reference to FIGS. 1 and 2A to 2Eor the integrated circuit device 200 described with reference to FIG. 3. However, the integrated circuit device 400D includes an insulating wall structure WS4D including the main insulating wall MW. The insulating wall structure WS4D may further include the first cladding portion VCA described with reference to FIGS. 2B and 2C. The gate dielectric film 152 may include portions contacting the surfaces of the gate line 160 and a portion contacting the sidewall of the insulating wall structure WS4D, for example, the first sidewall S1 of the insulating wall structure WS4D. The gate line 160 may include a portion between each of the first to fourth nanosheets N1, N2, N3, and N4 and the sidewall of the insulating wall structure WS4D, for example, the first sidewall S1 of the insulating wall structure WS4D.

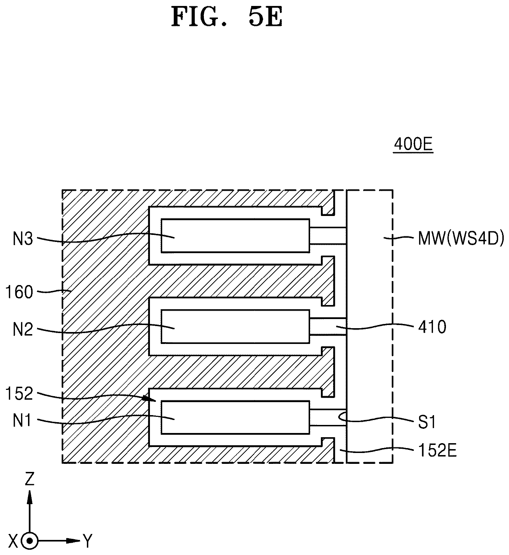

Referring to FIG. 5E, the integrated circuit device 400E has substantially the same configuration as the integrated circuit device 100 described with reference to FIGS. 1 and 2A to 2E or the integrated circuit device 200 described with reference to FIG. 3. However, the integrated circuit device 400E includes the insulating wall structure WS4D including the main insulating wall MW, similar to that shown in FIG. 5D. The insulating wall structure WS4D may further include the first cladding portion VCA described with reference to FIGS. 2B and 2C.

A plurality of edge inner spacers 410 may be arranged respectively between the first to fourth nanosheets N1, N2, N3, and N4 and the sidewall of the insulating wall structure WS4D, for example, the first sidewall S1 of the insulating wall structure WS4D. The plurality of edge inner spacers 410 may be arranged on the sidewall of the insulating wall structure WS4D so as to be in a line in the vertical direction (the Z direction) and may be spaced apart from one another with a local region of the gate line 160 therebetween.

The gate dielectric film 152 may include portions contacting the surfaces of the first to fourth nanosheets N1, N2, N3, and N4, a portion contacting the sidewall of the insulating wall structure WS4D, for example, the first sidewall S1 of the insulating wall structure WS4D, and portions contacting the plurality of edge inner spacers 410. The end portion 152E of the gate dielectric film 152 may be in contact with the main insulating wall MW.

According to the integrated circuit devices 400B, 400C, 400D, and 400E described with reference to FIGS. 5B to 5E, similar to the integrated circuit device 400A described with reference to FIG. 5A, a structure, in which the gate line 160 surrounds the first to fourth nanosheets N1, N2, N3, and N4 throughout the total length of the first to fourth nanosheets N1, N2, N3, and N4 in the second horizontal direction (the Y direction), may be implemented in the integrated circuit devices 400B, 400C, 400D, and 400E. Therefore, it may be prevented that an effective work function is unintentionally reduced in a transistor in each of the integrated circuit devices 400B, 400C, 400D, and 400E, and the performance of the transistor may be maximized.

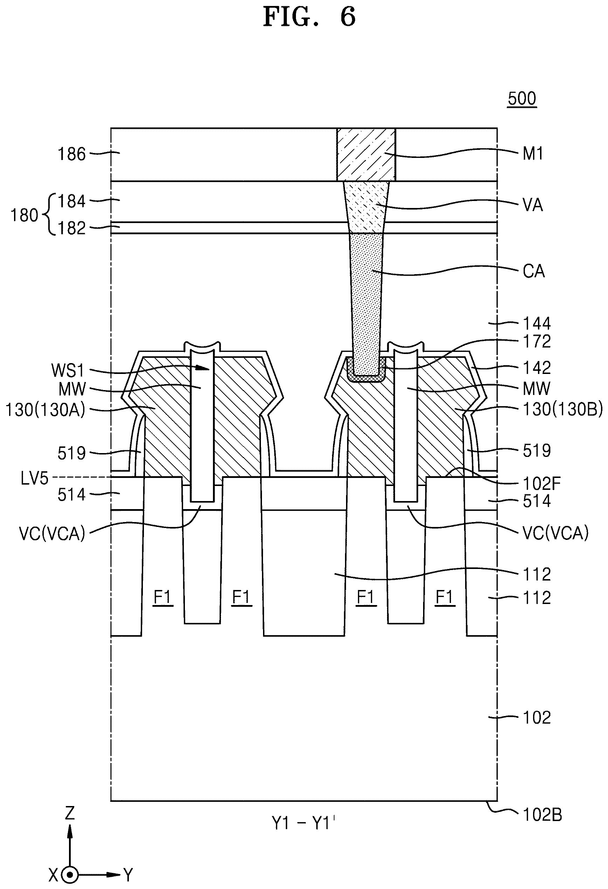

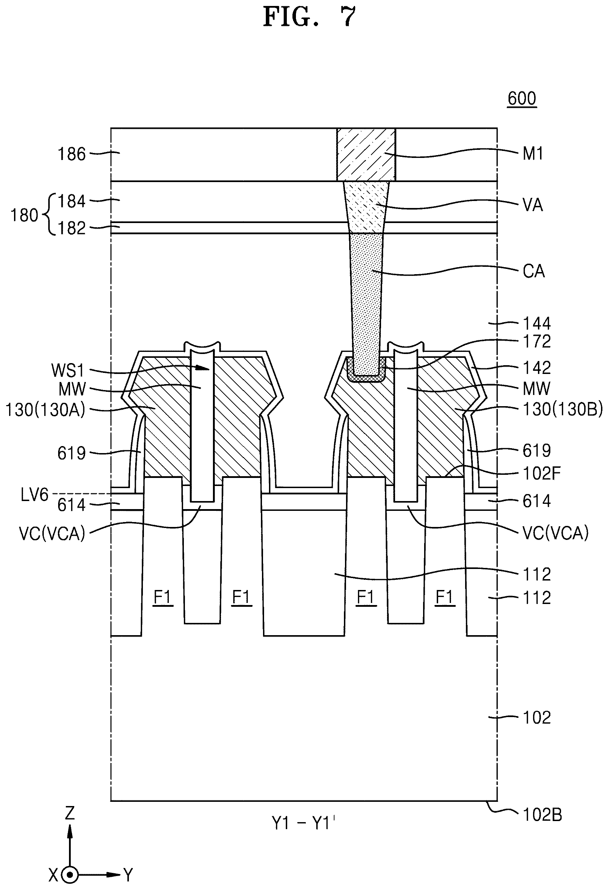

FIG. 6 and 7 are cross-sectional views respectively illustrating integrated circuit devices 500 and 600 according to some embodiments. FIGS. 6 and 7 respectively illustrate cross-sectional configurations of portions of the integrated circuit devices 500 and 600, the portions corresponding to the cross-section taken along the line Y1-Y1' of FIG. 1. In FIGS. 6 and 7, the same reference numerals as in FIGS. 1 and 2A to 2E respectively denote the same members, and here, repeated descriptions thereof are omitted.

Referring to FIG. 6, the integrated circuit device 500 has substantially the same configuration as the integrated circuit device 100 described with reference to FIGS. 1 and 2A to 2E . However, the integrated circuit device 500 further includes a plurality of isolation insulating patterns 514, which are each adjacent to the source/drain region 130 in the second horizontal direction (the Y direction) and are respectively and integrally connected to portions of the plurality of first isolation insulating patterns 114 (see FIG. 2C).

In the integrated circuit device 500, the plurality of isolation insulating patterns 514 may be arranged in a straight line with a portion of the insulating wall structure WS1, which is between a pair of source/drain regions 130, the straight line following the second horizontal direction (the Y direction). The lower surfaces of the plurality of isolation insulating patterns 514 may be respectively in contact with local upper surfaces of the device isolation film 112. Herein, each of the plurality of isolation insulating patterns 514 may be referred to as a second isolation insulating pattern. Each of the plurality of isolation insulating patterns 514 may be in contact with the upper sidewall of the fin-type active region F1 adjacent thereto. The adjacent fin-type active region F1 may be one selected from a pair of fin-type active regions F1, which are spaced apart from one another with one insulating wall structure WS1 therebetween and contact the one insulating wall structure WS1. Each of the plurality of isolation insulating patterns 514 may face the first cladding portion VCA of the insulating wall structure WS1 in the second horizontal direction (the Y direction) with one fin-type active region F1 adjacent to each isolation insulating pattern 514 therebetween. The device isolation film 112 may be spaced apart from the insulating liner 142 and the inter-gate dielectric 144 in the vertical direction (the Z direction) with the isolation insulating pattern 514 therebetween. A vertical level LV5 of the upper surface of each of the plurality of isolation insulating patterns 514 may be equal or similar to the vertical level of the frontside surface 102F corresponding to the upper surface of each of the plurality of fin-type active regions F1.

A side insulating spacer 519, which covers the sidewall of the source/drain region 130, may be arranged on the isolation insulating pattern 514. A more detailed configuration of the side insulating spacer 519 is substantially the same as that of the side insulating spacer 119 described with reference to FIGS. 2B and 2D.

Referring to FIG. 7, the integrated circuit device 600 has substantially the same configuration as the integrated circuit device 100 described with reference to FIGS. 1 and 2A to 2E . However, the integrated circuit device 600 further includes a plurality of isolation insulating patterns 614, which are respectively adjacent to the plurality of source/drain regions 130 in the second horizontal direction (the Y direction) and respectively and integrally connected to portions of the plurality of first isolation insulating patterns 114 (see FIG. 2C).

In the integrated circuit device 600, the plurality of isolation insulating patterns 614 may be arranged in a straight line with a portion of the insulating wall structure WS1, which are arranged between a pair of source/drain regions 130, the straight line following the second horizontal direction (the Y direction). The lower surfaces of the plurality of isolation insulating patterns 614 may be respectively in contact with local upper surfaces of the device isolation film 112. Herein, each of the plurality of isolation insulating patterns 614 may be referred to as a second isolation insulating pattern. Each of the plurality of isolation insulating patterns 614 may be in contact with the upper sidewall of the fin-type active region F1 adjacent thereto. The adjacent fin-type active region F1 may be one selected from a pair of fin-type active regions F1, which are spaced apart from one another with one insulating wall structure WS1 therebetween and contact the one insulating wall structure WS1. Each of the plurality of isolation insulating patterns 614 may face the first cladding portion VCA of the insulating wall structure WS1 in the second horizontal direction (the Y direction) with one fin-type active region F1 adjacent to each isolation insulating pattern 614 therebetween. The device isolation film 112 may be spaced apart from the insulating liner 142 and the inter-gate dielectric 144 in the vertical direction (the Z direction) with the isolation insulating pattern 614 therebetween. A vertical level LV6 of the upper surface of each of the plurality of isolation insulating patterns 614 may be lower than the vertical level of the frontside surface 102F corresponding to the upper surface of each of the plurality of fin-type active regions F1.

A side insulating spacer 619, which covers the sidewall of the source/drain region 130, may be arranged on the isolation insulating pattern 614. A more detailed configuration of the side insulating spacer 619 is substantially the same as that of the side insulating spacer 119 described with reference to FIGS. 2B and 2D.

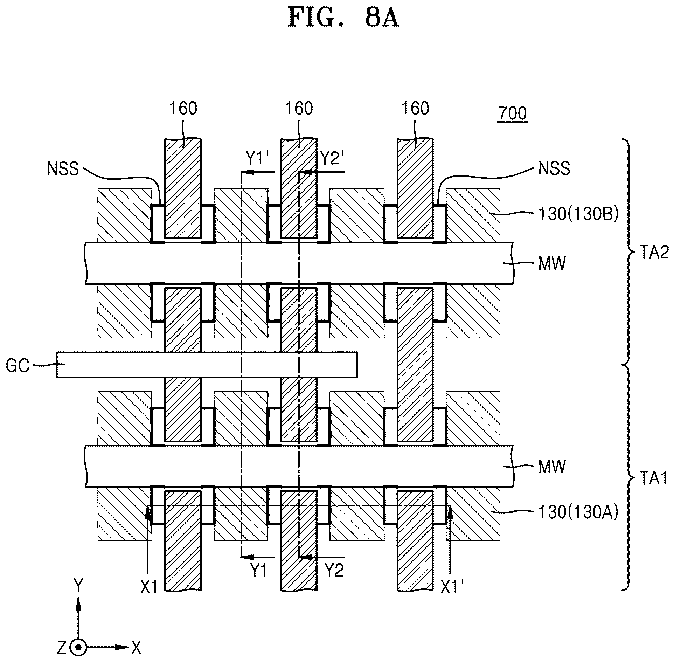

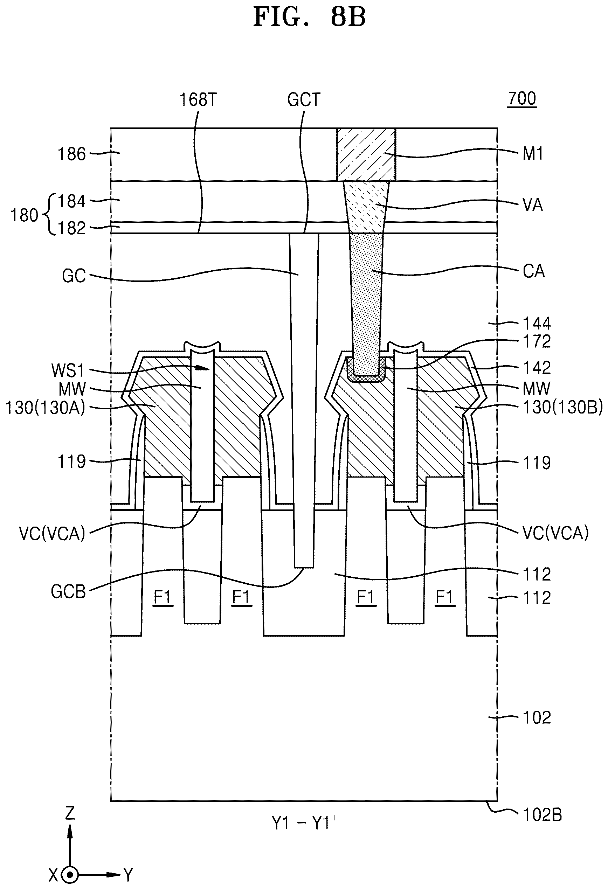

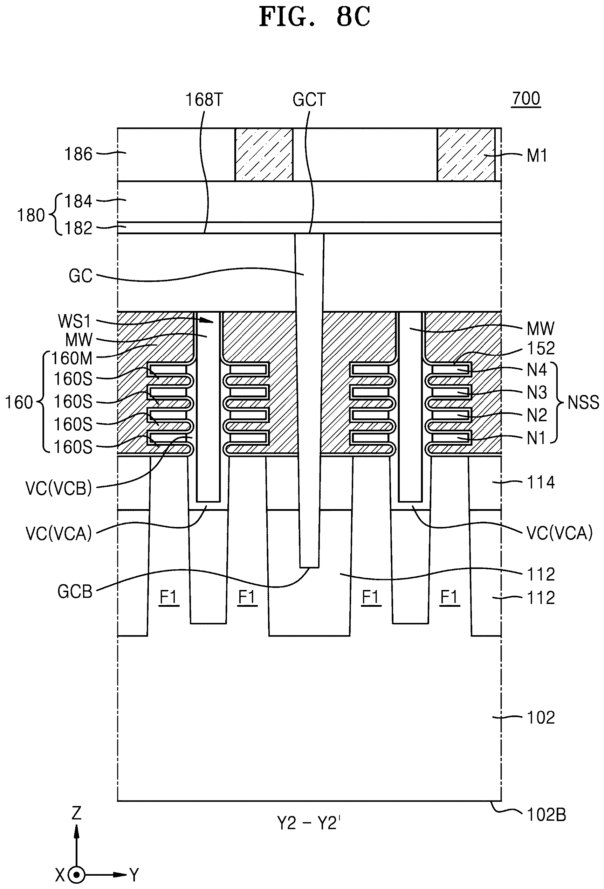

FIGS. 8A, 8B, and 8C are diagrams illustrating an integrated circuit device 700 according to some embodiments. In particular, FIG. 8A is a planar layout illustrating the integrated circuit device 700, FIG. 8B is a cross-sectional view of the integrated circuit device 700, taken along a line Y1-Y1' of FIG. 8A, and FIG. 8C is a cross-sectional view of the integrated circuit device 700, taken along a line Y2-Y2' of FIG. 8A. In FIGS. 8A, 8B, and 8C, the same reference numerals as in FIGS. 1 and 2A to 2E respectively denote the same members, and here, repeated descriptions thereof are omitted.

Referring to FIGS. 8A, 8B, and 8C, the integrated circuit device 700 has substantially the same configuration as the integrated circuit device 100 described with reference to FIGS. 1 and 2A to 2E. However, the integrated circuit device 700 may include a gate cut insulating pattern GC that defines the lengths, in the second horizontal direction (the Y direction), of some gate lines 160 selected from the plurality of gate lines 160. The gate cut insulating pattern GC may have a shape that faces ends of a plurality of gate lines 160 corresponding thereto in the second horizontal direction (the Y direction) and extends lengthwise in the first horizontal direction (the X direction). The gate cut insulating pattern GC may pass through a portion of the device isolation film 112 in the vertical direction (the Z direction). A lowermost surface GCB, which is closest to the backside surface 102B of the substrate 102, of the gate cut insulating pattern GC may be in contact with the device isolation film 112. An upper surface GCT of the gate cut insulating pattern GC may be coplanar with an upper surface 168T of the capping insulating pattern 168. The gate cut insulating pattern GC may include, but is not limited to, silicon nitride, SiCN, SiOCN, silicon oxide, or a combination thereof.

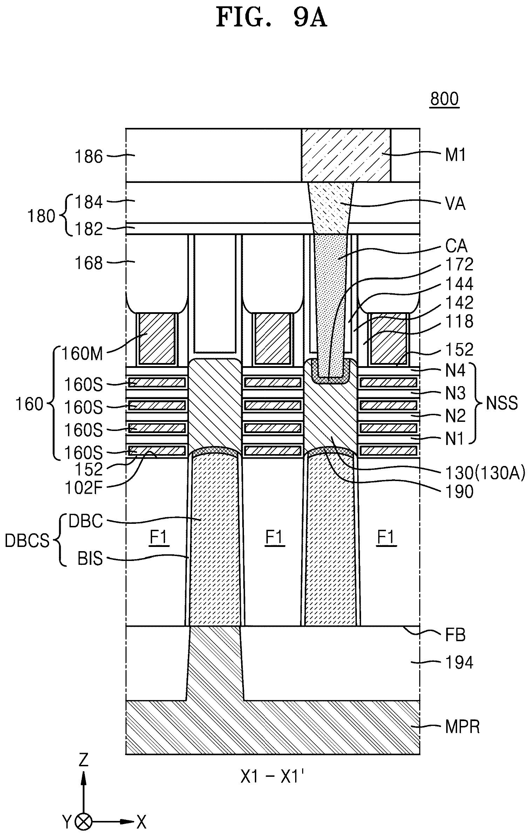

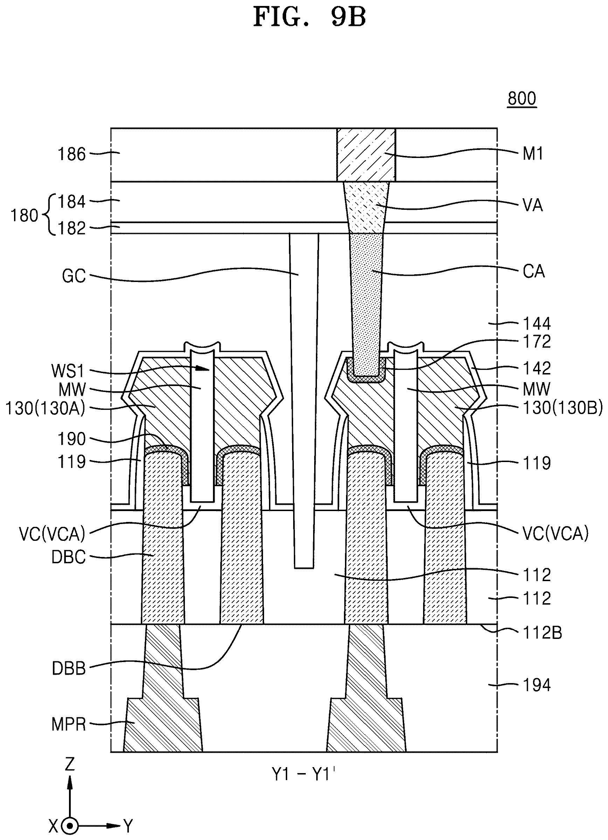

FIGS. 9A and 9B are cross-sectional views illustrating an integrated circuit device 800 according to some embodiments. FIG. 9A illustrates a cross-sectional configuration of a portion of the integrated circuit device 800, which corresponds to the cross-section taken along the line X1-X1' of FIG. 8A, and FIG. 9B illustrates a cross-sectional configuration of a portion of the integrated circuit device 800, which corresponds to the cross-section taken along the line Y1-Y1' of FIG. 8A. In FIGS. 9A and 9B, the same reference numerals as in FIGS. 1, 2A to 2E , and FIGS. 8A to 8C respectively denote the same members, and here, repeated descriptions thereof are omitted.

Referring to FIGS. 9A and 9B, the integrated circuit device 800 has a partially similar configuration to that of the integrated circuit device 700 described with reference to FIGS. 8A to 8C. However, the integrated circuit device 800 may include a plurality of backside contact structures DBCS and a plurality of backside wiring structures MPR connected to the plurality of backside contact structures DBCS.

Each of the plurality of backside contact structures DBCS may include a backside contact DBC and a backside insulating spacer BIS. The backside insulating spacer BIS may be arranged between the backside contact DBC and the fin-type active region F1 closest to the backside contact DBC. The backside contact DBC may be spaced apart from the fin-type active region F1 with the backside insulating spacer BIS therebetween. Each of a plurality of backside contacts DBC may be connected to a source/drain region 130, which is selected from the plurality of source/drain regions 130, via a metal silicide film 190. Each of the plurality of backside contact structures DBCS may extend in the vertical direction (the Z direction) from the metal silicide film 190 toward a backside surface FB of the fin-type active region F1, the metal silicide film 190 being in contact with the source/drain region 130. The metal silicide film 190 may be arranged between the source/drain region 130 and the backside contact DBC and may be in contact with each of the source/drain region 130 and the backside contact DBC. As shown in FIG. 9A, the backside contact structure DBCS may be arranged between a pair of fin-type active regions F1 that are adjacent to one another in the first horizontal direction (the X direction) from among the plurality of fin-type active regions F1. A constituent material of the metal silicide film 190 is the same as that of the metal silicide film 172 described with reference to FIGS. 2A and 2B. In some embodiments, the backside contact DBC may include only a metal plug including a single metal. In some embodiments, the backside contact DBC may include a metal plug and a conductive barrier film surrounding the metal plug. The metal plug may include, but is not limited to, Mo, W, Co, Ru, Mn, Ti, Ta, Al, Cu, a combination thereof, or an alloy thereof. The conductive barrier film may include a metal or a conductive metal nitride. For example, the conductive barrier film may include, but is not limited to, Ti, Ta, W, TiN, TaN, WN, WCN, TiSiN, TaSiN, WSiN, or a combination thereof.

Each of the plurality of backside contacts DBC may be configured to be connected to an opposite surface to a surface, which faces the inter-gate dielectric 144, of the source/drain region 130 selected from the plurality of source/drain regions 130.

As shown in FIG. 9B, in the second horizontal direction (the Y direction), the device isolation film 112 may cover both sidewalls of the backside contact DBC. The backside surface 112B, which is closest to the backside surface FB of the fin-type active region F1, of the device isolation film 112, a backside surface DBB of the backside contact DBC, and the backside surface FB of the fin-type active region F1 may be coplanar with one another.

The integrated circuit device 800 may include a backside insulating film 194, which covers the backside surface FB of each of the plurality of fin-type active regions F1, and a plurality of backside wiring structures MPR passing through the backside insulating film 194 in the vertical direction (the Z direction). Some of the plurality of backside wiring structures MPR may each be connected to the backside contact DBC. In some embodiments, a constituent material of the backside insulating film 194 is substantially the same as the constituent material of the upper insulating film 184 described above. A constituent material of each of the plurality of backside wiring structures MPR is substantially the same as the constituent material of each of the plurality of upper wiring layers M1 described above.

The integrated circuit device 800 described with reference to FIGS. 9A and 9B may provide a wiring structure having a stable and optimized structure even in an area reduced due to down-scaling, and thus, the degree of integration and the reliability of the integrated circuit device 800 may improve.

FIGS. 10A to 32B are cross-sectional views respectively illustrating a sequence of processes of a method of fabricating an integrated circuit device, according to some embodiments. More specifically, FIGS. 10A, 11A, 22A, 23A, 24A, 28A, 30A, 31A, and 32A are cross-sectional views respectively illustrating cross-sectional structures of a region corresponding to the cross-section taken along the line X1-X1' of FIG. 1, according to the sequence of processes. FIGS. 10B, 11B, 12, 13, 14, 15, 16, 17, 18, 19, 20, 21, 22B, 23B, 24B, 25A, 26A, 27A, 28B, 29, and 30B are cross-sectional views respectively illustrating cross-sectional structures of a region corresponding to the cross-section taken along the line Y2-Y2' of FIG. 1, according to the sequence of processes. FIGS. 22C, 30C, 31B, and 32B are cross-sectional views respectively illustrating cross-sectional structures of a region corresponding to the cross-section taken along the line Y2-Y2' of FIG. 1, according to the sequence of processes. FIGS. 24C, 25B, 26B, 27B, and 28C are plan views of some components in a region corresponding to the region EX1 of FIG. 1, according to the sequence of processes. An example of a method of fabricating the integrated circuit device 100 described with reference to FIGS. 1 and 2A to 2E is described with reference to FIGS. 10A to 32B. In FIGS. 10A to 32B, the same reference numerals as in FIGS. 1 and 2A to 2E respectively denote the same members, and here, repeated descriptions thereof are omitted.

Referring to 10A and 10B, the substrate 102 having a frontside surface 102F and a backside surface 102B, which are opposite to one another, may be prepared, followed by forming, on the frontside surface 102F of the substrate 102, a stack structure in which a plurality of sacrificial semiconductor layers 104 and a plurality of nanosheet semiconductor layers NS are alternately stacked one-by-one, and then, a dummy layer DL may be formed on the stack structure.

In the stack structure, each of the plurality of sacrificial semiconductor layers 104 and each of the plurality of nanosheet semiconductor layers NS may respectively include semiconductor materials having different etch selectivities. In some embodiments, each of the plurality of nanosheet semiconductor layers NS may include a Si layer, and each of the plurality of sacrificial semiconductor layers 104 may include a SiGe layer. The SiGe layer constituting a sacrificial semiconductor layer 104 may have a constant Ge content ratio selected from a range of about 5 at% to about 35 at%, for example, about 10 at% to about 35 at%.

In some embodiments, the dummy layer DL may include a silicon nitride film or a SiGe film. When the dummy layer DL includes a SiGe layer, the Ge content ratio in the SiGe layer constituting the dummy layer DL may be greater than the Ge content ratio in the SiGe layer constituting the sacrificial semiconductor layer 104. For example, the Ge content ratio in the SiGe layer constituting the dummy layer DL may be selected from a range of about 35 at% to about 40 at%. The thickness of the dummy layer DL in the vertical direction (the Z direction) may be about 10 nm to about 40 nm.

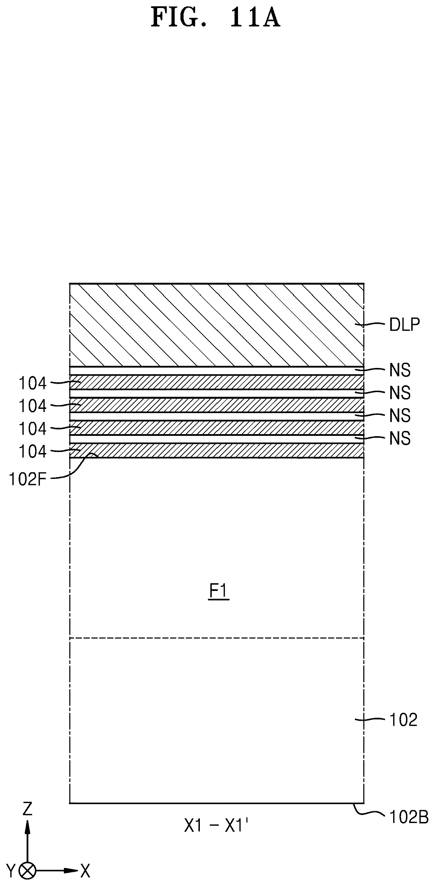

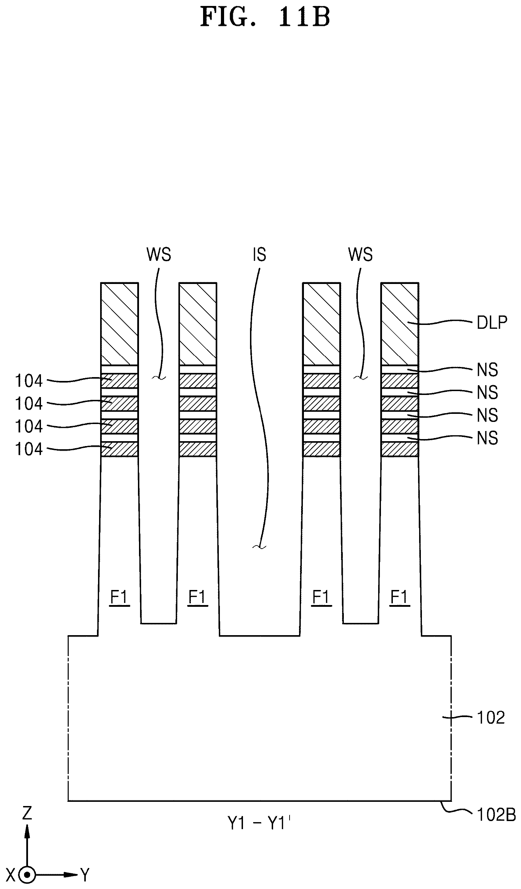

Referring to FIGS. 11A and 11B, in the resulting product of FIGS. 10A and 10B, a dummy pattern DLP may be formed by patterning the dummy layer DL. The dummy pattern DLP may include portions extending in the first horizontal direction (the X direction) over the substrate 102 so as to be parallel to one another. A portion of each of the plurality of sacrificial semiconductor layers 104, the plurality of nanosheet semiconductor layers NS, and the substrate 102 may be etched by using the dummy pattern DLP as an etch mask, thereby forming a plurality of fin-type active regions F1, which protrude upwards in the vertical direction (the Z direction) from the substrate 102. A plurality of wall spaces WS for forming the insulating wall structure WS1 (see FIG. 1) and a plurality of device isolation spaces IS for forming the device isolation film 112 (see FIGS. 2B and 2C) may be respectively provided between the plurality of fin-type active regions F1. The depth of each of the plurality of device isolation spaces IS may vary according to the distance between a pair of fin-type active regions F1 defining a device isolation space IS, among the plurality of fin-type active regions F1.

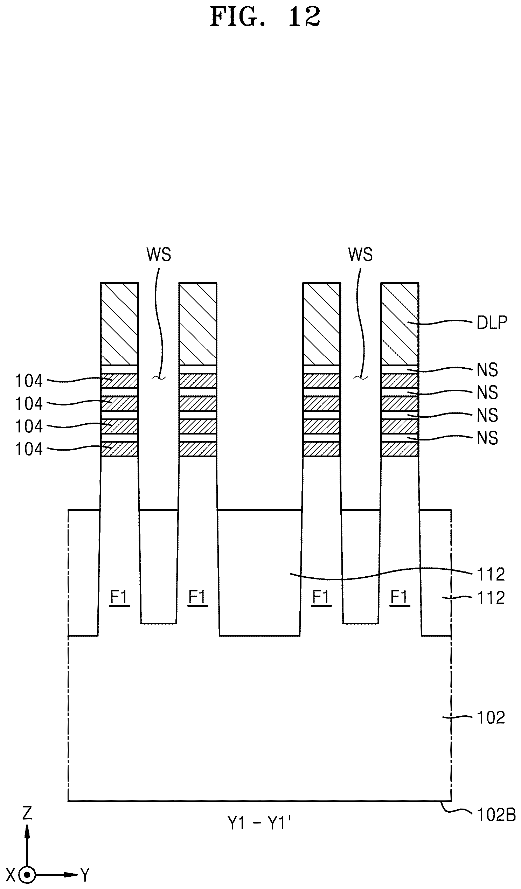

Referring to FIG. 12, in the resulting product of FIGS. 11A and 11B, the device isolation film 112 may be formed to fill the plurality of device isolation spaces IS. The device isolation film 112 may be formed in the device isolation space IS to cover a lower sidewall of each of the fin-type active regions F1. To form the device isolation film 112, an insulating film may be formed on the resulting product of FIGS. 11A and 11B to have a thickness sufficient to fill the plurality of device isolation spaces IS, followed by performing a recess process for removing a portion of the insulating film, thereby forming the device isolation film 112, which includes a remaining portion of the insulating film.

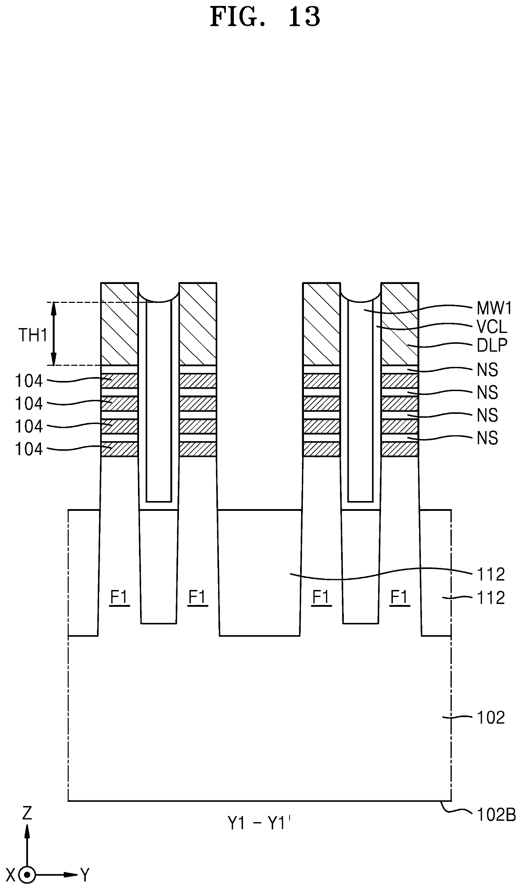

Referring to FIG. 13, a cladding layer VCL and a main insulating layer MW1 may be sequentially formed in the stated order on the entire surface of the resulting product of FIG. 12, and then, a portion of each of the cladding layer VCL and the main insulating layer MW1 may be removed such that the cladding layer VCL and the main insulating layer MW1 remain in only an area in which a plurality of insulating wall structures WS1 (see FIG. 1) are to be formed.

To form the cladding layer VCL and the main insulating layer MW1, an atomic layer deposition (ALD) process, a chemical vapor deposition (CVD) process, or a combination thereof may be used. In some embodiments, on the sidewall of each of the plurality of sacrificial semiconductor layers 104 and the plurality of nanosheet semiconductor layers NS, the cladding layer VCL may have a thickness of about 2 nm to about 10 nm in the second horizontal direction (the Y direction), and the main insulating layer MW1 may have a thickness of about 5 nm to about 15 nm in the second horizontal direction (the Y direction). A vertical-direction thickness TH1 from the upper surface of the uppermost nanosheet semiconductor layer NS from among the plurality of nanosheet semiconductor layers NS to the lowest portion of the upper surface of the main insulating layer MW1 may be, but is not limited to, about 5 nm to about 35 nm.

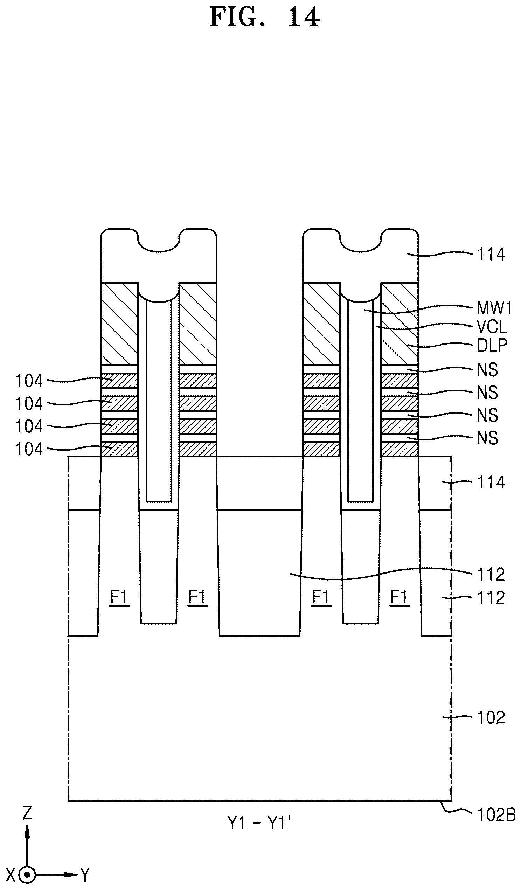

Referring to FIG. 14, in the resulting product of FIG. 13, an isolation insulating pattern 114 may be formed to cover only surfaces facing upwards in the vertical direction (the Z direction) from among exposed surfaces. In some embodiments, to form the isolation insulating pattern 114, a bottom-up type deposition process, by which an intended material is chemically deposited selectively on only an intended area, may be used.

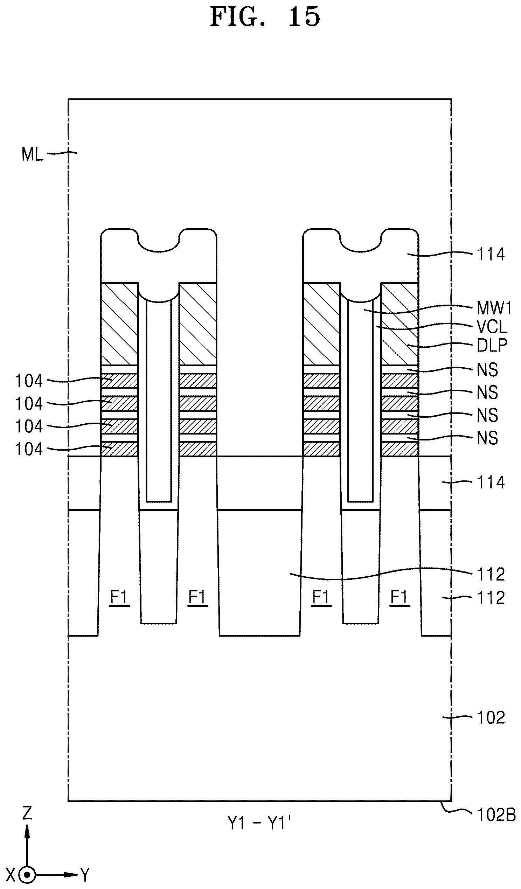

Referring to FIG. 15, a mask layer ML may be formed to cover the resulting product of FIG. 14. In some embodiments, the mask layer ML may include a spin-on hardmask (SOH) layer.

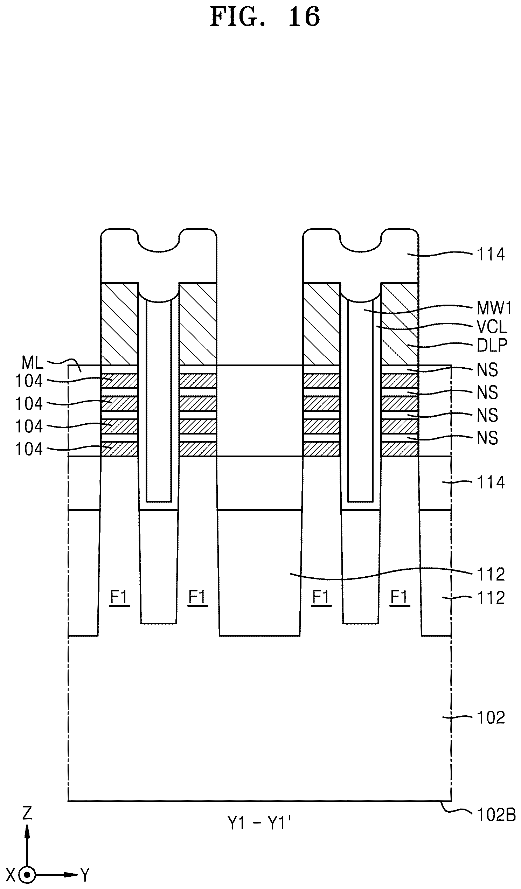

Referring to FIG. 16, a portion of the mask layer ML may be removed from the resulting product of FIG. 15, thereby reducing the height of the mask layer ML and exposing both a portion of the isolation insulating pattern 114 and the dummy pattern DLP above the mask layer ML.

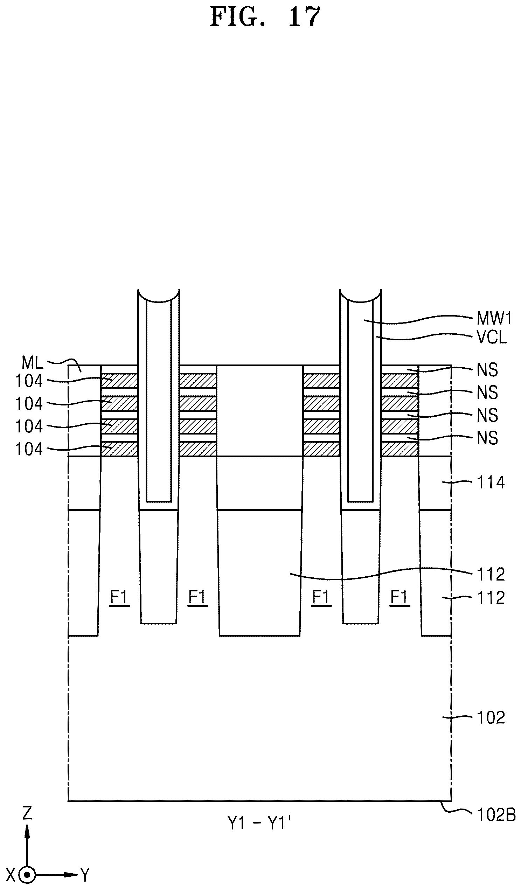

Referring to FIG. 17, in the resulting product of FIG. 16, the isolation insulating pattern 114 and the dummy pattern DLP, which are exposed, may be removed, thereby exposing the upper surface and the sidewall of the cladding layer VCL.

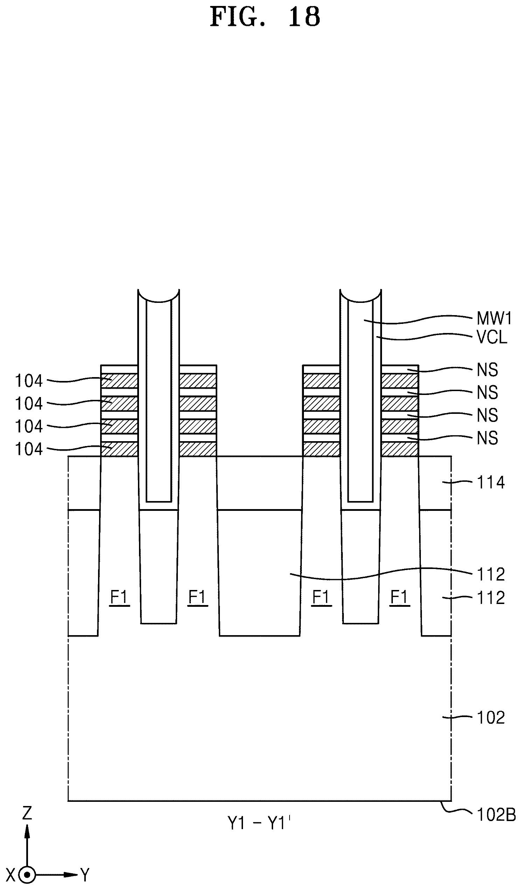

Referring to FIG. 18, the mask layer ML may be removed from the resulting product of FIG. 17, thereby exposing the sidewall of the stack structure and the upper surface of the isolation insulating pattern 114 that remains over the substrate 102, the stack structure including the plurality of sacrificial semiconductor layers 104 and the plurality of nanosheet semiconductor layers NS. To remove the mask layer ML, ashing and strip processes may be used.

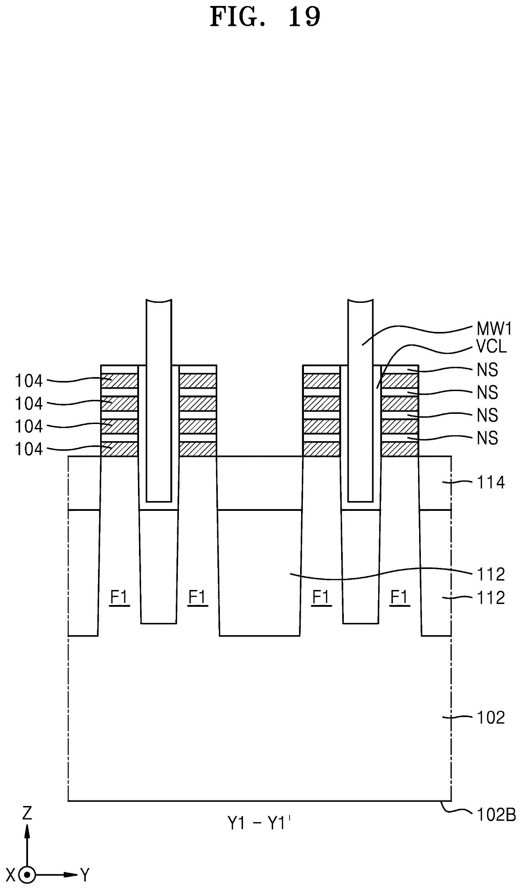

Referring to FIG. 19, an exposed portion of the cladding layer VCL may be removed from the resulting product of FIG. 18, thereby exposing the upper sidewall of the main insulating layer MW1.

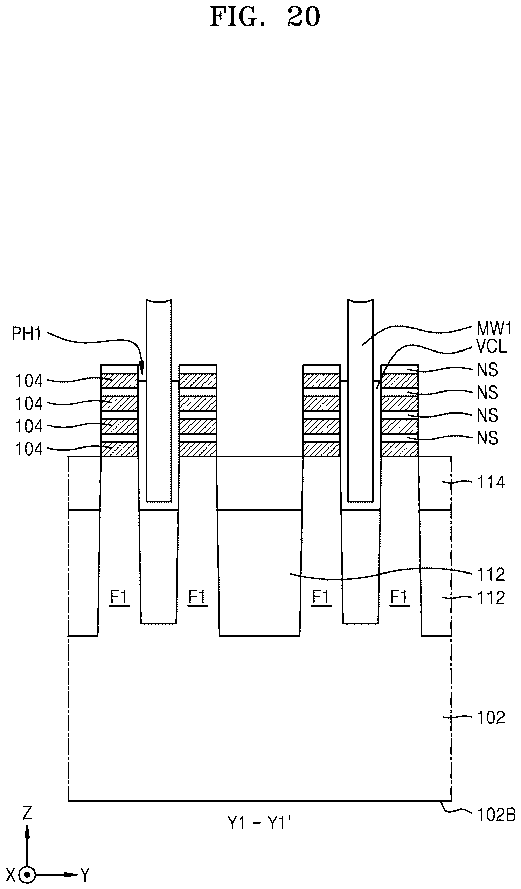

Referring to FIG. 20, in the resulting product of FIG. 19, the cladding layer VCL may be partially etched, thereby forming a partial recess space PH1 around the upper sidewall of the main insulating layer MW1. In the partial recess space PH1, at least the sidewall of the uppermost nanosheet semiconductor layer NS from among the plurality of nanosheet semiconductor layers NS may be exposed.

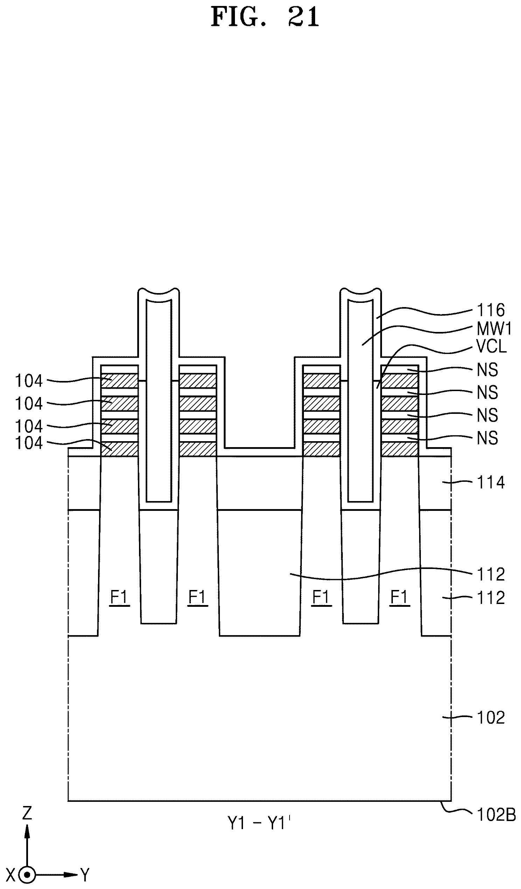

Referring to FIG. 21, in the resulting product of FIG. 20, a dummy oxide film 116 may be formed to conformally cover exposed surfaces. The dummy oxide film 116 may be formed to fill the partial recess space PH1 (see FIG. 20).

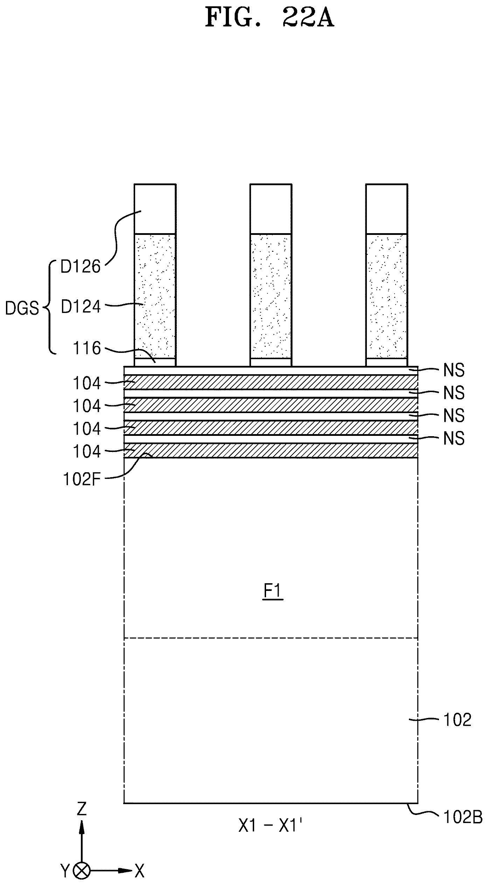

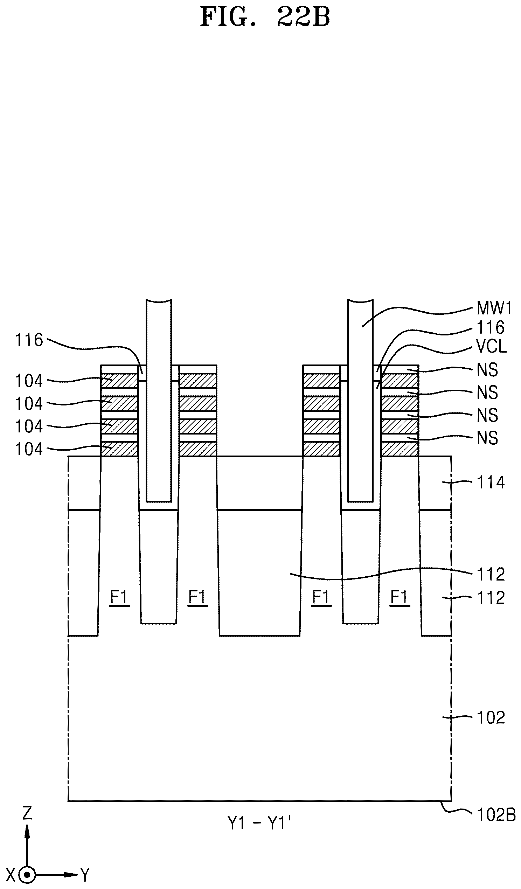

Referring to FIG. 22A, 22B, and 22C, a dummy gate layer D124 and a capping layer D126 may be formed on the resulting product of FIG. 21, followed by sequentially patterning the capping layer D126, the dummy gate layer D124, and the dummy oxide film 116 in the stated order, thereby forming a plurality of dummy gate structures DGS, which each include respective remaining portions of the dummy oxide film 116, the dummy gate layer D124, and the capping layer D126. A portion, which fills the partial recess space PH1 (see FIG. 20), of the dummy oxide film 116 may remain without being removed. Each of the plurality of dummy gate structures DGS may have a shape extending lengthwise in the second horizontal direction (the Y direction).

In some embodiments, the dummy gate layer D124 may include polysilicon, and the capping layer D126 may include a silicon nitride film. As shown in FIGS. 22A and 22B, in a space between each of the plurality of dummy gate structures DGS, the stack structure including the plurality of sacrificial semiconductor layers 104 and the plurality of nanosheet semiconductor layers NS and an upper portion of the main insulating layer MW1 may be exposed.

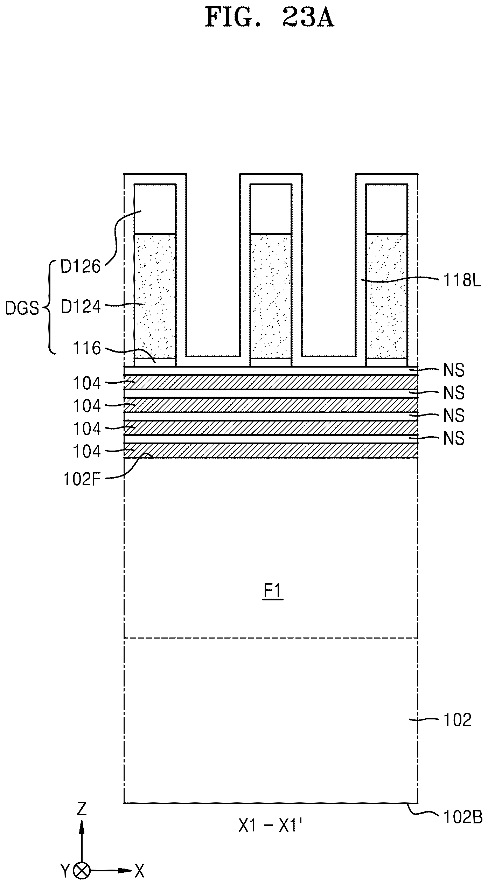

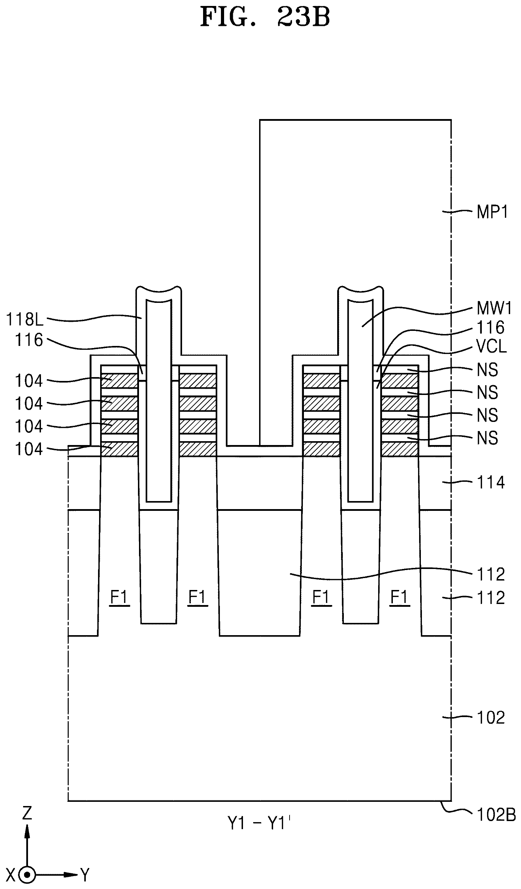

Referring to FIGS. 23A and 23B, an insulating spacer layer 118L may be formed to conformally cover exposed surfaces of the resulting product of FIGS. 22A, 22B, and 22C, and a mask pattern MP1 may be formed to selectively cover the second device area TA2 such that only the first device area TA1 out of the first device area TA1 and the second device area TA2 (see FIG. 1) is exposed. In some embodiments, the mask pattern MP1 may include, but is not limited to, an SOH pattern, an inorganic hardmask pattern, a photoresist pattern, or a combination thereof.

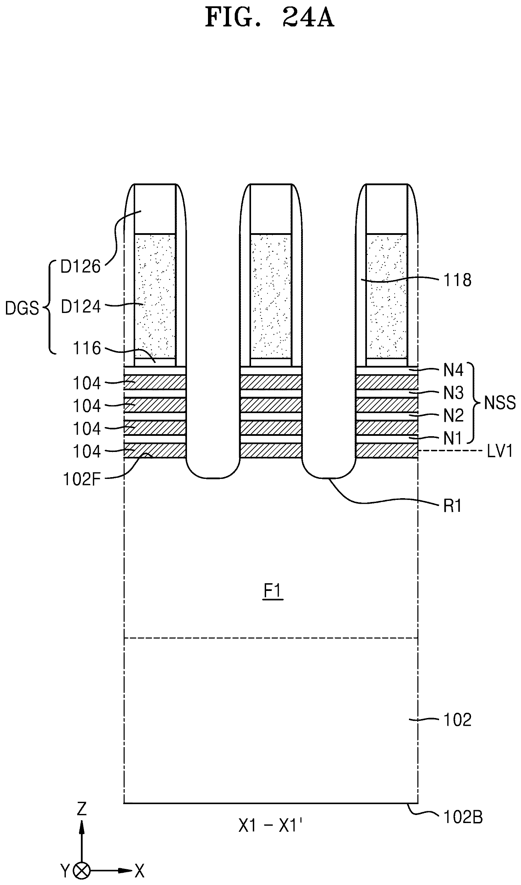

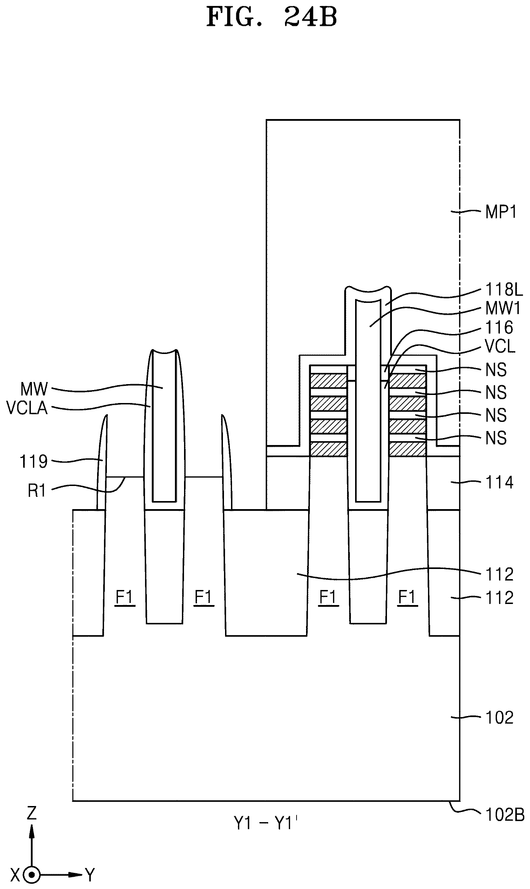

Referring to FIGS. 24A, 24B, and 24C, in the first device area TA1, which is exposed by the mask pattern MP1, of the resulting product of FIGS. 23A and 23B, a plurality of main insulating spacers 118 may be formed to respectively cover both sidewalls of each of the plurality of dummy gate structures DGS by performing etch-back on the insulating spacer layer 118L, and the plurality of sacrificial semiconductor layers 104 and the plurality of nanosheet semiconductor layers NS may each be partially etched by using the plurality of dummy gate structures DGS and the plurality of main insulating spacers 118 as an etch mask, thereby forming a plurality of nanosheet stacks NSS, which each include first to fourth nanosheets N1, N2, N3, and N4, from the plurality of nanosheet semiconductor layers NS and forming a plurality of recesses R1 in the fin-type active region F1. While the insulating spacer layer 118L is being etched-back to form the plurality of main insulating spacers 118 and the plurality of recesses R1 are being formed by partially etching each of the plurality of sacrificial semiconductor layers 104 and the plurality of nanosheet semiconductor layers NS, the isolation insulating pattern 114 in an area around the plurality of recesses R1 in second horizontal direction (the Y direction) may also be etched, as shown in FIG. 24B. As a result, a side insulating spacer 119, which includes a resulting product remaining after insulating material layers are etched-back, may be formed, the insulating material layers including a portion of the isolation insulating pattern 114 that covers the upper sidewall of the fin-type active region F1. In addition, a main insulating wall MW may be formed from the main insulating layer MW1, and a resulting product remaining after each of the cladding layer VCL, the dummy oxide film 116, and the insulating spacer layer 118L, which are insulating material films covering both sidewalls of the main insulating layer MW1, is partially etched-back may remain as a cladding spacer layer VCLA covering both sidewalls of the main insulating layer MW1.

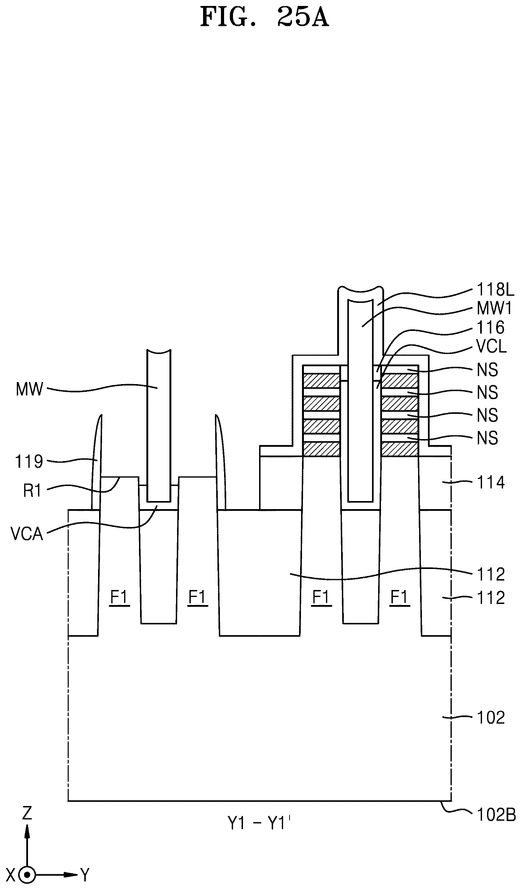

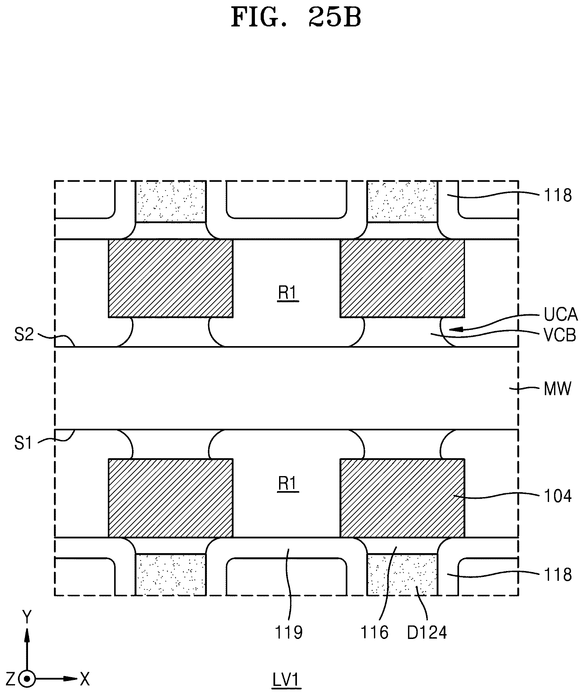

Referring to FIGS. 25A and 25B, in the first device area TA1 (see FIG. 1) of the resulting product of FIGS. 24A, 24B, and 24C, a portion of the cladding spacer layer VCLA may be removed through a recess R1, thereby forming a plurality of second cladding portions VCB from the cladding spacer layer VCLA. As a result, as shown in FIG. 25B, an undercut space UCA, which is connected to the recess R1, may be formed on both sides, in the first horizontal direction (the X direction), of each of the plurality of second cladding portions VCB.

Next, the mask pattern MP1, which covers the second device area TA2, may be removed, thereby exposing the insulating spacer layer 118L in the second device area TA2.

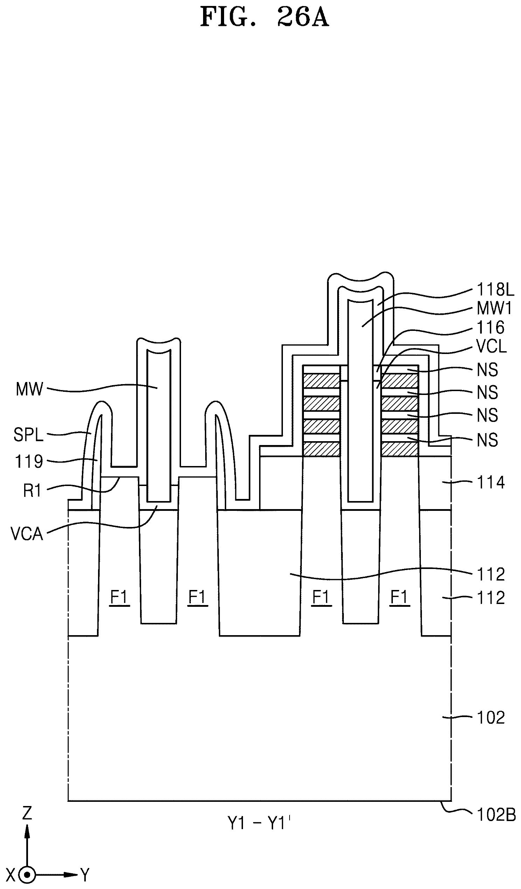

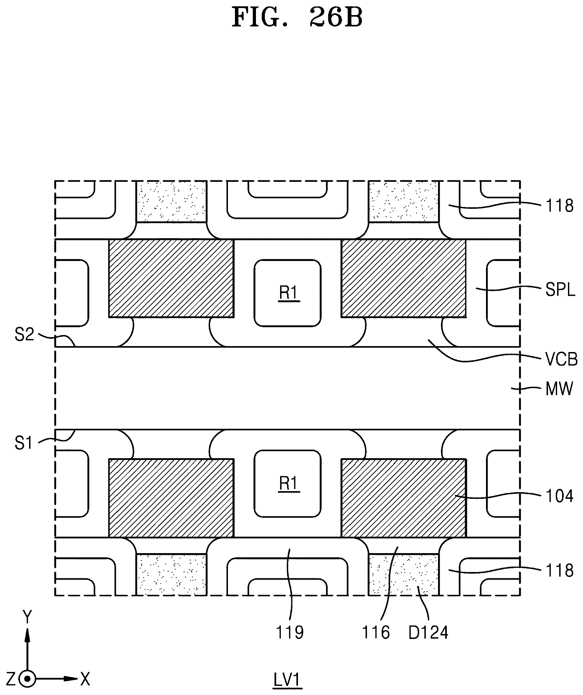

Referring to FIGS. 26A and 26B, a blocking insulating layer SPL may be formed to conformally cover the entire surface of the resulting product of FIGS. 25A and 25B. The blocking insulating layer SPL may include a nitrogen-containing insulating material, for example, silicon nitride (SiN), SiCN, SiBN, SiON, SiOCN, SiBCN, or a combination thereof. In some embodiments, the blocking insulating layer SPL may have a thickness of about 2 nm to about 4 nm, for example, about 3 nm.

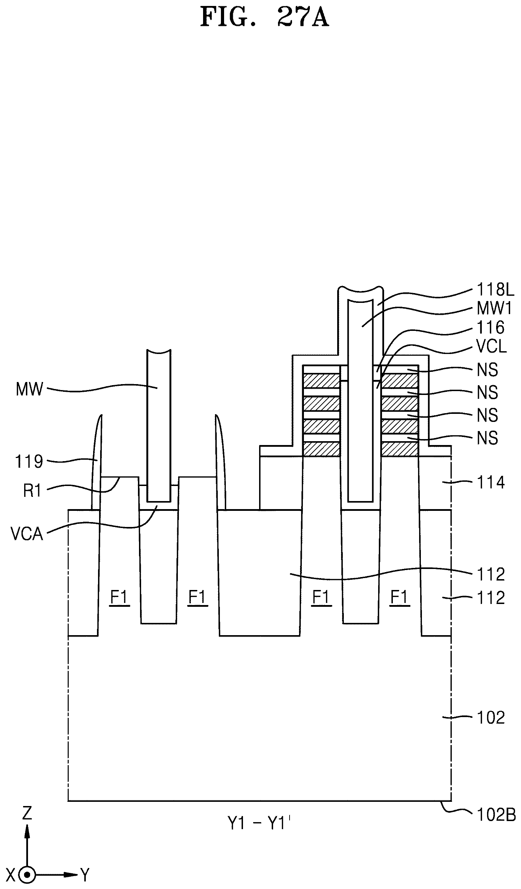

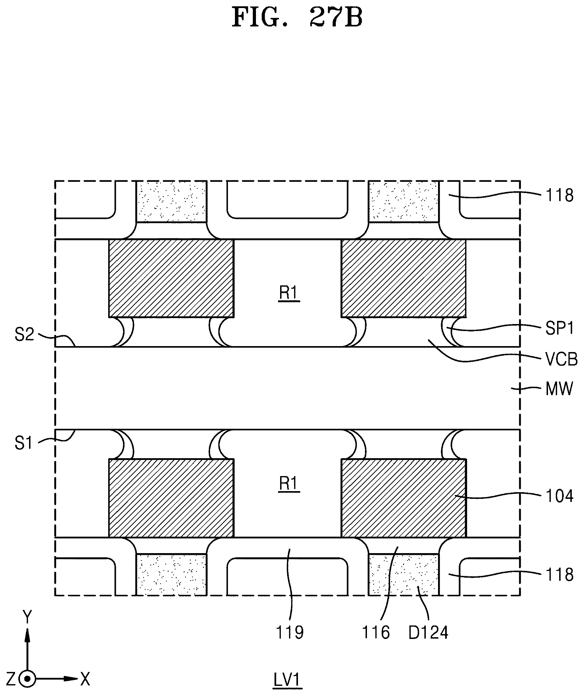

Referring to FIGS. 27A and 27B, in the resulting product of FIGS. 26A and 26B, the blocking insulating layer SPL may be etched-back, thereby forming a plurality of blocking insulating spacers SP1, which include remaining portions of the blocking insulating layer SPL. Each of the plurality of blocking insulating spacers SP1 may have a concave surface toward the recess R1.

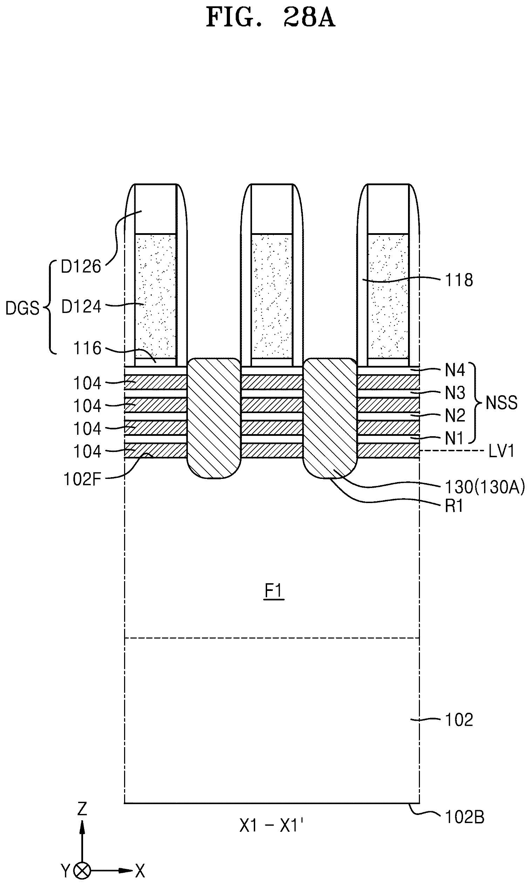

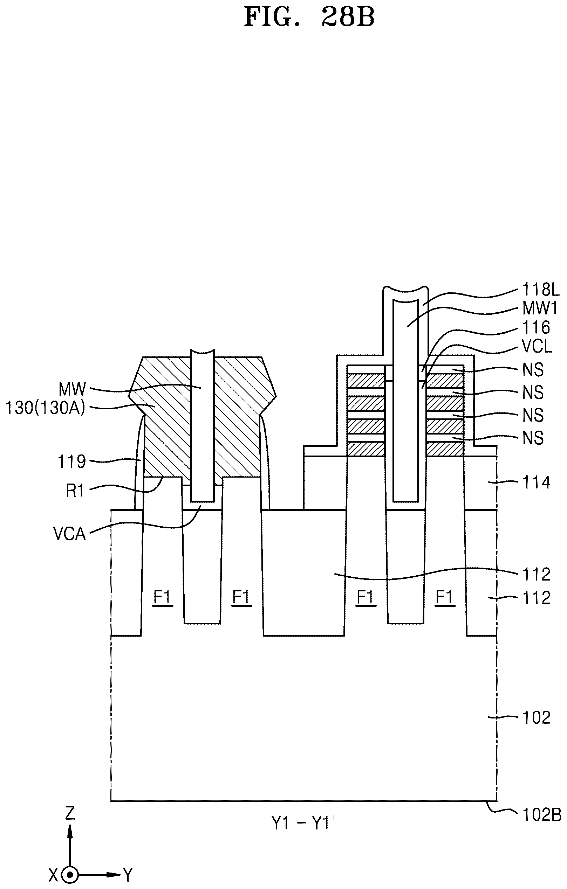

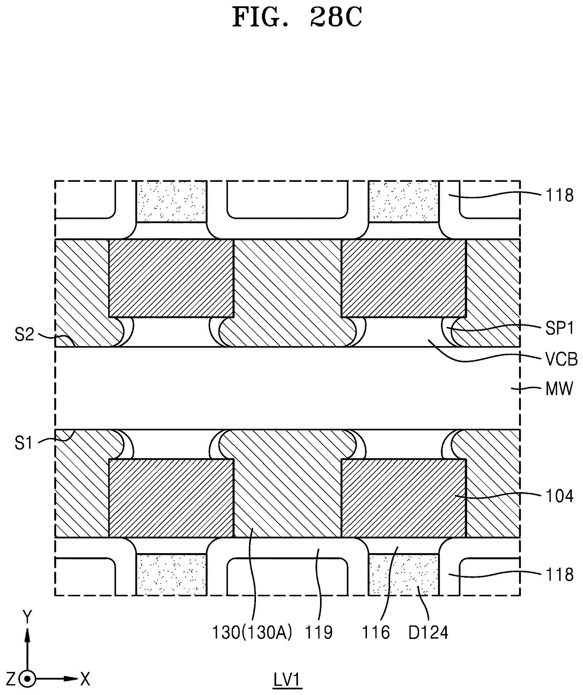

Referring to FIGS. 28A, 28B, and 28C, in the first device area TA1 of the resulting product of FIGS. 27A and 27B, a plurality of source/drain regions 130 may be formed on the plurality of fin-type active regions F1. To this end, the plurality of source/drain regions 130 may be formed to be arranged one-by-one on the fin-type active region F1, which is exposed by the recess R1 and a space that is connected to the recess R1 and defined by a pair of blocking insulating spacers SP1. To form the plurality of source/drain regions 130, a semiconductor material may be epitaxially grown on the surface of the fin-type active region F1, which is exposed by the recess R1, and on the sidewall of each of the first to fourth nanosheets N1, N2, N3, and N4.

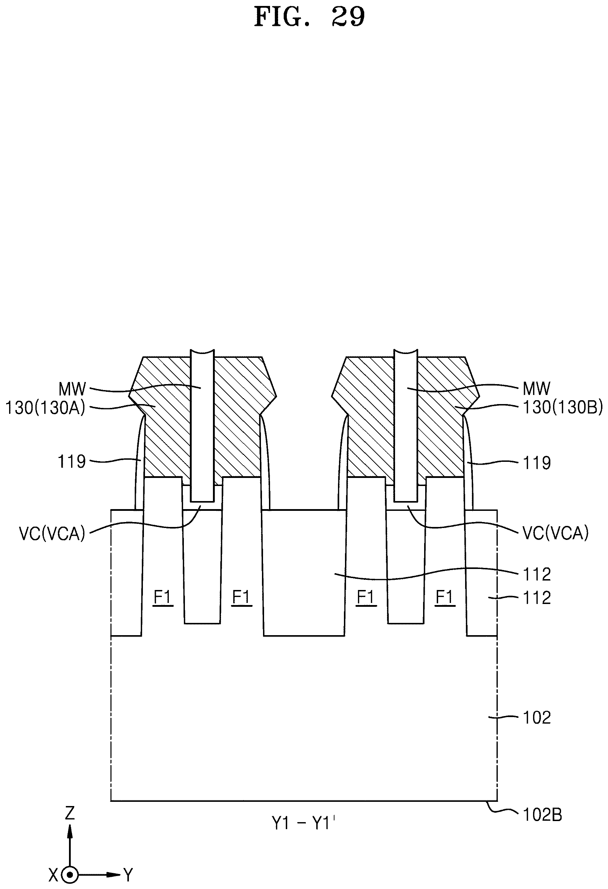

Referring to FIG. 29, similar processes to the processes described regarding the first device area TA1 with reference to FIGS. 23A to 28C may be performed on the second device area TA2 of the resulting product of FIGS. 28A, 28B, and 28C, a structure including the main insulating wall MW, the first cladding portion VCA, the plurality of main insulating spacers 118, the plurality of side insulating spacers 119, and the plurality of source/drain regions 130 may also be formed in the second device area TA2, like in the first device area TA1.

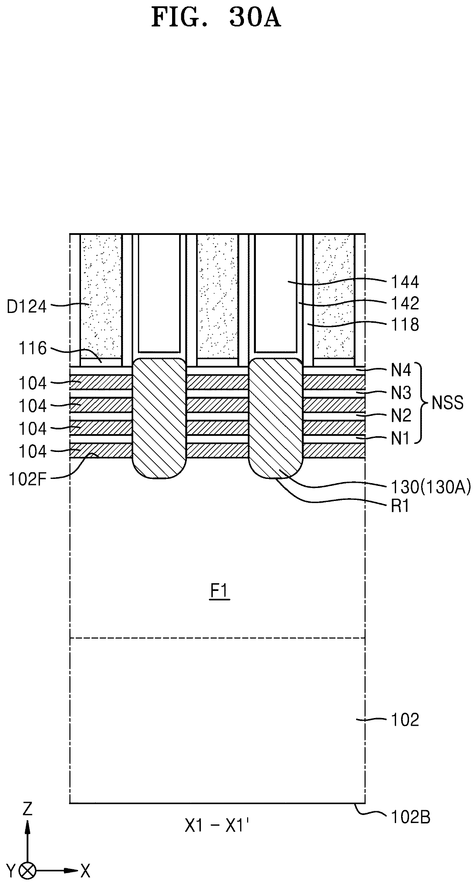

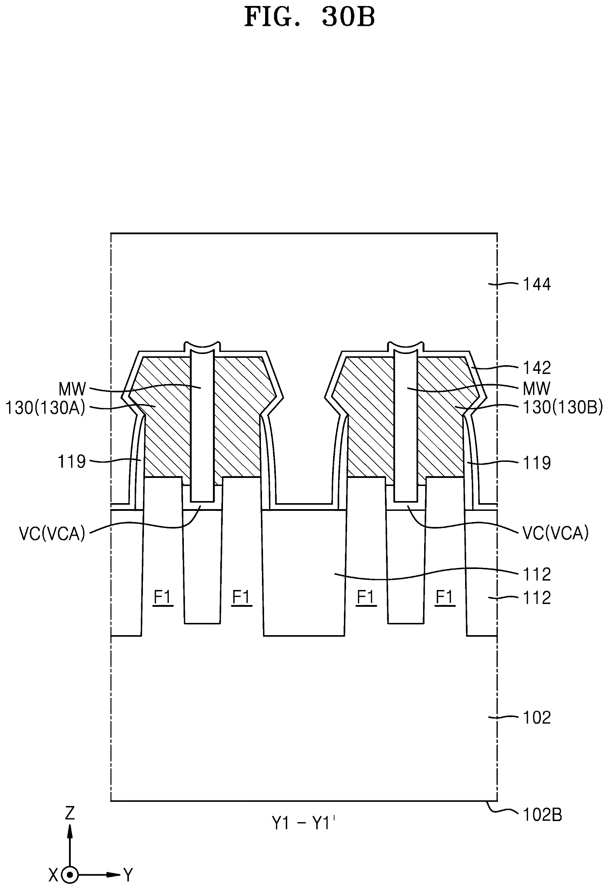

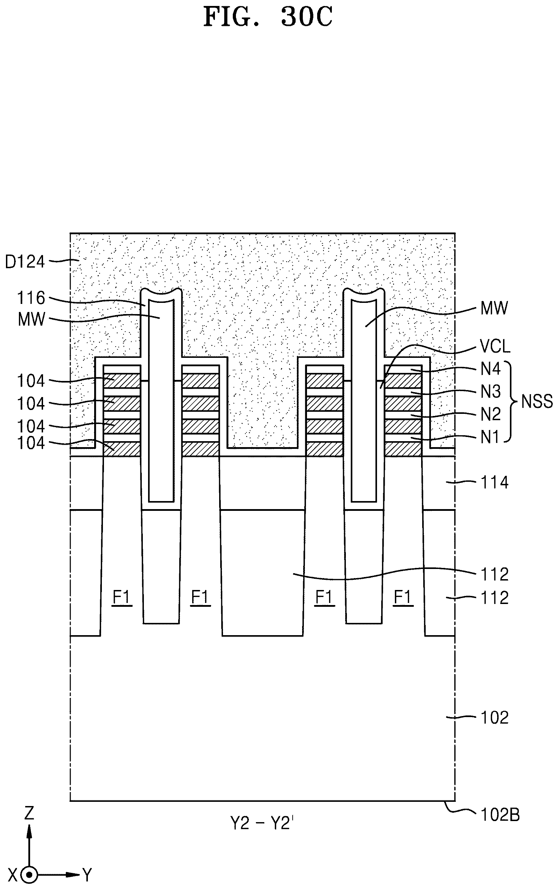

Referring to FIGS. 30A, 30B, and 30C, an insulating liner 142 may be formed to cover exposed surfaces of a resulting product having undergone the processes described with reference to FIG. 29, followed by forming an inter-gate dielectric 144 on the insulating liner 142, and then, a portion of each of the insulating liner 142 and the inter-gate dielectric 144 may be etched, thereby exposing the respective upper surfaces of the plurality of capping layers D126 (see FIG. 24A). Next, the dummy gate layer D124 may be exposed by removing the plurality of capping layers D126, and the insulating liner 142 and the inter-gate dielectric 144 may be partially removed such that the upper surface of the inter-gate dielectric 144 and the upper surface of the dummy gate layer D124 are at an approximately equal level.

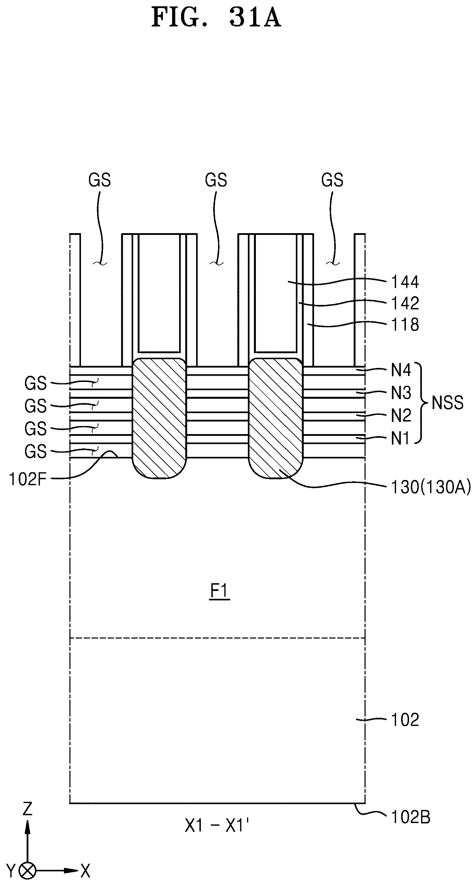

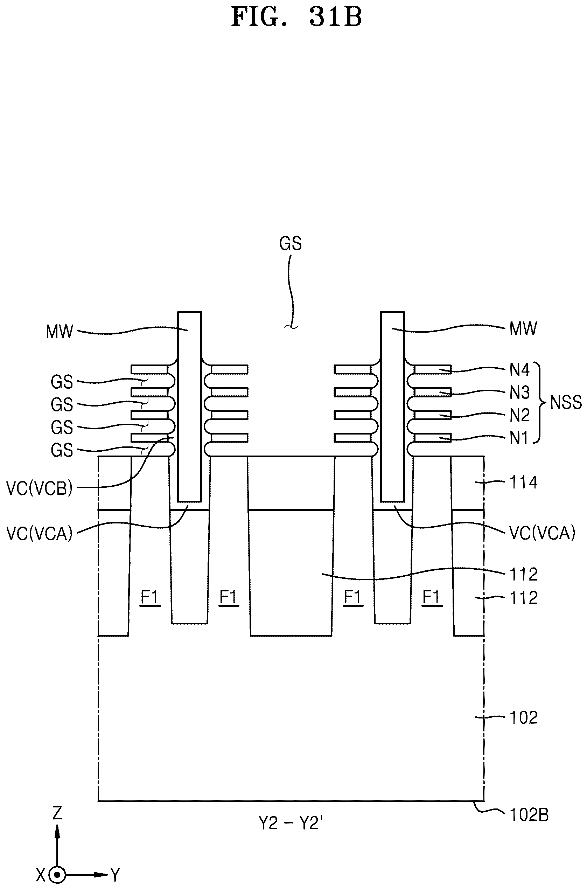

Referring to FIGS. 31A and 31B, the dummy gate layer D124 may be removed from the resulting product of FIGS. 30A, 30B, and 30C, followed by removing a portion of the dummy oxide film 116 exposed as a result, and then, the plurality of sacrificial semiconductor layers 104 remaining on the substrate 102 may be selectively removed, thereby preparing a plurality of gate spaces GS.

While the plurality of sacrificial semiconductor layers 104 are being selectively removed, a portion of each of the cladding layer VCL and the dummy oxide film 116, which are exposed due to the removal of the plurality of sacrificial semiconductor layers 104 from between each of the first to fourth nanosheets N1, N2, N3, and N4, may be consumed, and as a result, respective remaining portions of the cladding layer VCL and the dummy oxide film 116 may respectively constitute a first cladding portion VCA and a second cladding portion VCB. As the portion of each of the cladding layer VCL and the dummy oxide film 116, which are exposed due to the removal of the plurality of sacrificial semiconductor layers 104 from between each of the first to fourth nanosheets N1, N2, N3, and N4, is consumed, an uneven surface may be formed in the second cladding portion VCB to face the gate space GS.

In some embodiments, to selectively remove the plurality of sacrificial semiconductor layers 104, the difference in etch selectivity between each of the first to fourth nanosheets N1, N2, N3, and N4 and each of the plurality of sacrificial semiconductor layers 104 may be used. To selectively remove the plurality of sacrificial semiconductor layers 104, a liquid-phase or gas-phase etchant may be used. In some embodiments, to selectively remove the plurality of sacrificial semiconductor layers 104, a CH₃COOH-based etching solution, for example, an etching solution including a mixture of CH₃COOH, HNO₃, and HF, or an etching solution including a mixture of CH₃COOH, H₂O₂, and HF, may be used, but the inventive concept is not limited thereto.

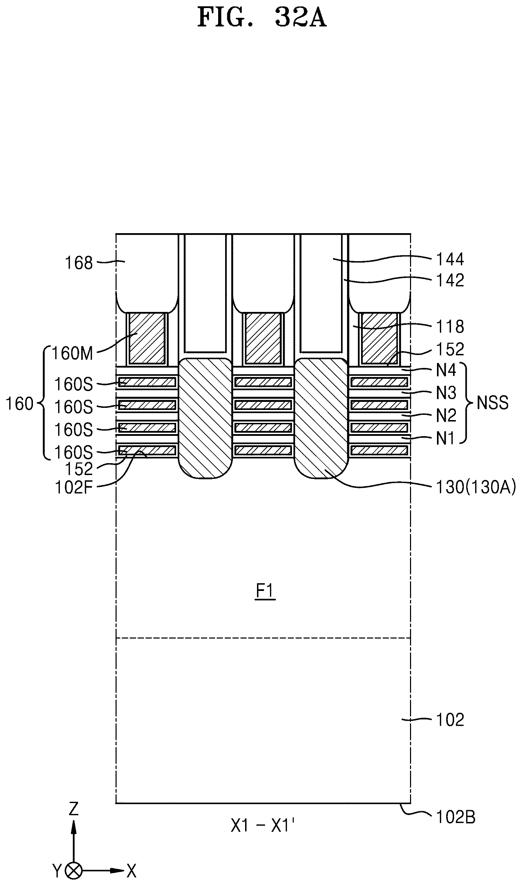

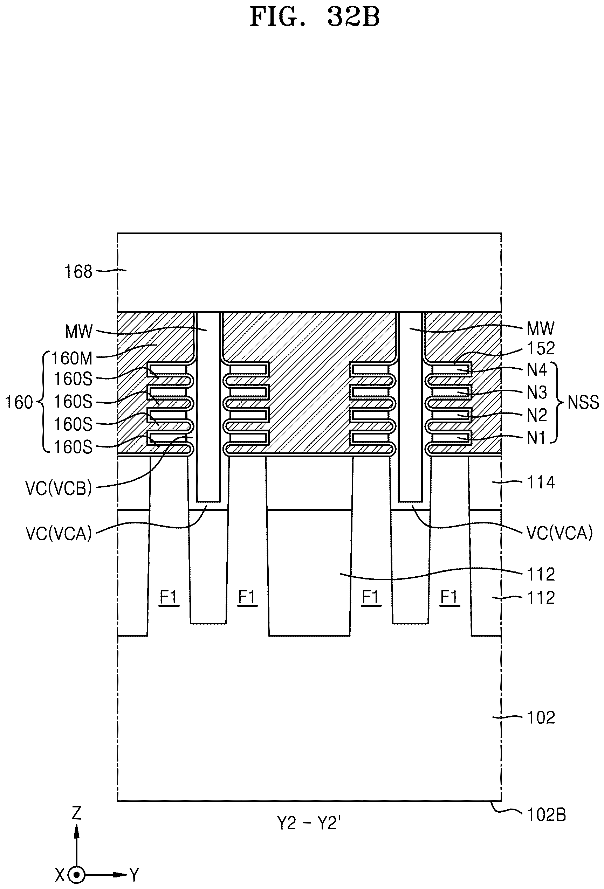

Referring to FIGS. 32A and 32B, in the resulting product of FIGS. 31A and 31B, a gate dielectric film 152 may be formed to conformally cover respective exposed surfaces of the first to fourth nanosheets N1, N2, N3, and N4 and respective exposed surfaces of the main insulating wall MW and the second cladding portion VCB. To form the gate dielectric film 152, an ALD process may be used.

Next, a gate line 160 may be formed on the gate dielectric film 152 to fill the gate space GS (see FIGS. 31A and 31B). Next, the height of each of the gate line 160, the gate dielectric film 152, the main insulating spacer 118, and the main insulating wall MW may be reduced by partially removing each thereof from the upper surface of each thereof, and a plurality of capping insulating patterns 168 may each be formed to cover the respective upper surfaces of the gate line 160, the gate dielectric film 152, and the main insulating spacer 118.

Next, as shown in FIGS. 2A and 2B, a source/drain contact hole may be formed between a pair of gate lines 160 adjacent to one another from among the plurality of gate lines 160 to expose the source/drain region 130, followed by forming a metal silicide film 172 on the surface of the source/drain region 130 through the source/drain contact hole, and then, a source/drain contact CA may be formed on the metal silicide film 172 to fill the source/drain contact hole. Next, an etch stop film 182 and an upper insulating film 184 may be formed in the stated order to cover the upper surface of each of the plurality of source/drain contacts CA, the plurality of capping insulating patterns 168, the main insulating wall MW, and the inter-gate dielectric 144, thereby forming an upper insulating structure 180. Next, a source/drain via contact VA, which passes through the upper insulating structure 180 in the vertical direction (the Z direction) and is connected to the source/drain contact CA, and a gate contact CB, which passes through the upper insulating structure 180 and the capping insulating pattern 168 in the vertical direction (the Z direction) and is connected to the gate line 160, may be formed. The source/drain via contact VA and the gate contact CB may be simultaneously formed or may be formed by separate processes from one another. Next, an interlayer dielectric 186, which covers the upper insulating structure 180, and a plurality of upper wiring layers M1, which pass through the interlayer dielectric 186, may be formed, thereby fabricating the integrated circuit device 100 described with reference to FIGS. 1 and 2A to 2E . According to the need, a frontside wiring structure may be further formed on the interlayer dielectric 186 and the plurality of upper wiring layers M1.

To fabricate the integrated circuit device 200 described with reference to FIG. 3, the processes described with reference to FIGS. 10A to 32B may be used. However, after the plurality of gate spaces GS are prepared by performing the processes described with reference to FIGS. 31A and 31B, before the process, described with reference to FIGS. 32A and 32B, of forming the gate dielectric film 152 is performed, a process of forming a plurality of first inner spacers 210 may be performed. In an example of the process of forming the plurality of first inner spacers 210, an insulating liner may be formed to conformally cover the entire surface of the resulting product of FIGS. 31A and 31B, followed by performing etch-back on the insulating liner, thereby forming the plurality of first inner spacers 210, which respectively include remaining portions of the insulating liner.

In some embodiments, while the plurality of first inner spacers 210 are being formed, the plurality of inner spacers 312 shown in FIGS. 4A, the plurality of inner spacers 312D shown in FIG. 4D, the plurality of inner spacers 312E shown in FIGS. 4E, or the plurality of inner spacers 312F shown in FIG. 4F may be formed together therewith.

In the etch-back process, described with reference to FIGS. 27A and 27B, of the blocking insulating layer SPL, the conditions of the etch-back process may be variously modified as needed, thereby forming the plurality of blocking insulating spacers SP3B shown in FIGS. 4B and 4E or the plurality of blocking insulating spacers SP3C shown in FIGS. 4C and 4F.

In the processes described with reference to FIGS. 31A and 31B, while the plurality of sacrificial semiconductor layers 104 are being selectively removed, an etching atmosphere for the plurality of sacrificial semiconductor layers 104 may be variously controlled, thereby variously controlling the consumption amount of each of the cladding layer VCL and the dummy oxide film 116, which are exposed due to the removal of the plurality of sacrificial semiconductor layers 104 from between each of the first to fourth nanosheets N1, N2, N3, and N4. Therefore, the second cladding portion VC4A shown in FIG. 5A, the second cladding portion VC4B shown in FIG. 5B, or the second cladding portion VC4C shown in FIG. 5C may be formed from respective remaining portions of the cladding layer VCL and the dummy oxide film 116.

In some embodiments, in the processes described with reference to FIGS. 31A and 31B, the cladding layer VCL and the dummy oxide film 116 may be completely removed from a space between each of the first to fourth nanosheets N1, N2, N3, and N4 and the main insulating wall MW, thereby leaving no residue of the cladding layer VCL and the dummy oxide film 116 in the space between each of the first to fourth nanosheets N1, N2, N3, and N4 and the main insulating wall MW, as shown in FIG. 5D. Next, the space between each of the first to fourth nanosheets N1, N2, N3, and N4 and the main insulating wall MW may be filled with the gate dielectric film 152 and the gate line 160.

In some embodiments, in the processes described with reference to FIGS. 31A and 31B, after the cladding layer VCL and the dummy oxide film 116 are completely removed from the space between each of the first to fourth nanosheets N1, N2, N3, and N4 and the main insulating wall MW, the plurality of edge inner spacers 410 may each be formed in the space between each of the first to fourth nanosheets N1, N2, N3, and N4 and the main insulating wall MW, as shown in FIG. 5E. In some embodiments, the plurality of edge inner spacers 410 may be formed together with the plurality of first inner spacers 210 in a process of forming the plurality of first inner spacers 210 through the plurality of gate spaces GS, as described above to fabricate the integrated circuit device 200 described with reference to FIG. 3.

To fabricate each of the integrated circuit devices 500 and 600 shown in FIGS. 6 and 7, the processes described with reference to FIGS. 10A to 32B may be used. However, while the main insulating spacer 118, the side insulating spacer 119, and the recess R1 are being formed according to the description made with reference to FIGS. 24A, 24B, and 24C, the etching of the isolation insulating pattern 114 on one side of each of the plurality of recesses R1 may be suppressed or the etching amount of the isolation insulating pattern 114 may be variously controlled as needed, thereby forming the plurality of isolation insulating patterns 514 shown in FIG. 6 or the plurality of isolation insulating patterns 614 shown in FIG. 7 from the isolation insulating pattern 114 shown in FIG. 23B.

To fabricate the integrated circuit device 700 described with reference to FIGS. 8A, 8B, and 8C, the processes described with reference to FIGS. 10A to 32B may be used. However, after the plurality of capping insulating patterns 168 are formed according to the description made with reference to FIGS. 32A and 32B, before the upper insulating structure 180 is formed on the plurality of capping insulating patterns 168, the gate cut insulating pattern GC may be formed to extend from the upper surface of each of the plurality of capping insulating patterns 168 and the upper surface of the inter-gate dielectric 144 toward the substrate 102 in the vertical direction (the Z direction) while passing through the plurality of capping insulating patterns 168 and the inter-gate dielectric 144 in the vertical direction (the Z direction). A process of forming the plurality of source/drain contacts CA may be performed before or after the process of forming the gate cut insulating pattern GC. Next, the upper insulating structure 180 may be formed to cover the plurality of capping insulating patterns 168, the inter-gate dielectric 144, the plurality of source/drain contacts CA, and the gate cut insulating pattern GC.

FIGS. 33A to 34B are diagrams respectively illustrating a sequence of processes of a method of fabricating an integrated circuit device, according to some embodiments. More specifically, FIGS. 33A and 34A are cross-sectional views respectively illustrating cross-sectional structures of a region corresponding to the cross-section taken along the line X1-X1' of FIG. 1, according to the sequence of processes, and FIGS. 33B and 34B are cross-sectional views respectively illustrating cross-sectional structures of a region corresponding to the cross-section taken along the line Y1-Y1' of FIG. 1, according to the sequence of processes. An example of a method of fabricating the integrated circuit device 800 shown in FIGS. 9A and 9B is described with reference to FIGS. 33A to 34B. In FIGS. 33A to 34B, the same reference numerals as in FIGS. 1 to 9B respectively denote the same members, and here, repeated descriptions thereof are omitted.

Referring to FIGS. 33A and 33B, in the resulting product shown in FIGS. 2A to 2C, the substrate 102 may be polished from the backside surface 102B of the substrate 102, and the plurality of fin-type active regions F1 may be partially removed, thereby exposing the device isolation film 112. Next, a portion of the device isolation film 112 may be removed, thereby forming a plurality of backside contact holes BCH to respectively expose the plurality of source/drain regions 130. A portion of the source/drain region 130, which is exposed while an etching process for forming the plurality of backside contact holes BCH is being performed, may be consumed, and thus, the shape of the surface of the source/drain region 130 may be modified, the surface facing the backside surface FB of the fin-type active region F1.

Referring to FIGS. 34A and 34B, in the resulting product of FIGS. 33A and 33B, a backside insulating spacer BIS may be formed to cover the surface of the fin-type active region F1, which is exposed in an inner sidewall of each of the plurality of backside contact holes BCH, and a plurality of backside contacts DBC may be formed to respectively fill remaining spaces of the plurality of backside contact holes BCH, thereby forming a plurality of backside contact structures DBCS.

Next, as shown in FIGS. 9A and 9B, a backside insulating film 194, which covers the plurality of backside contacts DBC, the backside surface FB of each of the plurality of fin-type active regions F1, and the backside surface 112B of the device isolation film 112, and a plurality of backside wiring structures MPR passing through the backside insulating film 194 in the vertical direction (the Z direction) may be formed, thereby fabricating the integrated circuit device 800 shown in FIGS. 9A and 9B.

According to embodiments, there is provided a method of manufacturing an integrated circuit device including: providing a nanosheet stack including at least one nanosheet, providing a pair of source/drain regions spaced apart from one another in a first horizontal direction with the nanosheet stack therebetween, each of the pair of source/drain regions being in contact with the at least one nanosheet, providing a gate line arranged between the pair of source/drain regions in the first horizontal direction and surrounding the at least one nanosheet, providing an insulating wall structure arranged adjacent to the nanosheet stack, the gate line, and the pair of source/drain regions in a second horizontal direction intersecting the first horizontal direction, the insulating wall structure having a first sidewall that includes portions contacting the pair of source/drain regions and a portion facing the gate line, providing a gate dielectric film surrounding the gate line, and providing a pair of blocking insulating spacers each arranged, in a plan view, in a gap area between the first sidewall of the insulating wall structure and the gate line in the second horizontal direction and contacting the pair of source/drain regions, wherein the pair of blocking insulating spacers are spaced apart from one another in the first horizontal direction in the gap area and each include a portion contacting the gate dielectric film and a portion contacting the first sidewall of the insulating wall structure.

While the disclosed concepts have been particularly shown and described with reference to embodiments thereof, it will be understood that various changes in form and details may be made therein without departing from the scope of the following claims.

## Claims

1. An integrated circuit device (100) comprising:
a nanosheet stack (NSS) comprising at least one nanosheet (N1);
a pair of source/drain regions (130) spaced apart from one another in a first horizontal direction (X) with the nanosheet stack (NSS) therebetween, each of the pair of source/drain regions (130) being in contact with the at least one nanosheet (NS1);
a gate line (160) arranged between the pair of source/drain regions (130) in the first horizontal direction (X) and surrounding the at least one nanosheet (NS1);
an insulating wall structure (WS1) arranged adjacent to the nanosheet stack (NSS), the gate line (160), and the pair of source/drain regions (130) in a second horizontal direction (Y) intersecting the first horizontal direction (X), the insulating wall structure (WS1) having a first sidewall (S1) that includes portions contacting the pair of source/drain regions (130) and a portion facing the gate line (160);
a gate dielectric film (152) surrounding the gate line (160); and
a pair of blocking insulating spacers (SP1) each arranged, in a plan view, in a gap area (GA) between the first sidewall (S1) of the insulating wall structure (WS1) and the gate line (160), in the second horizontal direction (Y), and contacting the pair of source/drain regions (130),
wherein the pair of blocking insulating spacers (SP1) are spaced apart from one another in the first horizontal direction (X) in the gap area (GA) and each comprise a portion contacting the gate dielectric film (152) and a portion contacting the first sidewall (S1) of the insulating wall structure (WS1).

2. The integrated circuit device of claim 1, further comprising a device isolation film (112) arranged at a vertical level that is lower than a vertical level of each of the insulating wall structure (WS1), the pair of source/drain regions (130), and the gate line (160),
wherein the insulating wall structure (WS1) comprises:
a main insulating wall (MW) having the first sidewall (S1);
a first cladding portion (VCA) contacting a lower surface of the main insulating wall (MW) at a vertical level that is higher than that of an upper surface of a first local region of the device isolation film (112) and lower than that of the first sidewall (S1) of the main insulating wall (MW), the first local region overlapping the insulating wall structure (WS1) in a vertical direction (Z); and
a second cladding portion (VCB), in a plan view, arranged between, in the first horizontal direction (X), the pair of blocking insulating spacers (SP1) and arranged between, in the second horizontal direction (Y), the first sidewall (S1) of the main insulating wall (MW) and an end portion (152E) of the gate dielectric film (152), the end portion (152E) being adjacent to the first sidewall (S1) of the insulating wall structure (WS1) in the second horizontal direction (Y),
each of the first cladding portion (VCA) and the second cladding portion (VCB) comprises a first insulating material,
the main insulating wall (MW) comprises a second insulating material that is different from the first insulating material, and
the pair of blocking insulating spacers (SP1) each comprise a third insulating material that is different from the first insulating material.

3. The integrated circuit device of claim 2, wherein the second cladding portion (VCB) comprises a surface contacting the at least one nanosheet (NS1), a surface contacting the main insulating wall (MW), and a surface contacting the gate dielectric film (152).

4. The integrated circuit device of any preceding claim, further comprising:
a plurality of first inner spacers (210) arranged between, in the first horizontal direction (X), each of the pair of blocking insulating spacers (SP1) and the gate line (160); and
a second inner spacer (312B), in a plan view, arranged between, in the first horizontal direction (X), the pair of blocking insulating spacers (SP1) and arranged between, in the second horizontal direction (Y), the first sidewall (S1) of the insulating wall structure (WS1) and an end portion (152E) of the gate dielectric film (152), the end portion (152E) being adjacent to the first sidewall (S1) of the insulating wall structure (WS1) in the second horizontal direction (Y),
wherein the plurality of first inner spacers (210) and the second inner spacer (312B) comprise a same material.

5. The integrated circuit device of claim 4, further comprising a third inner spacer (410) arranged, in a plan view, between at least one of the pair of source/drain regions (SP1) and the gate dielectric film (152),
wherein the plurality of first inner spacers (210), the second inner spacer (312B), and the third inner spacer comprise a same material.

6. The integrated circuit device of any preceding claim, wherein the insulating wall structure (WS1) comprises:
a main insulating wall (MW) having the first sidewall (S1); and
a first cladding portion (VCA) contacting a lower surface of the main insulating wall (MW) at a vertical level that is higher than that of an upper surface of a first local region of the device isolation film (112) and lower than that of the first sidewall (S1) of the main insulating wall (MW), the first local region overlapping the insulating wall structure (WS1) in a vertical direction (Z),
the first cladding portion (VCA) comprises a first insulating material,
the main insulating wall (MW) comprises a second insulating material that is different from the first insulating material, and
each of the pair of blocking insulating spacers (SP1) comprises a third insulating material that is different from the first insulating material.

7. The integrated circuit device of any preceding claim, wherein the insulating wall structure (WS1) comprises a main insulating wall (MW) having the first sidewall (S1),
a minimum separation width (W11) in the second horizontal direction (Y) between the at least one nanosheet (NS1) and the first sidewall (S1) of the insulating wall structure (WS1) is a first width, and
a minimum separation width (W13) between the gate line (160) and the first sidewall of (S1) the insulating wall structure (WS1), in an area adjacent to the at least one nanosheet (NS1), is less than the first width.

8. The integrated circuit device of any preceding claim, wherein the insulating wall structure (WS1) comprises:
a main insulating wall (MW) having the first sidewall (S1);
a first cladding portion (VCA) contacting the insulating wall structure (WS1) at a vertical level that is lower than that of the first sidewall (S1) of the main insulating wall (WS1); and
a second cladding portion (VCB) arranged between the first sidewall (S1) of the main insulating wall (MW) and the at least one nanosheet (NS1), and
the second cladding portion (VCB) has a flat surface in contact with the first sidewall (S1) of the main insulating wall (MW) in the second horizontal direction (Y), and has an uneven surface facing the at least one nanosheet (NS1) and the gate line (160) in the second horizontal direction (Y).

9. The integrated circuit device of any preceding claim, wherein the insulating wall structure (WS1) comprises:
a main insulating wall (MW) having the first sidewall (S1);
a first cladding portion (VCA) contacting the insulating wall structure (WS1) at a vertical level that is lower than that of the first sidewall (S1) of the main insulating wall (MW); and
a second cladding portion (VCB) arranged between the first sidewall (S1) of the main insulating wall (MW) and the at least one nanosheet (NS1),
the second cladding portion (VCB) intermittently extends along the first sidewall (S1) of the main insulating wall (MW), and
the gate dielectric film (152) comprises portions contacting the first sidewall (S1) of the main insulating wall (MW).

10. The integrated circuit device of any preceding claim, wherein the insulating wall structure (WS1) comprises a main insulating wall (MW) having the first sidewall (S1), and
the gate line (160) comprises a portion between the at least one nanosheet (NS1) and the first sidewall (S1) of the main insulating wall (MW).

11. The integrated circuit device of any preceding claim, wherein, in a plan view, each of the pair of blocking insulating spacers (SP1) is in contact with a source/drain region (130) selected from the pair of source/drain regions (130) and has a concave surface facing the selected source/drain region (130).

12. The integrated circuit device of any preceding claim, wherein, in a plan view, the pair of blocking insulating spacers (SP1) respectively fill corner areas defined in the gap area (GA) by the gate dielectric film (152) and the pair of source/drain regions (130).

13. The integrated circuit device of any preceding claim, further comprising:
a pair of semiconductor regions (F1) respectively corresponding to and contacting the pair of source/drain regions (130);
a device isolation film (112) covering respective lower sidewalls of the pair of semiconductor regions (F1) and arranged at a vertical level that is lower than a vertical level of each of the insulating wall structure (WS1), the pair of source/drain regions (130), and the gate line (160); and
a plurality of isolation insulating patterns (114) respectively covering local upper surfaces of an upper surface of the device isolation film (112), the local upper surfaces not overlapping the insulating wall structure (WS1) in a vertical direction (Z),
wherein the plurality of isolation insulating patterns (114) comprise a first isolation insulating pattern between the device isolation film (112) and the gate line (160), and
the first isolation insulating pattern (114) faces the insulating wall structure (WS1) in the second horizontal direction (Y) with a semiconductor region (F1) selected from the pair of semiconductor regions (F1) therebetween.

14. The integrated circuit device of claim 13, wherein the plurality of isolation insulating patterns (114) further comprise a second isolation insulating pattern (114) that is adjacent to the pair of source/drain regions (130) in the second horizontal direction (Y) and integrally connected to the first isolation insulating pattern (114),
the second isolation insulating pattern (114) is arranged in a straight line with, in the second horizontal direction (Y), a portion, which is between the pair of source/drain regions (130), of the insulating wall structure (WS1) and faces the insulating wall structure (WS1) in the second horizontal direction (Y) with one selected from the pair of semiconductor regions (F1) therebetween, and
a vertical level of an upper surface of the second isolation insulating pattern (114) is equal to or lower than a vertical level of an upper surface of each of the pair of semiconductor regions (F1).
